# EUROPEAN PATENT APPLICATION

(11) **EP 4 818 256 A1**
(43) Date of publication of application: **07.10.2026**
(21) Application number: 24897278.8
(22) Date of filing: 12.11.2024
(51) Int. Cl.: C08L 63/00, C08G 59/42, C08K 3/013, C08K 3/20, C08K 3/34, C08K 3/36, H01L 23/29, H01L 23/31, H01L 25/07, H01L 25/18

(54) **TWO-PACK TYPE LIQUID RESIN COMPOSITION AND POWER MODULE**

(30) Priority: 30.11.2023 JP 2023202588; 30.11.2023 JP 2023202589; 30.11.2023 JP 2023202591
(71) Applicant: Sumitomo Bakelite Co., Ltd., Shinagawa-ku Tokyo 140-0002 (JP)
(72) Inventor: INOMATA, Haruhiko, Tokyo 140-0002 (JP); KOBAYASHI, Tatsuro, Tokyo 140-0002 (JP); HARADA, Naoyuki, Tokyo 140-0002 (JP); TSUNODA, Tomoki, Tokyo 140-0002 (JP); HASHIMOTO, Koichi, Tokyo 140-0002 (JP)
(74) Representative: Ter Meer und Partner mbB
(86) International application number: PCT/JP2024/040109
(87) International publication number: WO 2025/115591

(57) **Abstract**

A two-pack type liquid resin composition includes a first liquid and a second liquid, in which the first liquid includes an epoxy resin (A), an inorganic filler (C), and a sedimentation inhibitor (D), the second liquid includes an acid anhydride (B), an inorganic filler (C), and a sedimentation inhibitor (D), the sedimentation inhibitor (D) includes an inorganic thickener (excluding the inorganic filler (C)), and a viscosity η_{5A} of the first liquid, as measured under conditions of a rotational speed of 5 rpm and a temperature of 25°C using an E-type viscometer and a 3°×R14 cone rotor, is 1.0 Pa·s or more and 50.0 Pa·s or less.

## Description

### TECHNICAL FIELD

The present invention relates to a two-pack type liquid resin composition and a power module.

### BACKGROUND ART

An epoxy resin is used as an encapsulant for encapsulating a substrate and a semiconductor element in a power module.

As a technique relating to the encapsulant for a power module, for example, a technique disclosed in Patent Document 1 may be cited.

Patent Document 1 discloses a semiconductor encapsulant filler to be blended in an encapsulant to reduce a coefficient of linear thermal expansion of the encapsulant and, at the same time, to maintain the encapsulant at a low viscosity to improve penetration property, and a semiconductor encapsulant composition using the same. The semiconductor encapsulant filler is characterized by including an inorganic substance and an organic layer chemically bonded to a surface of the inorganic substance, the organic layer having a functional group reactive with an epoxy resin. Patent Document 1 also discloses a semiconductor encapsulant including the filler and an epoxy resin.

### RELATED DOCUMENT

### PATENT DOCUMENT

[Patent Document 1] Japanese Unexamined Patent Publication No. 2009-67890

### SUMMARY OF THE INVENTION

### TECHNICAL PROBLEM

The present invention provides a two-pack type liquid resin composition in which a performance balance between storage stability and flowability is improved.

### SOLUTION TO PROBLEM

The present inventors have made intensive studies to achieve the above-described object. As a result, the present inventors have found that the performance balance between storage stability and flowability of a two-pack type liquid resin composition can be improved by, in the two-pack type liquid resin composition: adjusting a viscosity of a liquid resin composition including an epoxy resin to fall within a specific range, the liquid resin composition including an inorganic thickener as a sedimentation inhibitor; adjusting a viscosity of a liquid resin composition including an epoxy resin to fall within a specific range, the liquid resin composition including a dispersant as a sedimentation inhibitor; or adjusting a viscosity of a liquid resin composition including an epoxy resin to fall within a specific range, the liquid resin composition including an epoxy resin and a sedimentation inhibitor, thereby completing the present invention.

According to a first embodiment of the present invention, there are provided a two-pack type liquid resin composition and a power module described below.
[1a]
   A two-pack type liquid resin composition including a first liquid and a second liquid,
   in which the first liquid includes an epoxy resin (A), an inorganic filler (C), and a sedimentation inhibitor (D),
   the second liquid includes an acid anhydride (B), an inorganic filler (C), and a sedimentation inhibitor (D),
   the sedimentation inhibitor (D) includes an inorganic thickener (excluding the inorganic filler (C)), and
   a viscosity η_{5A} of the first liquid, measured under conditions of a rotational speed of 5 rpm and a temperature of 25°C using an E-type viscometer and a 3°×R14 cone rotor, is 1.0 Pa·s or more and 50.0 Pa·s or less.
[2a]
   The two-pack type liquid resin composition according to [1a], in which a viscosity η_{10A} of the first liquid, measured under conditions of a rotational speed of 10 rpm and a temperature of 25°C using an E-type viscometer and a 3°×R14 cone rotor, is 1.0 Pa·s or more and 50.0 Pa·s or less.
[3a]
   The two-pack type liquid resin composition according to [2a], in which a viscosity ratio Ti_{A} (η_{5A}/η_{10A}) of the viscosity η_{5A} to the viscosity η_{10A} is 0.1 or more and 1.5 or less.
[4a]
   The two-pack type liquid resin composition according to any one of [1a] to [3a], in which a viscosity η_{5B} of the second liquid, measured under conditions of a rotational speed of 5 rpm and a temperature of 25°C using an E-type viscometer and a 3°×R14 cone rotor, is 1.0 Pa·s or more and 50.0 Pa·s or less.
[5a]
   The two-pack type liquid resin composition according to [4a], in which a viscosity η_{10B} of the second liquid, measured under conditions of a rotational speed of 10 rpm and a temperature of 25°C using an E-type viscometer and a 3°×R14 cone rotor, is 1.0 Pa·s or more and 50.0 Pa·s or less.
[6a]
   The two-pack type liquid resin composition according to [5a], in which a viscosity ratio Ti_{B} (η_{5B}/η_{10B}) of the viscosity η_{5B} to the viscosity η_{10B} is 0.5 or more and 2.5 or less.
[7a]
   The two-pack type liquid resin composition according to any one of [1a] to [6a], in which a viscosity η_{5P} of a mixed liquid of the first liquid and the second liquid, measured under conditions of a rotational speed of 5 rpm and a temperature of 25°C using an E-type viscometer and a 3°×R14 cone rotor, is 1.0 Pa·s or more and 50.0 Pa·s or less.
[8a]
   The two-pack type liquid resin composition according to [7a], in which a viscosity η_{10P} of the mixed liquid of the first liquid and the second liquid, measured under conditions of a rotational speed of 10 rpm and a temperature of 25°C using an E-type viscometer and a 3°×R14 cone rotor, is 10.0 Pa·s or more and 50.0 Pa·s or less.
[9a]
   The two-pack type liquid resin composition according to [8a], in which a viscosity ratio Ti_{P} (η_{5P}/η_{10P}) of the viscosity η_{5P} to the viscosity η_{10P} is 0.5 or more and 2.0 or less.
[10a]
   The two-pack type liquid resin composition according to any one of [1a] to [9a], in which the inorganic thickener includes one or two or more selected from the group consisting of a layered inorganic mineral and nanosilica.
[11a]
   The two-pack type liquid resin composition according to [10a], in which the layered inorganic mineral includes one or two or more selected from the group consisting of clay and talc.
[12a]
   The two-pack type liquid resin composition according to any one of [1a] to [11a], in which a content of the sedimentation inhibitor (D) is 0.01% by mass or more and 2.00% by mass or less, when a total amount of the two-pack type liquid resin composition is taken as 100% by mass.
[13a]
   The two-pack type liquid resin composition according to any one of [1a] to [12a], in which the epoxy resin (A) includes an alicyclic epoxy resin.
[14a]
   The two-pack type liquid resin composition according to [13a], in which a content of the alicyclic epoxy resin is 50 parts by mass or more and 100 parts by mass or less, when a content of the epoxy resin (A) is taken as 100 parts by mass.
[15a]
   The two-pack type liquid resin composition according to any one of [1a] to [14a], in which a content of the epoxy resin (A) is 5% by mass or more and 30% by mass or less, when a total amount of the two-pack type liquid resin composition is taken as 100% by mass.
[16a]
   The two-pack type liquid resin composition according to any one of [1a] to [15a], in which the acid anhydride (B) includes one or two or more selected from the group consisting of methyl-5-norbornene-2,3-dicarboxylic acid anhydride, methylcyclohexane-1,2-dicarboxylic acid anhydride, and methyltetrahydrophthalic acid anhydride.
[17a]
   The two-pack type liquid resin composition according to any one of [1a] to [16a], in which a content of the acid anhydride (B) is 5% by mass or more and 20% by mass or less, when a total amount of the two-pack type liquid resin composition is taken as 100% by mass.
[18a]
   The two-pack type liquid resin composition according to any one of [1a] to [17a], in which the inorganic filler (C) includes one or two or more selected from the group consisting of silica, alumina, aluminum hydroxide, and calcium carbonate.
[19a]
   The two-pack type liquid resin composition according to any one of [1a] to [18a], in which the inorganic filler (C) has an average particle diameter D₅₀ of 0.5 µm or more and 100.0 µm or less, the D₅₀ being a particle diameter at which a cumulative value reaches 50% in a volume-based particle size distribution measured by a laser diffraction scattering method.
[20a]
   The two-pack type liquid resin composition according to any one of [1a] to [19a], in which a content of the inorganic filler (C) is 65% by mass or more and 85% by mass or less, when a total amount of the two-pack type liquid resin composition is taken as 100% by mass.
[21a]
   The two-pack type liquid resin composition according to any one of [1a] to [20a], further including a curing accelerator (E).
[22a]
   The two-pack type liquid resin composition according to [21a], in which the curing accelerator (E) includes one or two or more selected from the group consisting of a tertiary amine, a quaternary ammonium salt, imidazoles, an organic phosphine, and a Lewis acid catalyst.
[23a]
   The two-pack type liquid resin composition according to [21a] or [22a], in which a content of the curing accelerator (E) is 0.01% by mass or more and 1.00% by mass or less, when a total amount of the two-pack type liquid resin composition is taken as 100% by mass.
[24a]
   The two-pack type liquid resin composition according to any one of [1a] to [23a], in which the two-pack type liquid resin composition is usable for encapsulating, by a casting method, a power module that includes a power-module substrate including a circuit layer and a power semiconductor element on the circuit layer of the power-module substrate.
[25a]
   A power module including:
   a power-module substrate including a circuit layer;
   a power semiconductor element on the circuit layer of the power-module substrate; and
   an encapsulant for encapsulating the power-module substrate and the power semiconductor element,
   in which the encapsulant includes a cured product of the two-pack type liquid resin composition according to any one of [1a] to [24a].
[26a]
   The power module according to [25a], in which the power semiconductor element includes one or two or more selected from the group consisting of a MOS transistor and an insulated gate bipolar transistor (IGBT).

According to a second embodiment of the present invention, there are provided a two-pack type liquid resin composition and a power module described below.
[1b]
   A two-pack type liquid resin composition including a first liquid and a second liquid,
   in which the first liquid includes an epoxy resin (A), an inorganic filler (C), and a sedimentation inhibitor (D),
   the second liquid includes an acid anhydride (B), an inorganic filler (C), and a sedimentation inhibitor (D),
   the sedimentation inhibitor (D) includes a dispersant, and
   a viscosity η_{5A} of the first liquid, measured under conditions of a rotational speed of 5 rpm and a temperature of 25°C using an E-type viscometer and a 3°×R14 cone rotor, is 1.0 Pa·s or more and 50.0 Pa·s or less.
[2b]
   The two-pack type liquid resin composition according to [1b], in which a viscosity η_{10A} of the first liquid, measured under conditions of a rotational speed of 10 rpm and a temperature of 25°C using an E-type viscometer and a 3°×R14 cone rotor, is 1.0 Pa·s or more and 50.0 Pa·s or less.
[3b]
   The two-pack type liquid resin composition according to [2b], in which a viscosity ratio Ti_{A} (η_{5A}/η_{10A}) of the viscosity η_{5A} to the viscosity η_{10A} is 0.4 or more and 1.5 or less.
[4b]
   The two-pack type liquid resin composition according to any one of [1b] to [3b], in which a viscosity η_{5B} of the second liquid, measured under conditions of a rotational speed of 5 rpm and a temperature of 25°C using an E-type viscometer and a 3°×R14 cone rotor, is 1.0 Pa·s or more and 70.0 Pa·s or less.
[5b]
   The two-pack type liquid resin composition according to [4b], in which a viscosity η_{10B} of the second liquid, measured under conditions of a rotational speed of 10 rpm and a temperature of 25°C using an E-type viscometer and a 3°×R14 cone rotor, is 1.0 Pa·s or more and 50.0 Pa·s or less.
[6b]
   The two-pack type liquid resin composition according to [5b], in which a viscosity ratio Ti_{B} (η_{5B}/η_{10B}) of the viscosity η_{5B} to the viscosity η_{10B} is 0.5 or more and 4.0 or less.
[7b]
   The two-pack type liquid resin composition according to any one of [1b] to [6b], in which a viscosity η_{5P} of a mixed liquid of the first liquid and the second liquid, measured under conditions of a rotational speed of 5 rpm and a temperature of 25°C using an E-type viscometer and a 3°×R14 cone rotor, is 1.0 Pa·s or more and 50.0 Pa·s or less.
[8b]
   The two-pack type liquid resin composition according to [7b], in which a viscosity η_{10P} of the mixed liquid of the first liquid and the second liquid, measured under conditions of a rotational speed of 10 rpm and a temperature of 25°C using an E-type viscometer and a 3°×R14 cone rotor, is 10.0 Pa·s or more and 50.0 Pa·s or less.
[9b]
   The two-pack type liquid resin composition according to [8b], in which a viscosity ratio Ti_{P} (η_{5P}/η_{10P}) of the viscosity η_{5P} to the viscosity η_{10P} is 0.5 or more and 2.0 or less.
[10b]
   The two-pack type liquid resin composition according to any one of [1b] to [9b], in which the dispersant includes an ester compound including a long-chain hydrocarbon group.
[11b]
   The two-pack type liquid resin composition according to [10b], in which the ester compound including a long-chain hydrocarbon group includes one or two or more selected from the group consisting of a polyhydroxycarboxylic acid ester, an acidic phosphate ester, and a carboxyl group-including polymer-modified product.
[12b]
   The two-pack type liquid resin composition according to any one of [1b] to [11b], in which a content of the sedimentation inhibitor (D) is 0.01% by mass or more and 2.0% by mass or less, when a total amount of the two-pack type liquid resin composition is taken as 100% by mass.
[13b]
   The two-pack type liquid resin composition according to any one of [1b] to [12b], in which the epoxy resin (A) includes an alicyclic epoxy resin.
[14b]
   The two-pack type liquid resin composition according to [13b], in which a content of the alicyclic epoxy resin is 50 parts by mass or more and 100 parts by mass or less, when a content of the epoxy resin (A) is taken as 100 parts by mass.
[15b]
   The two-pack type liquid resin composition according to any one of [1b] to [14b], in which a content of the epoxy resin (A) is 5% by mass or more and 30% by mass or less, when a total amount of the two-pack type liquid resin composition is taken as 100% by mass.
[16b]
   The two-pack type liquid resin composition according to any one of [1b] to [15b], in which the acid anhydride (B) includes one or two or more selected from the group consisting of methyl-5-norbornene-2,3-dicarboxylic acid anhydride, methylcyclohexane-1,2-dicarboxylic acid anhydride, and methyltetrahydrophthalic acid anhydride.
[17b]
   The two-pack type liquid resin composition according to any one of [1b] to [16b], in which a content of the acid anhydride (B) is 5% by mass or more and 20% by mass or less, when a total amount of the two-pack type liquid resin composition is taken as 100% by mass.
[18b]
   The two-pack type liquid resin composition according to any one of [1b] to [17b], in which the inorganic filler (C) includes one or two or more selected from the group consisting of silica, alumina, aluminum hydroxide, and calcium carbonate.
[19b]
   The two-pack type liquid resin composition according to any one of [1b] to [18b], in which the inorganic filler (C) has an average particle diameter D₅₀ of 0.5 µm or more and 100 µm or less, the D₅₀ being a particle diameter at which a cumulative value reaches 50% in a volume-based particle size distribution measured by a laser diffraction scattering method.
[20b]
   The two-pack type liquid resin composition according to any one of [1b] to [19b], in which a content of the inorganic filler (C) is 65% by mass or more and 85% by mass or less, when a total amount of the two-pack type liquid resin composition is taken as 100% by mass.
[21b]
   The two-pack type liquid resin composition according to any one of [1b] to [20b], further including a curing accelerator (E).
[22b]
   The two-pack type liquid resin composition according to [21b], in which the curing accelerator (E) includes one or two or more selected from the group consisting of a tertiary amine, a quaternary ammonium salt, imidazoles, an organic phosphine, and a Lewis acid catalyst.
[23b]
   The two-pack type liquid resin composition according to [21b] or [22b], in which a content of the curing accelerator (E) is 0.01% by mass or more and 1.00% by mass or less, when a total amount of the two-pack type liquid resin composition is taken as 100% by mass.
[24b]
   The two-pack type liquid resin composition according to any one of [1b] to [23b], in which the two-pack type liquid resin composition is usable for encapsulating, by a casting method, a power module that includes a power-module substrate including a circuit layer and a power semiconductor element on the circuit layer of the power-module substrate.
[25b]
   A power module including:
   a power-module substrate including a circuit layer;
   a power semiconductor element on the circuit layer of the power-module substrate; and
   an encapsulant for encapsulating the power-module substrate and the power semiconductor element,
   in which the encapsulant includes a cured product of the two-pack type liquid resin composition according to any one of [1b] to [24b].
[26b]
   The power module according to [25b], in which the power semiconductor element includes one or two or more selected from the group consisting of a MOS transistor and an insulated gate bipolar transistor (IGBT).

According to a third embodiment of the present invention, there are provided a two-pack type liquid resin composition and a power module described below.
[1c]
   A two-pack type liquid resin composition including a first liquid and a second liquid,
   in which the first liquid includes an epoxy resin (A), an inorganic filler (C), and a sedimentation inhibitor (D),
   the second liquid includes an acid anhydride (B), an inorganic filler (C), and a sedimentation inhibitor (D), and
   a viscosity η_{5A} of the first liquid, measured under conditions of a rotational speed of 5 rpm and a temperature of 60°C using an E-type viscometer and a 3°×R14 cone rotor, is 1.0 Pa·s or more and 15.0 Pa·s or less.
[2c]
   The two-pack type liquid resin composition according to [1c], in which a viscosity η_{10A} of the first liquid, measured under conditions of a rotational speed of 10 rpm and a temperature of 60°C using an E-type viscometer and a 3°×R14 cone rotor, is 1.0 Pa·s or more and 15.0 Pa·s or less.
[3c]
   The two-pack type liquid resin composition according to [2c], in which a viscosity ratio Ti_{A} (η_{5A}/η_{10A}) of the viscosity η_{5A} to the viscosity η_{10A} is 0.1 or more and 1.5 or less.
[4c]
   The two-pack type liquid resin composition according to any one of [1c] to [3c], in which a viscosity η_{5B} of the second liquid, measured under conditions of a rotational speed of 5 rpm and a temperature of 25°C using an E-type viscometer and a 3°×R14 cone rotor, is 1.0 Pa·s or more and 50.0 Pa·s or less.
[5c]
   The two-pack type liquid resin composition according to [4c], in which a viscosity η_{10B} of the second liquid, measured under conditions of a rotational speed of 10 rpm and a temperature of 25°C using an E-type viscometer and a 3°×R14 cone rotor, is 1.0 Pa·s or more and 50.0 Pa·s or less.
[6c]
   The two-pack type liquid resin composition according to [5c], in which a viscosity ratio Ti_{B} (η_{5B}/η_{10B}) of the viscosity η_{5B} to the viscosity η_{10B} is 0.5 or more and 2.5 or less.
[7c]
   The two-pack type liquid resin composition according to any one of [1c] to [6c], in which a viscosity η_{5P} of a mixed liquid of the first liquid and the second liquid, measured under conditions of a rotational speed of 5 rpm and a temperature of 60°C using an E-type viscometer and a 3°×R14 cone rotor, is 1.0 Pa·s or more and 30.0 Pa·s or less.
[8c]
   The two-pack type liquid resin composition according to [7c], in which a viscosity η_{10P} of the mixed liquid of the first liquid and the second liquid, measured under conditions of a rotational speed of 10 rpm and a temperature of 60°C using an E-type viscometer and a 3°×R14 cone rotor, is 1.0 Pa·s or more and 30.0 Pa·s or less.
[9c]
   The two-pack type liquid resin composition according to [8c], in which a viscosity ratio Ti_{P} (η_{5P}/η_{10P}) of the viscosity η_{5P} to the viscosity η_{10P} is 0.5 or more and 2.0 or less.
[10c]
   The two-pack type liquid resin composition according to any one of [1c] to [9c], in which the sedimentation inhibitor (D) includes an inorganic thickener (excluding the inorganic filler (C)).
[11c]
   The two-pack type liquid resin composition according to [10c], in which the inorganic thickener includes a layered inorganic mineral.
[12c]
   The two-pack type liquid resin composition according to [11c], in which the layered inorganic mineral includes one or two or more selected from the group consisting of clay and talc.
[13c]
   The two-pack type liquid resin composition according to any one of [1c] to [12c], in which a content of the sedimentation inhibitor (D) is 0.01% by mass or more and 2.00% by mass or less, when a total amount of the two-pack type liquid resin composition is taken as 100% by mass.
[14c]
   The two-pack type liquid resin composition according to any one of [1c] to [13c], in which a content of the epoxy resin (A) is 3% by mass or more and 30% by mass or less, when a total amount of the two-pack type liquid resin composition is taken as 100% by mass.
[15c]
   The two-pack type liquid resin composition according to any one of [1c] to [14c], in which the acid anhydride (B) includes one or two or more selected from the group consisting of methyl-5-norbornene-2,3-dicarboxylic acid anhydride, methylcyclohexane-1,2-dicarboxylic acid anhydride, and methyltetrahydrophthalic acid anhydride.
[16c]
   The two-pack type liquid resin composition according to any one of [1c] to [15c], in which a content of the acid anhydride (B) is 5% by mass or more and 20% by mass or less, when a total amount of the two-pack type liquid resin composition is taken as 100% by mass.
[17c]
   The two-pack type liquid resin composition according to any one of [1c] to [16c], in which the inorganic filler (C) includes one or two or more selected from the group consisting of silica, alumina, aluminum hydroxide, and calcium carbonate.
[18c]
   The two-pack type liquid resin composition according to any one of [1c] to [17c], in which the inorganic filler (C) has an average particle diameter D₅₀ of 0.5 µm or more and 100 µm or less, the D₅₀ being a particle diameter at which a cumulative value reaches 50% in a volume-based particle size distribution measured by a laser diffraction scattering method.
[19c]
   The two-pack type liquid resin composition according to any one of [1c] to [18c], in which a content of the inorganic filler (C) is 65% by mass or more and 85% by mass or less, when a total amount of the two-pack type liquid resin composition is taken as 100% by mass.
[20c]
   The two-pack type liquid resin composition according to any one of [1c] to [19c], further including a curing accelerator (E).
[21c]
   The two-pack type liquid resin composition according to [20c], in which the curing accelerator (E) includes one or two or more selected from the group consisting of a tertiary amine, a quaternary ammonium salt, imidazoles, an organic phosphine, and a Lewis acid catalyst.
[22c]
   The two-pack type liquid resin composition according to [20c] or [21c], in which a content of the curing accelerator (E) is 0.01% by mass or more and 1.00% by mass or less, when a total amount of the two-pack type liquid resin composition is taken as 100% by mass.
[23c]
   The two-pack type liquid resin composition according to any one of [1c] to [22c], in which the two-pack type liquid resin composition is usable for encapsulating, by a casting method, a power module that includes a power-module substrate including a circuit layer and a power semiconductor element on the circuit layer of the power-module substrate.
[24c]
   A power module including:
   a power-module substrate including a circuit layer;
   a power semiconductor element on the circuit layer of the power-module substrate; and
   an encapsulant for encapsulating the power-module substrate and the power semiconductor element,
   in which the encapsulant includes a cured product of the two-pack type liquid resin composition according to any one of [1c] to [23c].
[25c]
   The power module according to [24c], in which the power semiconductor element includes one or two or more selected from the group consisting of a MOS transistor and an insulated gate bipolar transistor (IGBT).

### ADVANTAGEOUS EFFECTS OF INVENTION

According to the first to third embodiments of the present invention, it is possible to provide a two-pack type liquid resin composition having improved performance balance between storage stability and flowability, and a power module using the two-pack type liquid resin composition.

### DESCRIPTION OF EMBODIMENTS

Hereinafter, the embodiments of the present invention will be described.

In the present specification, a numerical range indicated by "to" includes numerical values before and after "to" as a minimum value and a maximum value, respectively. In the numerical range described in stages in the present specification, an upper limit value or a lower limit value of a numerical range at one stage can be combined with an upper limit value or a lower limit value of a numerical range at another stage as appropriate. In the numerical range described in the present specification, the upper limit value or the lower limit value of the numerical range may be replaced with a value described in Examples. "A or B" means that any one of A or B is included, and both A and B may be included. Materials exemplified in the present specification can be used alone or in combination of two or more kinds thereof, unless otherwise specified. In the present specification, unless otherwise specified, a content of each component in a composition means, when a plurality of substances corresponding to the component are present in the composition, the total amount of the plurality of substances present in the composition. In the present specification, the description "when the total amount of the two-pack type liquid resin composition (or the first liquid and the second liquid) is taken as 100% by mass" means that components such as solvents, which volatilize when the two-pack type liquid resin composition is cured, are excluded.

### <First embodiment>

### [Two-pack type liquid resin composition]

The two-pack type liquid resin composition according to the first embodiment is a two-pack type liquid resin composition including a first liquid and a second liquid, in which the first liquid includes an epoxy resin (A), an inorganic filler (C), and a sedimentation inhibitor (D), the second liquid includes an acid anhydride (B), an inorganic filler (C), and a sedimentation inhibitor (D), the sedimentation inhibitor (D) includes an inorganic thickener (excluding the inorganic filler (C)), and a viscosity η_{5A} of the first liquid, measured under conditions of a rotational speed of 5 rpm and a temperature of 25°C using an E-type viscometer and a 3°×R14 cone rotor, is 1.0 Pa·s or more and 50.0 Pa·s or less.

The two-pack type liquid resin composition according to the first embodiment can improve the performance balance between storage stability and flowability by satisfying the above-described configuration.

In the two-pack type liquid resin composition according to the first embodiment, specific components in the first liquid and the second liquid of the two-pack type liquid resin composition are considered to contribute to maintaining a preferred dispersion state of the inorganic filler (C) in the first liquid and the second liquid. Further, when the viscosity η_{5A} of the first liquid is within the above-described numerical range, the flowability of the first liquid under quiescent conditions becomes suitable from the viewpoint of storage stability, and sedimentation of the inorganic filler (C) in the first liquid is considered to be physically suppressed. As a result, the two-pack type liquid resin composition according to the first embodiment is considered capable of improving the performance balance between storage stability in the first-liquid and second-liquid states and flowability suitable for workability in casting.

In the two-pack type liquid resin composition according to the first embodiment, from the viewpoint of further improving the performance balance between the storage stability and the flowability of the two-pack type liquid resin composition, the above-described viscosity η_{5A} is preferably 3.0 Pa·s or more, more preferably 5.0 Pa·s or more, and still more preferably 8.0 Pa·s or more; and is preferably 40.0 Pa·s or less, more preferably 30.0 Pa·s or less, and still more preferably 25.0 Pa·s or less.

In addition, from the viewpoint of further improving the performance balance between the storage stability and the flowability of the two-pack type liquid resin composition, the viscosity η_{5A} of the two-pack type liquid resin composition according to the first embodiment is preferably 3.0 Pa·s or more and 40.0 Pa·s or less, more preferably 5.0 Pa·s or more and 30.0 Pa·s or less, and still more preferably 8.0 Pa·s or more and 25.0 Pa·s or less.

The above-described viscosity η_{5A} of the two-pack type liquid resin composition according to the first embodiment refers to a viscosity one minute after rotation of the cone rotor set in the E-type viscometer starts.

In the two-pack type liquid resin composition according to the first embodiment, from the viewpoint of further improving the performance balance between the storage stability and the flowability of the two-pack type liquid resin composition, a viscosity η_{10A} of the above-described first liquid, measured under conditions of a rotational speed of 10 rpm and a temperature of 25°C using an E-type viscometer and a 3°×R14 cone rotor, is preferably 1.0 Pa·s or more, more preferably 3.0 Pa·s or more, still more preferably 5.0 Pa·s or more, and even more preferably 8.0 Pa·s or more; and is preferably 50.0 Pa·s or less, more preferably 40.0 Pa·s or less, and still more preferably 30.0 Pa·s or less.

In addition, from the viewpoint of further improving the performance balance between the storage stability and the flowability of the two-pack type liquid resin composition, the viscosity η_{10A} of the two-pack type liquid resin composition according to the first embodiment is preferably 1.0 Pa·s or more and 50.0 Pa·s or less, more preferably 3.0 Pa·s or more and 50.0 Pa·s or less, still more preferably 5.0 Pa·s or more and 40.0 Pa·s or less, and even more preferably 8.0 Pa·s or more and 30.0 Pa·s or less.

The above-described viscosity η_{10A} of the two-pack type liquid resin composition according to the first embodiment refers to a viscosity one minute after rotation of the cone rotor set in the E-type viscometer starts.

In the two-pack type liquid resin composition according to the first embodiment, from the viewpoint of further improving the performance balance between the storage stability and the flowability of the two-pack type liquid resin composition, a viscosity ratio Ti_{A} (η_{5A}/η_{10A}) of the above-described viscosity η_{5A} to the above-described viscosity η_{10A} is preferably 0.1 or more, more preferably 0.3 or more, still more preferably 0.5 or more, and even more preferably 0.8 or more; and is preferably 1.5 or less, more preferably 1.3 or less, and still more preferably 1.1 or less.

In addition, from the viewpoint of further improving the performance balance between the storage stability and the flowability of the two-pack type liquid resin composition, the viscosity ratio Ti_{A} (η_{5A}/η_{10A}) of the two-pack type liquid resin composition according to the first embodiment is preferably 0.1 or more and 1.5 or less, more preferably 0.3 or more and 1.5 or less, still more preferably 0.5 or more and 1.3 or less, and even more preferably 0.8 or more and 1.1 or less.

In the two-pack type liquid resin composition according to the first embodiment, from the viewpoint of further improving the performance balance between the storage stability and the flowability of the two-pack type liquid resin composition, a viscosity η_{5B} of the above-described second liquid, measured under conditions of a rotational speed of 5 rpm and a temperature of 25°C using an E-type viscometer and a 3°×R14 cone rotor, is preferably 1.0 Pa·s or more, more preferably 5.0 Pa·s or more, still more preferably 10.0 Pa·s or more, even more preferably 15.0 Pa·s or more, and even still more preferably 20.0 Pa·s or more; and is preferably 50.0 Pa·s or less, more preferably 45.0 Pa·s or less, still more preferably 40.0 Pa·s or less, even more preferably 35.0 Pa·s or less, and even still more preferably 30.0 Pa·s or less.

In addition, from the viewpoint of further improving the performance balance between the storage stability and the flowability of the two-pack type liquid resin composition, the viscosity η_{5B} of the two-pack type liquid resin composition according to the first embodiment is preferably 1.0 Pa·s or more and 50.0 Pa·s or less, more preferably 5.0 Pa·s or more and 45.0 Pa·s or less, still more preferably 10.0 Pa·s or more and 40.0 Pa·s or less, even more preferably 15.0 Pa·s or more and 35.0 Pa·s or less, and even still more preferably 20.0 Pa·s or more and 30.0 Pa·s or less.

The above-described viscosity η_{5B} of the two-pack type liquid resin composition according to the first embodiment refers to a viscosity one minute after rotation of the cone rotor set in the E-type viscometer starts.

In the two-pack type liquid resin composition according to the first embodiment, from the viewpoint of further improving the performance balance between the storage stability and the flowability of the two-pack type liquid resin composition, a viscosity η_{10B} of the above-described second liquid, measured under conditions of a rotational speed of 10 rpm and a temperature of 25°C using an E-type viscometer and a 3°×R14 cone rotor, is preferably 1.0 Pa·s or more, more preferably 3.0 Pa·s or more, still more preferably 5.0 Pa·s or more, even more preferably 10.0 Pa·s or more, and even still more preferably 15.0 Pa·s or more; and is preferably 50.0 Pa·s or less, more preferably 45.0 Pa·s or less, still more preferably 40.0 Pa·s or less, even more preferably 35.0 Pa·s or less, even still more preferably 30.0 Pa·s or less, and further more preferably 25.0 Pa·s or less.

In addition, from the viewpoint of further improving the performance balance between the storage stability and the flowability of the two-pack type liquid resin composition, the viscosity η_{10B} of the two-pack type liquid resin composition according to the first embodiment is preferably 1.0 Pa·s or more and 50.0 Pa·s or less, more preferably 1.0 Pa·s or more and 45.0 Pa·s or less, still more preferably 3.0 Pa·s or more and 40.0 Pa·s or less, even more preferably 5.0 Pa·s or more and 35.0 Pa·s or less, even still more preferably 10.0 Pa·s or more and 30.0 Pa·s or less, and further more preferably 15.0 Pa·s or more and 25.0 Pa·s or less.

The above-described viscosity η_{10B} of the two-pack type liquid resin composition according to the first embodiment refers to a viscosity one minute after rotation of the cone rotor set in the E-type viscometer starts.

In the two-pack type liquid resin composition according to the first embodiment, from the viewpoint of further improving the performance balance between the storage stability and the flowability of the two-pack type liquid resin composition, a viscosity ratio Ti_{B} (η_{5B}/η_{10B}) of the above-described viscosity η_{5B} to the above-described viscosity η_{10B} is preferably 0.5 or more, more preferably 0.8 or more, and still more preferably 1.0 or more; and is preferably 2.5 or less, more preferably 2.2 or less, still more preferably 2.0 or less, even more preferably 1.7 or less, and even still more preferably 1.5 or less.

In addition, from the viewpoint of further improving the performance balance between the storage stability and the flowability of the two-pack type liquid resin composition, the viscosity ratio Ti_{B} (η_{5B}/η_{10B}) of the two-pack type liquid resin composition according to the first embodiment is preferably 0.5 or more and 2.5 or less, more preferably 0.5 or more and 2.2 or less, still more preferably 0.5 or more and 2.0 or less, even more preferably 0.8 or more and 1.7 or less, and even still more preferably 1.0 or more and 1.5 or less.

In the two-pack type liquid resin composition according to the first embodiment, from the viewpoint of further improving the performance balance between the storage stability and the flowability of the two-pack type liquid resin composition, a viscosity η_{5P} of a mixed liquid of the above-described first liquid and the above-described second liquid, measured under conditions of a rotational speed of 5 rpm and a temperature of 25°C using an E-type viscometer and a 3°×R14 cone rotor, is preferably 1.0 Pa·s or more, more preferably 5.0 Pa·s or more, still more preferably 10.0 Pa·s or more, even more preferably 15.0 Pa·s or more, and even still more preferably 20.0 Pa·s or more; and is preferably 50.0 Pa·s or less, more preferably 45.0 Pa·s or less, still more preferably 40.0 Pa·s or less, and even more preferably 35.0 Pa·s or less.

In addition, from the viewpoint of further improving the performance balance between the storage stability and the flowability of the two-pack type liquid resin composition, the viscosity η_{5P} of the two-pack type liquid resin composition according to the first embodiment is preferably 1.0 Pa·s or more and 50.0 Pa·s or less, more preferably 5.0 Pa·s or more and 50.0 Pa·s or less, still more preferably 10.0 Pa·s or more and 45.0 Pa·s or less, even more preferably 15.0 Pa·s or more and 40.0 Pa·s or less, and even still more preferably 20.0 Pa·s or more and 35.0 Pa·s or less.

The above-described viscosity η_{5P} of the two-pack type liquid resin composition according to the first embodiment refers to a viscosity one minute after rotation of the cone rotor set in the E-type viscometer starts.

In the two-pack type liquid resin composition according to the first embodiment, from the viewpoint of further improving the performance balance between the storage stability and the flowability of the two-pack type liquid resin composition, a viscosity η_{10P} of the mixed liquid of the above-described first liquid and the above-described second liquid, measured under conditions of a rotational speed of 10 rpm and a temperature of 25°C using an E-type viscometer and a 3°×R14 cone rotor, is preferably 10.0 Pa·s or more, more preferably 12.0 Pa·s or more, still more preferably 14.0 Pa·s or more, even more preferably 16.0 Pa·s or more, even still more preferably 18.0 Pa·s or more, further more preferably 20.0 Pa·s or more, and even further more preferably 21.0 Pa·s or more; and is preferably 50.0 Pa·s or less, more preferably 45.0 Pa·s or less, still more preferably 40.0 Pa·s or less, even more preferably 35.0 Pa·s or less, and even still more preferably 30.0 Pa·s or less.

In addition, from the viewpoint of further improving the performance balance between the storage stability and the flowability of the two-pack type liquid resin composition, the viscosity η_{10P} of the two-pack type liquid resin composition according to the first embodiment is preferably 10.0 Pa·s or more and 50.0 Pa·s or less, more preferably 12.0 Pa·s or more and 50.0 Pa·s or less, still more preferably 14.0 Pa·s or more and 50.0 Pa·s or less, even more preferably 16.0 Pa·s or more and 45.0 Pa·s or less, even still more preferably 18.0 Pa·s or more and 40.0 Pa·s or less, further more preferably 20.0 Pa·s or more and 35.0 Pa·s or less, and even further more preferably 21.0 Pa·s or more and 30.0 Pa·s or less.

The above-described viscosity η_{10P} of the two-pack type liquid resin composition according to the first embodiment refers to a viscosity one minute after rotation of the cone rotor set in the E-type viscometer starts.

In the two-pack type liquid resin composition according to the first embodiment, from the viewpoint of further improving the performance balance between the storage stability and the flowability of the two-pack type liquid resin composition, a viscosity ratio Ti_{P} (η_{5P}/η_{10P}) of the above-described viscosity η_{5P} to the above-described viscosity η_{10P} is preferably 0.5 or more, more preferably 0.6 or more, still more preferably 0.7 or more, even more preferably 0.8 or more, even still more preferably 0.9 or more, and further more preferably 1.0 or more; and is preferably 2.0 or less, more preferably 1.9 or less, still more preferably 1.8 or less, even more preferably 1.7 or less, even still more preferably 1.6 or less, further more preferably 1.5 or less, even further more preferably 1.4 or less, particularly preferably 1.3 or less, and most preferably 1.2 or less.

In addition, from the viewpoint of further improving the performance balance between the storage stability and the flowability of the two-pack type liquid resin composition, the Ti_{P} (η_{5P}/η_{10P}) of the two-pack type liquid resin composition according to the first embodiment is preferably 0.5 or more and 2.0 or less, more preferably 0.5 or more and 1.9 or less, still more preferably 0.5 or more and 1.8 or less, even more preferably 0.5 or more and 1.7 or less, even still more preferably 0.6 or more and 1.6 or less, further more preferably 0.7 or more and 1.5 or less, even further more preferably 0.8 or more and 1.4 or less, particularly preferably 0.9 or more and 1.3 or less, and most preferably 1.0 or more and 1.2 or less.

Hereinafter, components used in the resin composition according to the first embodiment will be described in detail.

### (Epoxy resin (A))

The two-pack type liquid resin composition according to the first embodiment includes an epoxy resin (A). As the epoxy resin in the first embodiment, from the viewpoint of further improving the performance balance of strength, hardness, elastic modulus, coefficient of thermal expansion, thermal conductivity, heat dissipation, and electrical properties of a cured product of the two-pack type liquid resin composition, the epoxy resin preferably includes one or two or more selected from the group consisting of alicyclic epoxy resins; bisphenol-type epoxy resins such as bisphenol A-type epoxy resin, bisphenol F-type epoxy resin, bisphenol E-type epoxy resin, bisphenol S-type epoxy resin, bisphenol M-type epoxy resin (4,4'-(1,3-phenylenediisopropylidene)bisphenol-type epoxy resin), bisphenol P-type epoxy resin (4,4'-(1,4-phenylenediisopropylidene)bisphenol-type epoxy resin), and bisphenol Z-type epoxy resin (4,4'-cyclohexylidenebisphenol-type epoxy resin); novolac-type epoxy resins such as phenol novolac-type epoxy resin, cresol novolac-type epoxy resin, trisphenolmethane-type novolac-type epoxy resin, tetraphenolethane-type novolac-type epoxy resin, and novolac-type epoxy resin having a condensed polycyclic aromatic hydrocarbon structure; aromatic glycidylamine-type epoxy resins such as N,N-diglycidylaniline, N,N-diglycidyltoluidine, diaminodiphenylmethane-type glycidylamine, and aminophenol-type glycidylamine; aminophenol-type epoxy resins; biphenyl-type epoxy resins; arylalkylene-type epoxy resins such as xylylene-type epoxy resin and biphenyl aralkyl-type epoxy resin; naphthalene-type epoxy resins such as naphthylene ether-type epoxy resin, naphthol-type epoxy resin, naphthalenediol-type epoxy resin, bifunctional to tetrafunctional epoxy-type naphthalene resin, binaphthyl-type epoxy resin, and naphthalene aralkyl-type epoxy resin; anthracene-type epoxy resins; phenoxy-type epoxy resins; dicyclopentadiene-type epoxy resins; norbornene-type epoxy resins; adamantane-type epoxy resins; and fluorene-type epoxy resins. From the viewpoint of further improving the flowability of the two-pack type liquid resin composition, the epoxy resin more preferably includes an alicyclic epoxy resin.

In the first embodiment, the alicyclic epoxy resin preferably includes an alicyclic epoxy resin that is liquid at 25°C, more preferably includes one or two or more selected from the group consisting of epoxy-[epoxy-oxaspiro-C₈₋₁₅alkyl]-cyclo-C₅₋₁₂alkanes such as vinylcyclopentadiene dioxide, vinylcyclohexene monoxide, vinylcyclohexene dioxide, dicyclopentadiene oxide, and 3,4-epoxy-1-[8,9-epoxy-2,4-dioxaspiro[5.5]undecan-3-yl]-cyclohexane; epoxy-C₅₋₁₂cycloalkyl-C₁₋₃alkyl-epoxy-C₅₋₁₂cycloalkane carboxylates such as 3,4-epoxycyclohexylmethyl-3',4'-epoxycyclohexane carboxylate and 4,5-epoxycyclooctylmethyl-4',5'-epoxycyclooctane carboxylate; and bis(C₁₋₃alkyl epoxy-C₅₋₁₂cycloalkyl-C₁₋₃alkyl) dicarboxylates such as bis(2-methyl-3,4-epoxycyclohexylmethyl) adipate, still more preferably includes an epoxy-C₅₋₁₂cycloalkyl-C₁₋₃alkyl-epoxy-C₅₋₁₂cycloalkane carboxylate, and even more preferably includes 3,4-epoxycyclohexylmethyl-3',4'-epoxycyclohexane carboxylate.

Examples of a commercially available product of the 3,4-epoxycyclohexylmethyl-3',4'-epoxycyclohexane carboxylate include Celloxide #2021P (epoxy equivalent: 128 to 140) manufactured by Daicel Corporation, which is preferably used.

When the epoxy resin (A) in the first embodiment includes an alicyclic epoxy resin, from the viewpoint of further improving the flowability of the two-pack type liquid resin composition, a content of the alicyclic epoxy resin in the epoxy resin (A) is preferably 50 parts by mass or more, more preferably 60 parts by mass or more, still more preferably 70 parts by mass or more, even more preferably 80 parts by mass or more, even still more preferably 90 parts by mass or more, and further more preferably 95 parts by mass or more, when the content of the epoxy resin (A) is taken as 100 parts by mass; and the upper limit value thereof is not particularly limited, but may be, for example, 100 parts by mass or less. In addition, from the viewpoint of further improving the flowability of the two-pack type liquid resin composition, the content of the alicyclic epoxy resin in the epoxy resin (A) is preferably 50 parts by mass or more and 100 parts by mass or less, more preferably 60 parts by mass or more and 100 parts by mass or less, still more preferably 70 parts by mass or more and 100 parts by mass or less, even more preferably 80 parts by mass or more and 100 parts by mass or less, even still more preferably 90 parts by mass or more and 100 parts by mass or less, and further more preferably 95 parts by mass or more and 100 parts by mass or less, when the content of the epoxy resin (A) is taken as 100 parts by mass.

When the total amount of the above-described two-pack type liquid resin composition is taken as 100% by mass, the content of the epoxy resin (A) in the two-pack type liquid resin composition according to the first embodiment is preferably 5% by mass or more, more preferably 6% by mass or more, still more preferably 7% by mass or more, even more preferably 8% by mass or more, even still more preferably 9% by mass or more, and further more preferably 10% by mass or more, from the viewpoint of further improving the performance balance of strength, hardness, elastic modulus, coefficient of thermal expansion, thermal conductivity, heat dissipation, and electrical properties of a cured product of the two-pack type liquid resin composition; and is preferably 30% by mass or less, more preferably 28% by mass or less, still more preferably 25% by mass or less, even more preferably 23% by mass or less, even still more preferably 20% by mass or less, further more preferably 18% by mass or less, even further more preferably 15% by mass or less, and particularly preferably 13% by mass or less, from the viewpoint of further improving the performance balance between the storage stability and the flowability of the two-pack type liquid resin composition.

In addition, from the viewpoint of further improving the performance balance of storage stability, flowability, strength, hardness, elastic modulus, coefficient of thermal expansion, thermal conductivity, heat dissipation, and electrical properties of the cured product of the two-pack type liquid resin composition, the content of the epoxy resin (A) in the two-pack type liquid resin composition is preferably 5% by mass or more and 30% by mass or less, more preferably 5% by mass or more and 28% by mass or less, still more preferably 5% by mass or more and 25% by mass or less, even more preferably 6% by mass or more and 23% by mass or less, even still more preferably 7% by mass or more and 20% by mass or less, further more preferably 8% by mass or more and 18% by mass or less, even further more preferably 9% by mass or more and 15% by mass or less, and particularly preferably 10% by mass or more and 13% by mass or less, when the total amount of the above-described two-pack type liquid resin composition is taken as 100% by mass.

### (Acid anhydride (B))

The two-pack type liquid resin composition according to the first embodiment includes an acid anhydride (B). The acid anhydride (B) functions as a curing agent for the epoxy resin (A).

As the acid anhydride (B) in the first embodiment, from the viewpoint of improving curability of the two-pack type liquid resin composition, the acid anhydride preferably includes one or two or more selected from the group consisting of dodecenyl succinic acid anhydride, polyadipic acid anhydride, polyazelaic acid anhydride, polysebacic acid anhydride, poly(ethyloctadecanedioic) acid anhydride, poly(phenylhexadecanedioic) acid anhydride, methyltetrahydrophthalic acid anhydride, methylhexahydrophthalic acid anhydride, hexahydrophthalic acid anhydride, methylhymic acid anhydride, tetrahydrophthalic acid anhydride, trialkyltetrahydrophthalic acid anhydride, methylcyclohexenedicarboxylic acid anhydride, phthalic acid anhydride, trimellitic acid anhydride, pyromellitic acid anhydride, benzophenonetetracarboxylic acid anhydride, ethylene glycol bistrimellitate, HET acid anhydride, tetrahydrophthalic acid anhydride, methylnadic acid anhydride (methyl-5-norbornene-2,3-dicarboxylic acid anhydride), methylhymic acid anhydride (methyl-3,6-endomethylene-1,2,3,6-tetrahydrophthalic acid anhydride), methylcyclohexane-1,2-dicarboxylic acid anhydride, and 5-(2,5-dioxotetrahydro-3-furanyl)-3-methyl-3-cyclohexane-1,2-dicarboxylic acid anhydride. From the viewpoint of further improving the performance balance between the storage stability and the flowability of the two-pack type liquid resin composition, the acid anhydride more preferably includes one or two or more selected from the group consisting of methyl-5-norbornene-2,3-dicarboxylic acid anhydride, methylcyclohexane-1,2-dicarboxylic acid anhydride, and methyltetrahydrophthalic acid anhydride, and still more preferably includes methyl-5-norbornene-2,3-dicarboxylic acid anhydride.

When the total amount of the above-described two-pack type liquid resin composition is taken as 100% by mass, a content of the acid anhydride (B) in the two-pack type liquid resin composition according to the first embodiment is preferably 5% by mass or more, more preferably 7% by mass or more, still more preferably 9% by mass or more, and even more preferably 11% by mass or more, from the viewpoint of improving the curability of the two-pack type liquid resin composition; and is preferably 20% by mass or less, more preferably 18% by mass or less, still more preferably 16% by mass or less, and even more preferably 14% by mass or less, from the viewpoint of further improving the performance balance between the storage stability and the flowability of the two-pack type liquid resin composition.

In addition, from the viewpoint of improving the performance balance of storage stability, flowability, and curability of the two-pack type liquid resin composition, the content of the acid anhydride (B) in the two-pack type liquid resin composition is preferably 5% by mass or more and 20% by mass or less, more preferably 7% by mass or more and 18% by mass or less, still more preferably 9% by mass or more and 16% by mass or less, and even more preferably 11% by mass or more and 14% by mass or less, when the total amount of the above-described two-pack type liquid resin composition is taken as 100% by mass.

### (Inorganic filler (C))

The two-pack type liquid resin composition according to the first embodiment includes an inorganic filler (C). The inorganic filler (C) preferably includes one or two or more selected from the group consisting of silica, alumina, zircon, iron oxide, zinc oxide, titanium oxide, silicon nitride, boron nitride, aluminum nitride, silicon carbide, glass fiber, glass flake, alumina fiber, carbon fiber, black lead, carbon black, ferrite, graphite, aluminum hydroxide, magnesium hydroxide, calcium carbonate, manganese carbonate, magnesium carbonate, barium sulfate, potassium titanate, calcium silicate, inorganic balloons, and silver powder, from the viewpoint of further improving the performance balance of strength, hardness, elastic modulus, coefficient of thermal expansion, thermal conductivity, heat dissipation, and electrical properties of the cured product of the two-pack type liquid resin composition. From the viewpoint of further improving the performance balance between storage stability and flowability of the two-pack type liquid resin composition, the inorganic filler (C) more preferably includes one or two or more selected from the group consisting of silica, alumina, aluminum hydroxide, and calcium carbonate. In addition, the inorganic filler may be subjected to surface treatment. Examples of the surface treatment include alkylation treatment, trimethylsilylation treatment, silicone treatment, and treatment with a silane coupling agent, but the surface treatment is not particularly limited thereto.

A shape of the inorganic filler (C) in the first embodiment is preferably fibrous, amorphous, or spherical from the viewpoint of further improving the performance balance of strength, hardness, elastic modulus, coefficient of thermal expansion, thermal conductivity, heat dissipation, and electrical properties of the cured product of the two-pack type liquid resin composition; and is more preferably spherical from the viewpoint of further improving the performance balance between storage stability and flowability of the two-pack type liquid resin composition.

As used herein, "spherical" may be a true sphere, an ellipsoid, or a substantially spherical shape including an egg shape and the like. The inorganic filler (C) in the first embodiment preferably has an aspect ratio (ratio of major axis to minor axis) of 1.3 or less, more preferably 1.2 or less, and still more preferably 1.1 or less.

From the viewpoint of further improving the performance balance between the storage stability and the flowability of the two-pack type liquid resin composition, an average particle diameter D₅₀ of the inorganic filler (C) in the first embodiment, at which a cumulative value reaches 50% in a volume-based particle size distribution measured by a laser diffraction scattering method, is preferably 0.5 µm or more, more preferably 1.0 µm or more, still more preferably 3.0 µm or more, even more preferably 5.0 µm or more, even still more preferably 7.0 µm or more, further more preferably 10.0 µm or more, even further more preferably 12.0 µm or more, particularly preferably 15.0 µm or more, more particularly preferably 17.0 µm or more, and most preferably 20.0 µm or more; and is preferably 100.0 µm or less, more preferably 90.0 µm or less, still more preferably 80.0 µm or less, even more preferably 70.0 µm or less, even still more preferably 60.0 µm or less, further more preferably 50.0 µm or less, even further more preferably 40.0 µm or less, and particularly preferably 30.0 µm or less.

In addition, from the viewpoint of further improving the performance balance between the storage stability and the flowability of the two-pack type liquid resin composition, the average particle diameter D₅₀ is preferably 0.5 µm or more and 100.0 µm or less, more preferably 1.0 µm or more and 100.0 µm or less, still more preferably 3.0 µm or more and 100.0 µm or less, even more preferably 5.0 µm or more and 90.0 µm or less, even still more preferably 7.0 µm or more and 80.0 µm or less, further more preferably 10.0 µm or more and 70.0 µm or less, even further more preferably 12.0 µm or more and 60.0 µm or less, particularly preferably 15.0 µm or more and 50.0 µm or less, more particularly preferably 17.0 µm or more and 40.0 µm or less, and most preferably 20.0 µm or more and 30.0 µm or less.

The inorganic filler (C) in the first embodiment may include inorganic fillers having two or more different average particle diameters D₅₀ within the above-described range of the average particle diameter D₅₀.

The average particle diameter D₅₀ of the inorganic filler (C) in the first embodiment can be measured by, for example, a laser diffraction scattering measurement method using a laser diffraction particle size distribution analyzer (for example, SALD-7000 manufactured by Shimadzu Corporation).

When the total amount of the above-described two-pack type liquid resin composition is taken as 100% by mass, a content of the inorganic filler (C) in the two-pack type liquid resin composition according to the first embodiment is preferably 65% by mass or more, more preferably 67% by mass or more, still more preferably 69% by mass or more, even more preferably 71% by mass or more, even still more preferably 73% by mass or more, and further more preferably 75% by mass or more, from the viewpoint of further improving the performance balance between the storage stability and the flowability of the two-pack type liquid resin composition; and is preferably 85% by mass or less, more preferably 83% by mass or less, still more preferably 81% by mass or less, even more preferably 79% by mass or less, and even still more preferably 77% by mass or less.

In addition, from the viewpoint of further improving the performance balance between the storage stability and the flowability of the two-pack type liquid resin composition, the content of the inorganic filler (C) in the two-pack type liquid resin composition is preferably 65% by mass or more and 85% by mass or less, more preferably 67% by mass or more and 85% by mass or less, still more preferably 69% by mass or more and 83% by mass or less, even more preferably 71% by mass or more and 81% by mass or less, even still more preferably 73% by mass or more and 79% by mass or less, and further more preferably 75% by mass or more and 77% by mass or less, when the total amount of the above-described two-pack type liquid resin composition is taken as 100% by mass.

When the total amount of the above-described first liquid is taken as 100% by mass, a content of the inorganic filler (C) in the first liquid according to the first embodiment is preferably 65% by mass or more, more preferably 67% by mass or more, still more preferably 69% by mass or more, even more preferably 71% by mass or more, and even still more preferably 73% by mass or more, from the viewpoint of further improving the performance balance between storage stability and flowability of the first liquid; and is preferably 85% by mass or less, more preferably 83% by mass or less, still more preferably 81% by mass or less, and even more preferably 79% by mass or less.

In addition, from the viewpoint of further improving the performance balance between the storage stability and the flowability of the first liquid, the content of the inorganic filler (C) in the first liquid is preferably 65% by mass or more and 85% by mass or less, more preferably 67% by mass or more and 85% by mass or less, still more preferably 69% by mass or more and 83% by mass or less, even more preferably 71% by mass or more and 81% by mass or less, and even still more preferably 73% by mass or more and 79% by mass or less, when the total amount of the above-described first liquid is taken as 100% by mass.

When the total amount of the above-described second liquid is taken as 100% by mass, a content of the inorganic filler (C) in the second liquid according to the first embodiment is preferably 65% by mass or more, more preferably 67% by mass or more, still more preferably 69% by mass or more, even more preferably 71% by mass or more, and even still more preferably 73% by mass or more, from the viewpoint of further improving the performance balance between the storage stability and the flowability of the second liquid; and is preferably 85% by mass or less, more preferably 83% by mass or less, still more preferably 81% by mass or less, even more preferably 79% by mass or less, and even still more preferably 77% by mass or less.

In addition, from the viewpoint of further improving the performance balance between the storage stability and the flowability of the second liquid, the content of the inorganic filler (C) in the second liquid is preferably 65% by mass or more and 85% by mass or less, more preferably 67% by mass or more and 83% by mass or less, still more preferably 69% by mass or more and 81% by mass or less, even more preferably 71% by mass or more and 79% by mass or less, and even still more preferably 73% by mass or more and 77% by mass or less, when the total amount of the above-described second liquid is taken as 100% by mass.

### (Sedimentation inhibitor (D))

The two-pack type liquid resin composition according to the first embodiment includes, as a sedimentation inhibitor (D), an inorganic thickener excluding the inorganic filler (C) described above. By including an inorganic thickener as the sedimentation inhibitor (D), sedimentation of the inorganic filler (C) in the two-pack type liquid resin composition can be suppressed.

From the viewpoint of further improving the performance balance between the storage stability and the flowability of the two-pack type liquid resin composition, the inorganic thickener in the first embodiment preferably includes one or two or more selected from the group consisting of a layered inorganic mineral and nanosilica.

From the viewpoint of further improving the performance balance between the storage stability and the flowability of the two-pack type liquid resin composition, the layered inorganic mineral in the first embodiment preferably includes one or two or more selected from the group consisting of clay and talc, and more preferably includes organoclay.

From the viewpoint of further improving the performance balance between the storage stability and the flowability of the two-pack type liquid resin composition, the clay in the first embodiment preferably includes one or two or more selected from the group consisting of kaolin, smectite, illite, bentonite (montmorillonite), hectorite, pyrophyllite, attapulgite, sepiolite, and laponite, and more preferably includes bentonite.

In addition, the organoclay in the first embodiment preferably includes one or two or more selected from the group consisting of organokaolin, organosmectite, organoillite, organobentonite (organomontmorillonite), organohectorite, organopyrophyllite, organoattapulgite, organosepiolite, and organolaponite; more preferably includes organobentonite from the viewpoint of further improving the performance balance between the storage stability and the flowability of the two-pack type liquid resin composition; still more preferably includes bentonite ion-exchanged with a quaternary ammonium salt, still more preferably includes bentonite ion-exchanged with a quaternary alkylammonium salt; even more preferably includes bentonite ion-exchanged with a quaternary alkylammonium salt including at least one alkyl group having 6 to 24 carbon atoms; and even still more preferably includes bentonite ion-exchanged with a quaternary alkylammonium salt including at least one alkyl group having 12 to 22 carbon atoms.

Here, the "organoclay" refers to a layered silicate (clay) in which an organic compound is intercalated in the interlayer of silicate planes laminated in layers. Between the silicate planes laminated in layers, for example, interlayer cations such as sodium ions and calcium ions are present and maintain a layered crystal structure. By ion-exchanging the interlayer cations with organic cations, the organic compound is chemically bonded to the surface of the silicate planes and is inserted in the interlayer.

In the organoclay, the organic compound that is ion-exchanged with the interlayer cations preferably includes a quaternary ammonium salt; more preferably includes a quaternary alkylammonium salt; still more preferably includes a quaternary alkylammonium salt including at least one alkyl group having 6 or more and 24 or less carbon atoms; even more preferably includes a quaternary alkylammonium salt including at least one alkyl group having 12 or more and 22 or less carbon atoms; and even still more preferably includes one or two or more selected from the group consisting of trimethylstearylammonium salt, dimethylstearylbenzylammonium salt, dimethyloctadecylammonium salt, oleylbis(2-hydroxyethyl)methylammonium salt, dimethylstearylammonium salt, benzyldimethylstearylammonium salt, and dimethyldistearylammonium salt.

Examples of a commercially available product of the organobentonite used in the first embodiment include BENTONE 34, BENTONE SD-1, BENTONE SD-2, BENTONE SD-3, BENTONE 57, and BENTONE 52 manufactured by Elementis PLC.; ESBEN NX, ESBEN N400, ESBEN WX, ESBEN NZ, ESBEN, ESBEN W, ESBEN C, ESBEN E, ESBEN NZ70, ESBEN NTO, ESBEN NX80, ESBEN NO12S, ESBEN NEZ, ESBEN NO12, and ESBEN NE manufactured by HOJUN Co., Ltd.; and KUNIVIS 110, KUNIVIS 120, and KUNIVIS 127 manufactured by Kunimine Industries.

Examples of a commercially available product of the organohectorite used in the first embodiment include BENTONE 27 and BENTONE 38 manufactured by Elementis PLC.

The nanosilica included in the inorganic thickener according to the first embodiment refers to silica having an average particle diameter D₅₀ of primary particles of less than 0.100 µm, the D₅₀ being a particle diameter at which a cumulative value reaches 50% in a volume-based particle size distribution measured by a laser diffraction scattering method.

From the viewpoint of further improving the performance balance between the storage stability and the flowability of the two-pack type liquid resin composition, the above-described average particle diameter D₅₀ of the nanosilica in the first embodiment is preferably 0.090 µm or less, more preferably 0.080 µm or less, still more preferably 0.070 µm or less, even more preferably 0.060 µm or less, even still more preferably 0.050 µm or less, further more preferably 0.040 µm or less, even further more preferably 0.030 µm or less, and most preferably 0.020 µm or less; and the lower limit value thereof is not particularly limited, but may be, for example, 0.001 µm or more, 0.003 µm or more, 0.005 µm or more, 0.008 µm or more, or 0.010 µm or more.

In addition, from the viewpoint of further improving the performance balance between the storage stability and the flowability of the two-pack type liquid resin composition, the above-described average particle diameter D₅₀ of the nanosilica is preferably 0.001 µm or more and 0.090 µm or less, more preferably 0.001 µm or more and 0.080 µm or less, still more preferably 0.001 µm or more and 0.070 µm or less, even more preferably 0.001 µm or more and 0.060 µm or less, even still more preferably 0.003 µm or more and 0.050 µm or less, further more preferably 0.005 µm or more and 0.040 µm or less, even further more preferably 0.008 µm or more and 0.030 µm or less, and most preferably 0.010 µm or more and 0.020 µm or less.

The average particle diameter D₅₀ of the nanosilica in the first embodiment can be measured by, for example, a laser diffraction scattering measurement method using a laser diffraction particle size distribution analyzer (for example, SALD-7000 manufactured by Shimadzu Corporation).

As the nanosilica in the first embodiment, for example, REOLOSIL QS09, REOLOSIL QS10, REOLOSIL QS102, REOLOSIL CP102, REOLOSIL QS20, REOLOSIL QS20L, REOLOSIL QS30, REOLOSIL QS40, and the like, manufactured by Tokuyama Corporation, can be used.

When the total amount of the above-described two-pack type liquid resin composition is taken as 100% by mass, a content of the sedimentation inhibitor (D) in the two-pack type liquid resin composition according to the first embodiment is preferably 0.01% by mass or more, more preferably 0.03% by mass or more, still more preferably 0.05% by mass or more, and even more preferably 0.08% by mass or more, from the viewpoint of further suppressing sedimentation of the inorganic filler (C) in the two-pack type liquid resin composition; and is preferably 2.00% by mass or less, more preferably 1.50% by mass or less, still more preferably 1.00% by mass or less, even more preferably 0.80% by mass or less, even still more preferably 0.50% by mass or less, further more preferably 0.30% by mass or less, and even further more preferably 0.20% by mass or less, from the viewpoint of further improving the performance balance between the storage stability and the flowability of the two-pack type liquid resin composition.

In addition, from the viewpoints of further suppressing sedimentation of the inorganic filler (C) in the two-pack type liquid resin composition and further improving the performance balance between the storage stability and the flowability of the two-pack type liquid resin composition, the content of the sedimentation inhibitor (D) in the two-pack type liquid resin composition is preferably 0.01% by mass or more and 2.00% by mass or less, more preferably 0.01% by mass or more and 1.50% by mass or less, still more preferably 0.01% by mass or more and 1.00% by mass or less, even more preferably 0.01% by mass or more and 0.80% by mass or less, even still more preferably 0.03% by mass or more and 0.50% by mass or less, further more preferably 0.05% by mass or more and 0.30% by mass or less, and even further more preferably 0.08% by mass or more and 0.20% by mass or less, when the total amount of the above-described two-pack type liquid resin composition is taken as 100% by mass.

When the total amount of the above-described first liquid is taken as 100% by mass, a content of the sedimentation inhibitor (D) in the first liquid according to the first embodiment is preferably 0.01% by mass or more, more preferably 0.03% by mass or more, still more preferably 0.05% by mass or more, and even more preferably 0.08% by mass or more, from the viewpoint of suppressing sedimentation of the inorganic filler (C) in the first liquid; and is preferably 2.00% by mass or less, more preferably 1.50% by mass or less, still more preferably 1.00% by mass or less, even more preferably 0.80% by mass or less, even still more preferably 0.50% by mass or less, and further more preferably 0.30% by mass or less, from the viewpoint of further improving the performance balance between the storage stability and the flowability of the first liquid.

In addition, from the viewpoints of suppressing sedimentation of the inorganic filler (C) in the first liquid and further improving the performance balance between the storage stability and the flowability of the first liquid, the content of the sedimentation inhibitor (D) in the first liquid is preferably 0.01% by mass or more and 2.00% by mass or less, more preferably 0.01% by mass or more and 1.50% by mass or less, still more preferably 0.01% by mass or more and 1.00% by mass or less, even more preferably 0.03% by mass or more and 0.80% by mass or less, even still more preferably 0.05% by mass or more and 0.50% by mass or less, and further more preferably 0.08% by mass or more and 0.30% by mass or less, when the total amount of the above-described first liquid is taken as 100% by mass.

When the total amount of the above-described second liquid is taken as 100% by mass, a content of the sedimentation inhibitor (D) in the second liquid according to the first embodiment is preferably 0.01% by mass or more, more preferably 0.03% by mass or more, still more preferably 0.05% by mass or more, and even more preferably 0.08% by mass or more, from the viewpoint of suppressing sedimentation of the inorganic filler (C) in the second liquid; and is preferably 2.00% by mass or less, more preferably 1.50% by mass or less, still more preferably 1.00% by mass or less, even more preferably 0.80% by mass or less, even still more preferably 0.50% by mass or less, further more preferably 0.30% by mass or less, even further more preferably 0.20% by mass or less, and most preferably 0.15% by mass or less, from the viewpoint of further improving the performance balance between the storage stability and the flowability of the second liquid.

In addition, from the viewpoints of suppressing sedimentation of the inorganic filler (C) in the second liquid and further improving the performance balance between storage stability and flowability of the second liquid, the content of the sedimentation inhibitor (D) in the second liquid is preferably 0.01% by mass or more and 2.00% by mass or less, more preferably 0.01% by mass or more and 1.50% by mass or less, still more preferably 0.01% by mass or more and 1.00% by mass or less, even more preferably 0.01% by mass or more and 0.80% by mass or less, even still more preferably 0.01% by mass or more and 0.50% by mass or less, further more preferably 0.03% by mass or more and 0.30% by mass or less, even further more preferably 0.05% by mass or more and 0.20% by mass or less, and most preferably 0.08% by mass or more and 0.15% by mass or less, when the total amount of the above-described second liquid is taken as 100% by mass.

### (Curing accelerator (E))

The two-pack type liquid resin composition according to the first embodiment preferably further includes a curing accelerator (E) from the viewpoint of promoting the reaction between the epoxy resin (A) and the acid anhydride (B) to improve the curability of the two-pack type liquid resin composition.

It is preferable that the curing accelerator (E) in the first embodiment is included in the second liquid, from the viewpoint of further improving the performance balance between the storage stability and the flowability of the two-pack type liquid resin composition.

From the viewpoint of improving the curability of the two-pack type liquid resin composition, the curing accelerator (E) in the first embodiment preferably includes one or two or more selected from the group consisting of a tertiary amine, a quaternary ammonium salt, imidazoles, an organic phosphine, and a Lewis acid catalyst, and more preferably includes a quaternary ammonium salt.

The tertiary amine preferably includes one or two or more selected from the group consisting of trimethylamine, triethylamine, tripropylamine, tributylamine, and benzyldimethylamine.

The quaternary ammonium salt preferably includes one or two or more selected from the group consisting of organic acid salts of diazabicycloundecene, such as DBU [1,8-diazabicyclo[5.4.0]undec-7-ene] octylate (manufactured by San-Apro Ltd., trade name: SA102), DBN [1,5-diazabicyclo[4.3.0]non-5-ene], quaternary ammonium salts that are salts of tertiary amines and carboxylic acids (manufactured by San-Apro Ltd., trade name: U-CAT2313), octadecyltrimethylammonium chloride (manufactured by NOF CORPORATION, trade name: NISSAN CATION), and tetraalkylammonium salts (each alkyl group having 1 to 18 carbon atoms) (for example, tetraethylammonium bromide, tetrabutylammonium bromide, and tetraalkylammonium carboxylates (carboxylic acids having 1 to 12 carbon atoms)).

The curing accelerator (E) in the first embodiment more preferably includes an organic acid salt of diazabicycloundecene, from the viewpoint of improving the curability of the two-pack type liquid resin composition.

The imidazoles preferably include one or two or more selected from the group consisting of 1-benzyl-2-methylimidazole, 2-ethyl-4-methylimidazole, 2-undecylimidazole, 1,2-dimethylimidazole, and 1-benzyl-2-phenylimidazole.

The organic phosphine preferably includes one or two or more selected from the group consisting of triphenylphosphine, triphenylphosphine-triphenylborate, tris(p-methoxyphenyl)phosphine, and tetraphenylphosphonium tetraphenylborate.

The Lewis acid catalyst preferably includes one or two or more selected from the group consisting of boron trifluoride amine complex, boron trichloride amine complex, and boron trifluoride ethylamine complex.

When the total amount of the above-described two-pack type liquid resin composition is taken as 100% by mass, a content of the curing accelerator (E) in the two-pack type liquid resin composition according to the first embodiment is preferably 0.01% by mass or more, more preferably 0.05% by mass or more, still more preferably 0.10% by mass or more, even more preferably 0.15% by mass or more, and even still more preferably 0.20% by mass or more, from the viewpoint of improving the curability of the two-pack type liquid resin composition; and is preferably 1.00% by mass or less, more preferably 0.80% by mass or less, still more preferably 0.50% by mass or less, and even more preferably 0.30% by mass or less, from the viewpoint of further improving the performance balance between the storage stability and the flowability of the two-pack type liquid resin composition.

In addition, from the viewpoint of improving curability, storage stability, and flowability of the two-pack type liquid resin composition, the content of the curing accelerator (E) in the two-pack type liquid resin composition is preferably 0.01% by mass or more and 1.00% by mass or less, more preferably 0.05% by mass or more and 1.00% by mass or less, still more preferably 0.10% by mass or more and 0.80% by mass or less, even more preferably 0.15% by mass or more and 0.50% by mass or less, and even still more preferably 0.20% by mass or more and 0.30% by mass or less, when the total amount of the above-described two-pack type liquid resin composition is taken as 100% by mass.

### (Other components)

The two-pack type liquid resin composition according to the first embodiment may include a coupling agent, a colorant such as carbon black, an antifoaming agent such as a silicone antifoaming agent, a flame retardant, and the like as necessary.

From the viewpoint of improving an interfacial strength between the epoxy resin (A) and the inorganic filler (C), the coupling agent in the first embodiment preferably includes one or two or more selected from the group consisting of an epoxy silane coupling agent, an amino silane coupling agent, a ureido silane coupling agent, and a mercapto silane coupling agent, and more preferably includes an epoxy silane coupling agent.

The epoxy silane coupling agent preferably includes one or two or more selected from the group consisting of γ-glycidoxypropyltriethoxysilane, γ-glycidoxypropyltrimethoxysilane, γ-glycidoxypropylmethyldimethoxysilane, and β-(3,4-epoxycyclohexyl)ethyltrimethoxysilane, and more preferably includes γ-glycidoxypropyltrimethoxysilane.

The amino silane coupling agent preferably includes one or two or more selected from the group consisting of γ-aminopropyltriethoxysilane, γ-aminopropyltrimethoxysilane, N-β(aminoethyl)γ-aminopropyltrimethoxysilane, N-β(aminoethyl)γ-aminopropylmethyldimethoxysilane, N-phenyl-γ-aminopropyltriethoxysilane, N-phenyl-γ-aminopropyltrimethoxysilane, N-β(aminoethyl)γ-aminopropyltriethoxysilane, N-(6-aminohexyl)3-aminopropyltrimethoxysilane, and N-(3-(trimethoxysilylpropyl)-1,3-benzenedimethanamine.

The ureido silane coupling agent includes, for example, one or two or more selected from the group consisting of γ-ureidopropyltriethoxysilane and hexamethyldisilazane.

When the total amount of the above-described two-pack type liquid resin composition is taken as 100% by mass, a content of the coupling agent in the two-pack type liquid resin composition according to the first embodiment is preferably 0.01% by mass or more, more preferably 0.03% by mass or more, still more preferably 0.05% by mass or more, and even more preferably 0.08% by mass or more, from the viewpoint of improving the interfacial strength between the epoxy resin (A) and the inorganic filler (C); and is preferably 1.00% by mass or less, more preferably 0.80% by mass or less, still more preferably 0.60% by mass or less, even more preferably 0.40% by mass or less, and even still more preferably 0.20% by mass or less.

In addition, from the viewpoint of improving the interfacial strength between the epoxy resin (A) and the inorganic filler (C), the content of the coupling agent in the two-pack type liquid resin composition is preferably 0.01% by mass or more and 1.00% by mass or less, more preferably 0.01% by mass or more and 0.80% by mass or less, still more preferably 0.03% by mass or more and 0.60% by mass or less, even more preferably 0.05% by mass or more and 0.40% by mass or less, and even still more preferably 0.08% by mass or more and 0.20% by mass or less, when the total amount of the above-described two-pack type liquid resin composition is taken as 100% by mass.

The colorant in the first embodiment preferably includes one or two or more selected from the group consisting of carbon black, titanium oxide, barium sulfate, iron black, red iron oxide, aniline black, and alizarin, and more preferably includes carbon black.

When the total amount of the above-described two-pack type liquid resin composition is taken as 100% by mass, a content of the colorant in the two-pack type liquid resin composition according to the first embodiment is preferably 0.01% by mass or more, more preferably 0.02% by mass or more, still more preferably 0.03% by mass or more, even more preferably 0.04% by mass or more, and even still more preferably 0.05% by mass or more; and is preferably 0.50% by mass or less, more preferably 0.40% by mass or less, still more preferably 0.30% by mass or less, even more preferably 0.20% by mass or less, and even still more preferably 0.10% by mass or less.

In addition, the content of the colorant in the two-pack type liquid resin composition is preferably 0.01% by mass or more and 0.50% by mass or less, more preferably 0.02% by mass or more and 0.40% by mass or less, still more preferably 0.03% by mass or more and 0.30% by mass or less, even more preferably 0.04% by mass or more and 0.20% by mass or less, and even still more preferably 0.05% by mass or more and 0.10% by mass or less, when the total amount of the above-described two-pack type liquid resin composition is taken as 100% by mass.

The antifoaming agent in the first embodiment preferably includes one or two or more selected from the group consisting of a silicone-based antifoaming agent, a fluorine-based antifoaming agent, and a polymer-based antifoaming agent, and more preferably includes a silicone-based antifoaming agent.

When the total amount of the above-described two-pack type liquid resin composition is taken as 100% by mass, a content of the antifoaming agent in the two-pack type liquid resin composition according to the first embodiment is preferably 0.01% by mass or more, more preferably 0.03% by mass or more, still more preferably 0.05% by mass or more, and even more preferably 0.08% by mass or more; and is preferably 1.00% by mass or less, more preferably 0.80% by mass or less, still more preferably 0.60% by mass or less, even more preferably 0.40% by mass or less, and even still more preferably 0.20% by mass or less.

In addition, the content of the antifoaming agent in the two-pack type liquid resin composition is preferably 0.01% by mass or more and 1.00% by mass or less, more preferably 0.01% by mass or more and 0.80% by mass or less, still more preferably 0.03% by mass or more and 0.60% by mass or less, even more preferably 0.05% by mass or more and 0.40% by mass or less, and even still more preferably 0.08% by mass or more and 0.20% by mass or less, when the total amount of the two-pack type liquid resin composition is taken as 100% by mass.

The flame retardant in the first embodiment preferably includes one or two or more selected from the group consisting of aluminum hydroxide, magnesium hydroxide, zinc borate, zinc molybdate, antimony trioxide, antimony pentoxide, phosphazene, brominated epoxy resin, and brominated polycarbonate, from the viewpoint of further improving flame retardancy of the cured product of the two-pack type liquid resin composition.

From the viewpoint of further improving the flame retardancy of the cured product of the two-pack type liquid resin composition, a content of the flame retardant in the two-pack type liquid resin composition according to the first embodiment is preferably 1.0% by mass or more and 50% by mass or less, and more preferably 5.0% by mass or more and 30% by mass or less, when the total amount of the above-described two-pack type liquid resin composition is taken as 100% by mass.

### (Method for producing two-pack type liquid resin composition)

A method for producing the two-pack type liquid resin composition according to the first embodiment will be described in detail.

The two-pack type liquid resin composition according to the first embodiment can be produced by sufficiently mixing and stirring, as a first liquid, the epoxy resin (A), the inorganic filler (C), the sedimentation inhibitor (D), and other components, and sufficiently mixing and stirring, as a second liquid, the acid anhydride (B), the inorganic filler (C), the sedimentation inhibitor (D), and other components, among the above-described components, by a known method.

When the two-pack type liquid resin composition according to the first embodiment includes a curing accelerator (E), it is preferable that the second liquid includes the curing accelerator (E).

Examples of a method of mixing and stirring each component to obtain the first liquid or the second liquid in the two-pack type liquid resin composition according to the first embodiment include a method using a mixing machine such as a mixer, and a method using a kneading machine such as a roll and a kneader.

The two-pack type liquid resin composition according to the first embodiment is used in a state of a mixed liquid obtained by mixing the first liquid and the second liquid. Examples of a method of mixing the first liquid and the second liquid include a method using a mixing machine such as a mixer, and a method using a kneading machine such as a roll and a kneader.

In the two-pack type liquid resin composition according to the first embodiment, when the amount of the above-described first liquid is taken as 100 parts by mass, a content of the second liquid when further mixing the first liquid and the second liquid is preferably 50 parts by mass or more, more preferably 70 parts by mass or more, and still more preferably 90 parts by mass or more, from the viewpoint of further improving the performance balance of flowability, heat resistance during curing, and mechanical properties of the two-pack type liquid resin composition; and is preferably 150 parts by mass or less, more preferably 130 parts by mass or less, and still more preferably 110 parts by mass or less.

In addition, from the viewpoint of further improving the performance balance of flowability, heat resistance during curing, and mechanical properties of the two-pack type liquid resin composition, the content of the second liquid when further mixing the first liquid and the second liquid is preferably 50 parts by mass or more and 150 parts by mass or less, more preferably 70 parts by mass or more and 130 parts by mass or less, and still more preferably 90 parts by mass or more and 110 parts by mass or less, when the amount of the above-described first liquid is taken as 100 parts by mass.

### <Second embodiment>

### [Two-pack type liquid resin composition]

The two-pack type liquid resin composition according to the second embodiment is a two-pack type liquid resin composition including a first liquid and a second liquid, in which the first liquid includes an epoxy resin (A), an inorganic filler (C), and a sedimentation inhibitor (D), the second liquid includes an acid anhydride (B), an inorganic filler (C), and a sedimentation inhibitor (D), the sedimentation inhibitor (D) includes a dispersant, and a viscosity η_{5A} of the first liquid, measured under conditions of a rotational speed of 5 rpm and a temperature of 25°C using an E-type viscometer and a 3°×R14 cone rotor, is 1.0 Pa·s or more and 50.0 Pa·s or less.

The two-pack type liquid resin composition according to the second embodiment can improve the performance balance between storage stability and flowability by satisfying the above-described configuration.

In the two-pack type liquid resin composition according to the second embodiment, specific components in the first liquid and the second liquid of the two-pack type liquid resin composition are considered to contribute to maintaining a preferred dispersion state of the inorganic filler (C) in the first liquid and the second liquid. Further, when the viscosity η_{5A} of the first liquid is within the above-described numerical range, the flowability of the first liquid under quiescent conditions becomes suitable from the viewpoint of storage stability, and sedimentation of the inorganic filler (C) in the first liquid is considered to be physically suppressed. As a result, the two-pack type liquid resin composition according to the second embodiment is considered capable of improving the performance balance between storage stability in the first-liquid and second-liquid states and flowability suitable for workability in casting.

In the two-pack type liquid resin composition according to the second embodiment, from the viewpoint of further improving the performance balance between the storage stability and the flowability of the two-pack type liquid resin composition, the above-described viscosity η_{5A} is preferably 3.0 Pa·s or more, more preferably 5.0 Pa·s or more, still more preferably 8.0 Pa·s or more, even more preferably 10.0 Pa·s or more, even still more preferably 15.0 Pa·s or more, and further more preferably 20.0 Pa·s or more; and is preferably 40.0 Pa·s or less, more preferably 30.0 Pa·s or less, and still more preferably 25.0 Pa·s or less.

In addition, from the viewpoint of further improving the performance balance between the storage stability and the flowability of the two-pack type liquid resin composition, the viscosity η_{5A} of the two-pack type liquid resin composition according to the second embodiment is preferably 3.0 Pa·s or more and 40.0 Pa·s or less, more preferably 5.0 Pa·s or more and 40.0 Pa·s or less, still more preferably 8.0 Pa·s or more and 40.0 Pa·s or less, even more preferably 10.0 Pa·s or more and 40.0 Pa·s or less, even still more preferably 15.0 Pa·s or more and 30.0 Pa·s or less, and further more preferably 20.0 Pa·s or more and 25.0 Pa·s or less.

The above-described viscosity η_{5A} of the two-pack type liquid resin composition according to the second embodiment refers to a viscosity one minute after rotation of the cone rotor set in the E-type viscometer starts.

In the two-pack type liquid resin composition according to the second embodiment, from the viewpoint of further improving the performance balance between the storage stability and the flowability of the two-pack type liquid resin composition, a viscosity η_{10A} of the above-described first liquid, measured under conditions of a rotational speed of 10 rpm and a temperature of 25°C using an E-type viscometer and a 3°×R14 cone rotor, is preferably 1.0 Pa·s or more, more preferably 3.0 Pa·s or more, still more preferably 5.0 Pa·s or more, even more preferably 8.0 Pa·s or more, even still more preferably 10.0 Pa·s or more, further more preferably 15.0 Pa·s or more, and even further more preferably 20.0 Pa·s or more; and is preferably 50.0 Pa·s or less, more preferably 40.0 Pa·s or less, and still more preferably 30.0 Pa·s or less.

In addition, from the viewpoint of further improving the performance balance between the storage stability and the flowability of the two-pack type liquid resin composition, the viscosity η_{10A} of the two-pack type liquid resin composition according to the second embodiment is preferably 1.0 Pa·s or more and 50.0 Pa·s or less, more preferably 3.0 Pa·s or more and 50.0 Pa·s or less, still more preferably 5.0 Pa·s or more and 50.0 Pa·s or less, even more preferably 8.0 Pa·s or more and 50.0 Pa·s or less, even still more preferably 10.0 Pa·s or more and 50.0 Pa·s or less, further more preferably 15.0 Pa·s or more and 40.0 Pa·s or less, and even further more preferably 20.0 Pa·s or more and 30.0 Pa·s or less.

The above-described viscosity η_{10A} of the two-pack type liquid resin composition according to the second embodiment refers to a viscosity one minute after rotation of the cone rotor set in the E-type viscometer starts.

In the two-pack type liquid resin composition according to the second embodiment, from the viewpoint of further improving the performance balance between the storage stability and the flowability of the two-pack type liquid resin composition, a viscosity ratio Ti_{A} (η_{5A}/η_{10A}) of the above-described viscosity η_{5A} to the above-described viscosity η_{10A} is preferably 0.4 or more, more preferably 0.5 or more, still more preferably 0.6 or more, even more preferably 0.7 or more, and even still more preferably 0.8 or more; and is preferably 1.5 or less, more preferably 1.3 or less, still more preferably 1.1 or less, and even more preferably 0.9 or less.

In addition, from the viewpoint of further improving the performance balance between the storage stability and the flowability of the two-pack type liquid resin composition, the viscosity ratio Ti_{A} (η_{5A}/η_{10A}) of the two-pack type liquid resin composition according to the second embodiment is preferably 0.4 or more and 1.5 or less, more preferably 0.5 or more and 1.5 or less, still more preferably 0.6 or more and 1.3 or less, even more preferably 0.7 or more and 1.1 or less, and even still more preferably 0.8 or more and 0.9 or less.

In the two-pack type liquid resin composition according to the second embodiment, from the viewpoint of further improving the performance balance between the storage stability and the flowability of the two-pack type liquid resin composition, a viscosity η_{5B} of the above-described second liquid, measured under conditions of a rotational speed of 5 rpm and a temperature of 25°C using an E-type viscometer and a 3°×R14 cone rotor, is preferably 1.0 Pa·s or more, more preferably 5.0 Pa·s or more, still more preferably 10.0 Pa·s or more, even more preferably 15.0 Pa·s or more, and even still more preferably 20.0 Pa·s or more; and is preferably 70.0 Pa·s or less, more preferably 65.0 Pa·s or less, still more preferably 60.0 Pa·s or less, even more preferably 55.0 Pa·s or less, even still more preferably 50.0 Pa·s or less, further more preferably 45.0 Pa·s or less, even further more preferably 40.0 Pa·s or less, and most preferably 35.0 Pa·s or less.

In addition, from the viewpoint of further improving the performance balance between the storage stability and the flowability of the two-pack type liquid resin composition, the viscosity η_{5B} of the two-pack type liquid resin composition according to the second embodiment is preferably 1.0 Pa·s or more and 70.0 Pa·s or less, more preferably 1.0 Pa·s or more and 65.0 Pa·s or less, still more preferably 1.0 Pa·s or more and 60.0 Pa·s or less, even more preferably 1.0 Pa·s or more and 55.0 Pa·s or less, even still more preferably 5.0 Pa·s or more and 50.0 Pa·s or less, further more preferably 10.0 Pa·s or more and 45.0 Pa·s or less, even further more preferably 15.0 Pa·s or more and 40.0 Pa·s or less, and particularly preferably 20.0 Pa·s or more and 35.0 Pa·s or less.

The above-described viscosity η_{5B} of the two-pack type liquid resin composition according to the second embodiment refers to a viscosity one minute after rotation of the cone rotor set in the E-type viscometer starts.

In the two-pack type liquid resin composition according to the second embodiment, from the viewpoint of further improving the performance balance between the storage stability and the flowability of the two-pack type liquid resin composition, a viscosity η_{10B} of the above-described second liquid, measured under conditions of a rotational speed of 10 rpm and a temperature of 25°C using an E-type viscometer and a 3°×R14 cone rotor, is preferably 1.0 Pa·s or more, more preferably 3.0 Pa·s or more, still more preferably 5.0 Pa·s or more, even more preferably 10.0 Pa·s or more, and even still more preferably 15.0 Pa·s or more; and is preferably 50.0 Pa·s or less, more preferably 45.0 Pa·s or less, still more preferably 40.0 Pa·s or less, even more preferably 35.0 Pa·s or less, and even still more preferably 30.0 Pa·s or less.

In addition, from the viewpoint of further improving the performance balance between the storage stability and the flowability of the two-pack type liquid resin composition, the viscosity η_{10B} of the two-pack type liquid resin composition according to the second embodiment is preferably 1.0 Pa·s or more and 50.0 Pa·s or less, more preferably 3.0 Pa·s or more and 45.0 Pa·s or less, still more preferably 5.0 Pa·s or more and 40.0 Pa·s or less, even more preferably 10.0 Pa·s or more and 35.0 Pa·s or less, and even still more preferably 15.0 Pa·s or more and 30.0 Pa·s or less.

The above-described viscosity η_{10B} of the two-pack type liquid resin composition according to the second embodiment refers to a viscosity one minute after rotation of the cone rotor set in the E-type viscometer starts.

In the two-pack type liquid resin composition according to the second embodiment, from the viewpoint of further improving the performance balance between the storage stability and the flowability of the two-pack type liquid resin composition, a viscosity ratio Ti_{B} (η_{5B}/η_{10B}) of the above-described viscosity η_{5B} to the above-described viscosity η_{10B} is preferably 0.5 or more, more preferably 0.8 or more, and still more preferably 1.0 or more; and is preferably 4.0 or less, more preferably 3.5 or less, still more preferably 3.0 or less, even more preferably 2.5 or less, even still more preferably 2.0 or less, and further more preferably 1.5 or less.

In addition, from the viewpoint of further improving the performance balance between the storage stability and the flowability of the two-pack type liquid resin composition, the viscosity ratio Ti_{B} (η_{5B}/η_{10B}) of the two-pack type liquid resin composition according to the second embodiment is preferably 0.5 or more and 4.0 or less, more preferably 0.5 or more and 3.5 or less, still more preferably 0.5 or more and 3.0 or less, even more preferably 0.5 or more and 2.5 or less, even still more preferably 0.8 or more and 2.0 or less, and further more preferably 1.0 or more and 1.5 or less.

In the two-pack type liquid resin composition according to the second embodiment, from the viewpoint of further improving the performance balance between the storage stability and the flowability of the two-pack type liquid resin composition, a viscosity η_{5P} of a mixed liquid of the above-described first liquid and the above-described second liquid, measured under conditions of a rotational speed of 5 rpm and a temperature of 25°C using an E-type viscometer and a 3°×R14 cone rotor, is preferably 1.0 Pa·s or more, more preferably 5.0 Pa·s or more, still more preferably 10.0 Pa·s or more, even more preferably 15.0 Pa·s or more, and even still more preferably 20.0 Pa·s or more; and is preferably 50.0 Pa·s or less, more preferably 45.0 Pa·s or less, still more preferably 40.0 Pa·s or less, even more preferably 35.0 Pa·s or less, even still more preferably 30.0 Pa·s or less, and further more preferably 28.0 Pa·s or less.

In addition, from the viewpoint of further improving the performance balance between the storage stability and the flowability of the two-pack type liquid resin composition, the viscosity η_{5P} of the two-pack type liquid resin composition according to the second embodiment is preferably 1.0 Pa·s or more and 50.0 Pa·s or less, more preferably 1.0 Pa·s or more and 45.0 Pa·s or less, still more preferably 5.0 Pa·s or more and 40.0 Pa·s or less, even more preferably 10.0 Pa·s or more and 35.0 Pa·s or less, even still more preferably 15.0 Pa·s or more and 30.0 Pa·s or less, and further more preferably 20.0 Pa·s or more and 28.0 Pa·s or less.

The above-described viscosity η_{5P} of the two-pack type liquid resin composition according to the second embodiment refers to a viscosity one minute after rotation of the cone rotor set in the E-type viscometer starts.

In the two-pack type liquid resin composition according to the second embodiment, from the viewpoint of further improving the performance balance between the storage stability and the flowability of the two-pack type liquid resin composition, a viscosity η_{10P} of the mixed liquid of the above-described first liquid and the above-described second liquid, measured under conditions of a rotational speed of 10 rpm and a temperature of 25°C using an E-type viscometer and a 3°×R14 cone rotor, is preferably 10.0 Pa·s or more, more preferably 12.0 Pa·s or more, still more preferably 14.0 Pa·s or more, even more preferably 16.0 Pa·s or more, even still more preferably 18.0 Pa·s or more, further more preferably 20.0 Pa·s or more, and even further more preferably 21.0 Pa·s or more; and is preferably 50.0 Pa·s or less, more preferably 45.0 Pa·s or less, still more preferably 40.0 Pa·s or less, even more preferably 35.0 Pa·s or less, even still more preferably 30.0 Pa·s or less, and further more preferably 27.0 Pa·s or less.

In addition, from the viewpoint of further improving the performance balance between the storage stability and the flowability of the two-pack type liquid resin composition, the viscosity η_{10P} of the two-pack type liquid resin composition according to the second embodiment is preferably 10.0 Pa·s or more and 50.0 Pa·s or less, more preferably 12.0 Pa·s or more and 50.0 Pa·s or less, still more preferably 14.0 Pa·s or more and 45.0 Pa·s or less, even more preferably 16.0 Pa·s or more and 40.0 Pa·s or less, even still more preferably 18.0 Pa·s or more and 35.0 Pa·s or less, further more preferably 20.0 Pa·s or more and 30.0 Pa·s or less, and even further more preferably 21.0 Pa·s or more and 27.0 Pa·s or less.

The above-described viscosity η_{10P} of the two-pack type liquid resin composition according to the second embodiment refers to a viscosity one minute after rotation of the cone rotor set in the E-type viscometer starts.

In the two-pack type liquid resin composition according to the second embodiment, from the viewpoint of further improving the performance balance between the storage stability and the flowability of the two-pack type liquid resin composition, a viscosity ratio Ti_{P} (η_{5P}/η_{10P}) of the above-described viscosity η_{5P} to the above-described viscosity η_{10P} is preferably 0.5 or more, more preferably 0.6 or more, still more preferably 0.7 or more, even more preferably 0.8 or more, even still more preferably 0.9 or more, and further more preferably 1.0 or more; and is preferably 2.0 or less, more preferably 1.9 or less, still more preferably 1.8 or less, even more preferably 1.7 or less, even still more preferably 1.6 or less, further more preferably 1.5 or less, even further more preferably 1.4 or less, particularly preferably 1.3 or less, and most preferably 1.2 or less.

In addition, from the viewpoint of further improving the performance balance between the storage stability and the flowability of the two-pack type liquid resin composition, the viscosity ratio Ti_{P} (η_{5P}/η_{10P}) of the two-pack type liquid resin composition according to the second embodiment is preferably 0.5 or more and 2.0 or less, more preferably 0.5 or more and 1.9 or less, still more preferably 0.5 or more and 1.8 or less, even more preferably 0.5 or more and 1.7 or less, even still more preferably 0.6 or more and 1.6 or less, further more preferably 0.7 or more and 1.5 or less, even further more preferably 0.8 or more and 1.4 or less, particularly preferably 0.9 or more and 1.3 or less, and most preferably 1.0 or more and 1.2 or less.

Hereinafter, components used in the resin composition according to the second embodiment will be described in detail.

### (Epoxy resin (A))

The two-pack type liquid resin composition according to the second embodiment includes an epoxy resin (A). As the epoxy resin in the second embodiment, from the viewpoint of further improving the performance balance of strength, hardness, elastic modulus, coefficient of thermal expansion, thermal conductivity, heat dissipation, and electrical properties of a cured product of the two-pack type liquid resin composition, the epoxy resin preferably includes one or two or more selected from the group consisting of alicyclic epoxy resins; bisphenol-type epoxy resins such as bisphenol A-type epoxy resin, bisphenol F-type epoxy resin, bisphenol E-type epoxy resin, bisphenol S-type epoxy resin, bisphenol M-type epoxy resin (4,4'-(1,3-phenylenediisopropylidene)bisphenol-type epoxy resin), bisphenol P-type epoxy resin (4,4'-(1,4-phenylenediisopropylidene)bisphenol-type epoxy resin), and bisphenol Z-type epoxy resin (4,4'-cyclohexylidenebisphenol-type epoxy resin); novolac-type epoxy resins such as phenol novolac-type epoxy resin, cresol novolac-type epoxy resin, trisphenolmethane-type novolac-type epoxy resin, tetraphenolethane-type novolac-type epoxy resin, and novolac-type epoxy resin having a condensed polycyclic aromatic hydrocarbon structure; aromatic glycidylamine-type epoxy resins such as N,N-diglycidylaniline, N,N-diglycidyltoluidine, diaminodiphenylmethane-type glycidylamine, and aminophenol-type glycidylamine; aminophenol-type epoxy resins; biphenyl-type epoxy resins; arylalkylene-type epoxy resins such as xylylene-type epoxy resin and biphenyl aralkyl-type epoxy resin; naphthalene-type epoxy resins such as naphthylene ether-type epoxy resin, naphthol-type epoxy resin, naphthalenediol-type epoxy resin, bifunctional to tetrafunctional epoxy-type naphthalene resin, binaphthyl-type epoxy resin, and naphthalene aralkyl-type epoxy resin; anthracene-type epoxy resins; phenoxy-type epoxy resins; dicyclopentadiene-type epoxy resins; norbornene-type epoxy resins; adamantane-type epoxy resins; and fluorene-type epoxy resins. From the viewpoint of further improving the flowability of the two-pack type liquid resin composition, the epoxy resin more preferably includes an alicyclic epoxy resin.

In the second embodiment, the alicyclic epoxy resin preferably includes an alicyclic epoxy resin that is liquid at 25°C, more preferably includes one or two or more selected from the group consisting of epoxy-[epoxy-oxaspiro-C₈₋₁₅alkyl]-cyclo-C₅₋₁₂alkanes such as vinylcyclopentadiene dioxide, vinylcyclohexene monoxide, vinylcyclohexene dioxide, dicyclopentadiene oxide, and 3,4-epoxy-1-[8,9-epoxy-2,4-dioxaspiro[5.5]undecan-3-yl]-cyclohexane; epoxy-C₅₋₁₂cycloalkyl-C₁₋₃alkyl-epoxy-C₅₋₁₂cycloalkane carboxylates such as 3,4-epoxycyclohexylmethyl-3',4'-epoxycyclohexane carboxylate and 4,5-epoxycyclooctylmethyl-4',5'-epoxycyclooctane carboxylate; and bis(C₁₋₃alkyl epoxy-C₅₋₁₂cycloalkyl-C₁₋₃alkyl) dicarboxylates such as bis(2-methyl-3,4-epoxycyclohexylmethyl) adipate, still more preferably includes an epoxy-C₅₋₁₂cycloalkyl-C₁₋₃alkyl-epoxy-C₅₋₁₂cycloalkane carboxylate, and even more preferably includes 3,4-epoxycyclohexylmethyl-3',4'-epoxycyclohexane carboxylate.

Examples of a commercially available product of the 3,4-epoxycyclohexylmethyl-3',4'-epoxycyclohexane carboxylate include Celloxide #2021P (epoxy equivalent: 128 to 140) manufactured by Daicel Corporation, which is preferably used.

When the epoxy resin (A) in the second embodiment includes an alicyclic epoxy resin, from the viewpoint of further improving the flowability of the two-pack type liquid resin composition, a content of the alicyclic epoxy resin in the epoxy resin (A) is preferably 50 parts by mass or more, more preferably 60 parts by mass or more, still more preferably 70 parts by mass or more, even more preferably 80 parts by mass or more, even still more preferably 90 parts by mass or more, and further more preferably 95 parts by mass or more, when the content of the epoxy resin (A) is taken as 100 parts by mass; and the upper limit value thereof is not particularly limited, but may be, for example, 100 parts by mass or less.

In addition, from the viewpoint of further improving the flowability of the two-pack type liquid resin composition, the content of the alicyclic epoxy resin in the epoxy resin (A) is preferably 50 parts by mass or more and 100 parts by mass or less, more preferably 60 parts by mass or more and 100 parts by mass or less, still more preferably 70 parts by mass or more and 100 parts by mass or less, even more preferably 80 parts by mass or more and 100 parts by mass or less, even still more preferably 90 parts by mass or more and 100 parts by mass or less, and further more preferably 95 parts by mass or more and 100 parts by mass or less, when the content of the epoxy resin (A) is taken as 100 parts by mass.

When the total amount of the above-described two-pack type liquid resin composition is taken as 100% by mass, the content of the epoxy resin (A) in the two-pack type liquid resin composition according to the second embodiment is preferably 5% by mass or more, more preferably 6% by mass or more, still more preferably 7% by mass or more, even more preferably 8% by mass or more, even still more preferably 9% by mass or more, and further more preferably 10% by mass or more, from the viewpoint of further improving the performance balance of strength, hardness, elastic modulus, coefficient of thermal expansion, thermal conductivity, heat dissipation, and electrical properties of a cured product of the two-pack type liquid resin composition; and is preferably 30% by mass or less, more preferably 28% by mass or less, still more preferably 25% by mass or less, even more preferably 23% by mass or less, even still more preferably 20% by mass or less, further more preferably 18% by mass or less, even further more preferably 15% by mass or less, particularly preferably 13% by mass or less, and most preferably 11% by mass or less, from the viewpoint of further improving the performance balance between the storage stability and the flowability of the two-pack type liquid resin composition.

In addition, from the viewpoint of further improving the performance balance of storage stability, flowability, strength, hardness, elastic modulus, coefficient of thermal expansion, thermal conductivity, heat dissipation, and electrical properties of the cured product of the two-pack type liquid resin composition, the content of the epoxy resin (A) in the two-pack type liquid resin composition is preferably 5% by mass or more and 30% by mass or less, more preferably 5% by mass or more and 28% by mass or less, still more preferably 5% by mass or more and 25% by mass or less, even more preferably 5% by mass or more and 23% by mass or less, even still more preferably 6% by mass or more and 20% by mass or less, further more preferably 7% by mass or more and 18% by mass or less, even further more preferably 8% by mass or more and 15% by mass or less, particularly preferably 9% by mass or more and 13% by mass or less, and most preferably 10% by mass or more and 11% by mass or less, when the total amount of the above-described two-pack type liquid resin composition is taken as 100% by mass.

### (Acid anhydride (B))

The two-pack type liquid resin composition according to the second embodiment includes an acid anhydride (B). The acid anhydride (B) functions as a curing agent for the epoxy resin (A).

As the acid anhydride (B) in the second embodiment, from the viewpoint of improving curability of the two-pack type liquid resin composition, the acid anhydride preferably includes one or two or more selected from the group consisting of dodecenyl succinic acid anhydride, polyadipic acid anhydride, polyazelaic acid anhydride, polysebacic acid anhydride, poly(ethyloctadecanedioic) acid anhydride, poly(phenylhexadecanedioic) acid anhydride, methyltetrahydrophthalic acid anhydride, methylhexahydrophthalic acid anhydride, hexahydrophthalic acid anhydride, methylhymic acid anhydride, tetrahydrophthalic acid anhydride, trialkyltetrahydrophthalic acid anhydride, methylcyclohexenedicarboxylic acid anhydride, phthalic acid anhydride, trimellitic acid anhydride, pyromellitic acid anhydride, benzophenonetetracarboxylic acid anhydride, ethylene glycol bistrimellitate, HET acid anhydride, tetrahydrophthalic acid anhydride, methylnadic acid anhydride (methyl-5-norbornene-2,3-dicarboxylic acid anhydride), methylhymic acid anhydride (methyl-3,6-endomethylene-1,2,3,6-tetrahydrophthalic acid anhydride), methylcyclohexane-1,2-dicarboxylic acid anhydride, and 5-(2,5-dioxotetrahydro-3-furanyl)-3-methyl-3-cyclohexane-1,2-dicarboxylic acid anhydride. From the viewpoint of further improving the performance balance between the storage stability and the flowability of the two-pack type liquid resin composition, the acid anhydride more preferably includes one or two or more selected from the group consisting of methyl-5-norbornene-2,3-dicarboxylic acid anhydride, methylcyclohexane-1,2-dicarboxylic acid anhydride, and methyltetrahydrophthalic acid anhydride, and still more preferably includes methyl-5-norbornene-2,3-dicarboxylic acid anhydride.

When the total amount of the above-described two-pack type liquid resin composition is taken as 100% by mass, a content of the acid anhydride (B) in the two-pack type liquid resin composition according to the second embodiment is preferably 5% by mass or more, more preferably 7% by mass or more, still more preferably 9% by mass or more, and even more preferably 11% by mass or more, from the viewpoint of improving the curability of the two-pack type liquid resin composition; and is preferably 20% by mass or less, more preferably 18% by mass or less, still more preferably 16% by mass or less, even more preferably 14% by mass or less, and even still more preferably 13% by mass or less, from the viewpoint of further improving the performance balance between the storage stability and the flowability of the two-pack type liquid resin composition.

In addition, from the viewpoint of improving the performance balance of storage stability, flowability, and curability of the two-pack type liquid resin composition, the content of the acid anhydride (B) in the two-pack type liquid resin composition is preferably 5% by mass or more and 20% by mass or less, more preferably 5% by mass or more and 18% by mass or less, still more preferably 7% by mass or more and 16% by mass or less, even more preferably 9% by mass or more and 14% by mass or less, and even still more preferably 11% by mass or more and 13% by mass or less, when the total amount of the above-described two-pack type liquid resin composition is taken as 100% by mass.

### (Inorganic filler (C))

The two-pack type liquid resin composition according to the second embodiment includes an inorganic filler (C). The inorganic filler (C) preferably includes one or two or more selected from the group consisting of silica, alumina, zircon, iron oxide, zinc oxide, titanium oxide, silicon nitride, boron nitride, aluminum nitride, silicon carbide, glass fiber, glass flake, alumina fiber, carbon fiber, black lead, carbon black, ferrite, graphite, aluminum hydroxide, magnesium hydroxide, calcium carbonate, manganese carbonate, magnesium carbonate, barium sulfate, potassium titanate, calcium silicate, inorganic balloons, and silver powder, from the viewpoint of further improving the performance balance of strength, hardness, elastic modulus, coefficient of thermal expansion, thermal conductivity, heat dissipation, and electrical properties of the cured product of the two-pack type liquid resin composition. From the viewpoint of further improving the performance balance between storage stability and flowability of the two-pack type liquid resin composition, the inorganic filler (C) more preferably includes one or two or more selected from the group consisting of silica, alumina, aluminum hydroxide, and calcium carbonate. In addition, the inorganic filler may be subjected to surface treatment. Examples of the surface treatment include alkylation treatment, trimethylsilylation treatment, silicone treatment, and treatment with a silane coupling agent, but the surface treatment is not particularly limited thereto.

A shape of the inorganic filler (C) in the second embodiment is preferably fibrous, amorphous, or spherical from the viewpoint of further improving the performance balance of strength, hardness, elastic modulus, coefficient of thermal expansion, thermal conductivity, heat dissipation, and electrical properties of the cured product of the two-pack type liquid resin composition; and is more preferably spherical from the viewpoint of further improving the performance balance between storage stability and flowability of the two-pack type liquid resin composition.

As used herein, "spherical" may be a true sphere, an ellipsoid, or a substantially spherical shape including an egg shape and the like. The inorganic filler (C) in the second embodiment preferably has an aspect ratio (ratio of major axis to minor axis) of 1.3 or less, more preferably 1.2 or less, and still more preferably 1.1 or less.

From the viewpoint of further improving the performance balance between the storage stability and the flowability of the two-pack type liquid resin composition, an average particle diameter D₅₀ of the inorganic filler (C) in the second embodiment, at which a cumulative value reaches 50% in a volume-based particle size distribution measured by a laser diffraction scattering method, is preferably 0.5 µm or more, more preferably 1.0 µm or more, still more preferably 3.0 µm or more, even more preferably 5.0 µm or more, even still more preferably 7.0 µm or more, further more preferably 10.0 µm or more, even further more preferably 12.0 µm or more, particularly preferably 15.0 µm or more, more particularly preferably 17.0 µm or more, and most preferably 20.0 µm or more; and is preferably 100.0 µm or less, more preferably 90.0 µm or less, still more preferably 80.0 µm or less, even more preferably 70.0 µm or less, even still more preferably 60.0 µm or less, further more preferably 50.0 µm or less, even further more preferably 40.0 µm or less, and particularly preferably 30.0 µm or less.

In addition, from the viewpoint of further improving the performance balance between the storage stability and the flowability of the two-pack type liquid resin composition, the average particle diameter D₅₀ is preferably 0.5 µm or more and 100.0 µm or less, more preferably 1.0 µm or more and 100.0 µm or less, still more preferably 3.0 µm or more and 100.0 µm or less, even more preferably 5.0 µm or more and 90.0 µm or less, even still more preferably 7.0 µm or more and 80.0 µm or less, further more preferably 10.0 µm or more and 70.0 µm or less, even further more preferably 12.0 µm or more and 60.0 µm or less, particularly preferably 15.0 µm or more and 50.0 µm or less, more particularly preferably 17.0 µm or more and 40.0 µm or less, and most preferably 20.0 µm or more and 30.0 µm or less.

The inorganic filler (C) in the second embodiment may include inorganic fillers having two or more different average particle diameters D₅₀ within the above-described range of the average particle diameter D₅₀.

The average particle diameter D₅₀ of the inorganic filler (C) in the second embodiment can be measured by, for example, a laser diffraction scattering measurement method using a laser diffraction particle size distribution analyzer (for example, SALD-7000 manufactured by Shimadzu Corporation).

When the total amount of the above-described two-pack type liquid resin composition is taken as 100% by mass, a content of the inorganic filler (C) in the two-pack type liquid resin composition according to the second embodiment is preferably 65% by mass or more, more preferably 67% by mass or more, still more preferably 69% by mass or more, even more preferably 71% by mass or more, even still more preferably 73% by mass or more, and further more preferably 75% by mass or more, from the viewpoint of further improving the performance balance between the storage stability and the flowability of the two-pack type liquid resin composition; and is preferably 85% by mass or less, more preferably 83% by mass or less, still more preferably 81% by mass or less, even more preferably 79% by mass or less, and even still more preferably 77% by mass or less.

In addition, from the viewpoint of further improving the performance balance between the storage stability and the flowability of the two-pack type liquid resin composition, the content of the inorganic filler (C) in the two-pack type liquid resin composition is preferably 65% by mass or more and 85% by mass or less, more preferably 67% by mass or more and 85% by mass or less, still more preferably 69% by mass or more and 83% by mass or less, even more preferably 71% by mass or more and 81% by mass or less, even still more preferably 73% by mass or more and 79% by mass or less, and further more preferably 75% by mass or more and 77% by mass or less, when the total amount of the above-described two-pack type liquid resin composition is taken as 100% by mass.

When the total amount of the above-described first liquid is taken as 100% by mass, a content of the inorganic filler (C) in the first liquid according to the second embodiment is preferably 65% by mass or more, more preferably 67% by mass or more, still more preferably 69% by mass or more, even more preferably 71% by mass or more, even still more preferably 73% by mass or more, further more preferably 75% by mass or more, and even further more preferably 77% by mass or more, from the viewpoint of further improving the performance balance between storage stability and flowability of the first liquid; and is preferably 85% by mass or less, more preferably 83% by mass or less, still more preferably 81% by mass or less, and even more preferably 79% by mass or less.

In addition, from the viewpoint of further improving the performance balance between the storage stability and the flowability of the first liquid, the content of the inorganic filler (C) in the first liquid is preferably 65% by mass or more and 85% by mass or less, more preferably 67% by mass or more and 85% by mass or less, still more preferably 69% by mass or more and 85% by mass or less, even more preferably 71% by mass or more and 85% by mass or less, even still more preferably 73% by mass or more and 83% by mass or less, further more preferably 75% by mass or more and 81% by mass or less, and even further more preferably 77% by mass or more and 79% by mass or less, when the total amount of the above-described first liquid is taken as 100% by mass.

When the total amount of the above-described second liquid is taken as 100% by mass, a content of the inorganic filler (C) in the second liquid according to the second embodiment is preferably 65% by mass or more, more preferably 67% by mass or more, still more preferably 69% by mass or more, even more preferably 71% by mass or more, and even still more preferably 73% by mass or more, from the viewpoint of further improving the performance balance between the storage stability and the flowability of the second liquid; and is preferably 85% by mass or less, more preferably 83% by mass or less, still more preferably 81% by mass or less, even more preferably 79% by mass or less, and even still more preferably 77% by mass or less.

In addition, from the viewpoint of further improving the performance balance between the storage stability and the flowability of the second liquid, the content of the inorganic filler (C) in the second liquid is preferably 65% by mass or more and 85% by mass or less, more preferably 67% by mass or more and 83% by mass or less, still more preferably 69% by mass or more and 81% by mass or less, even more preferably 71% by mass or more and 79% by mass or less, and even still more preferably 73% by mass or more and 77% by mass or less, when the total amount of the above-described second liquid is taken as 100% by mass.

### (Sedimentation inhibitor (D))

The two-pack type liquid resin composition according to the second embodiment includes a dispersant as a sedimentation inhibitor (D). By including a dispersant as the sedimentation inhibitor (D), sedimentation of the inorganic filler (C) in the two-pack type liquid resin composition can be suppressed.

As the dispersant in the second embodiment, the dispersant preferably includes an ester compound including a long-chain hydrocarbon group; more preferably includes one or two or more selected from the group consisting of a carboxylic acid ester compound including a long-chain hydrocarbon group, a phosphoric acid ester compound including a long-chain hydrocarbon group, a sulfuric acid ester compound including a long-chain hydrocarbon group, a nitric acid ester compound including a long-chain hydrocarbon group, and a carbonic acid ester compound including a long-chain hydrocarbon group; and still more preferably includes one or two or more selected from the group consisting of a carboxylic acid ester compound including a long-chain hydrocarbon group and a phosphoric acid ester compound including a long-chain hydrocarbon group.

Since such an ester compound including a long-chain hydrocarbon group can suppress secondary aggregation of the inorganic filler (C) due to steric hindrance by the long-chain hydrocarbon group, it is considered that the performance balance between the storage stability and the flowability of the two-pack type liquid resin composition can be further improved.

From the viewpoint of further improving the performance balance between the storage stability and the flowability of the two-pack type liquid resin composition, the long-chain hydrocarbon group in the ester compound including a long-chain hydrocarbon group in the second embodiment preferably includes one or two or more selected from the group consisting of an alkylene group, an alkyl group, an alkenyl group, an aralkyl group, an aryl group, and an aryl group in which one, two, or three hydrogen atoms of a hydrocarbon are substituted by substituents; and more preferably includes one or two or more selected from the group consisting of an alkylene group, an alkyl group, and an alkenyl group.

The long-chain hydrocarbon group may be linear or branched. In the long-chain hydrocarbon group, a part of hydrogen atoms of the long-chain hydrocarbon group may be substituted by a substituent such as a hydroxy group, an aldehyde group, a carbonyl group, a carboxy group, an amino group, a nitro group, a sulfo group, and a halogeno group. The long-chain hydrocarbon group may include a bonding group including oxygen, such as an ether bond and an ester bond, in the long chain.

From the viewpoint of further improving the performance balance between the storage stability and the flowability of the two-pack type liquid resin composition, the ester group in the ester compound including a long-chain hydrocarbon group in the second embodiment preferably includes one or two or more selected from the group consisting of a carboxylic acid ester group, a phosphoric acid ester group, a sulfuric acid ester group, a nitric acid ester group, and a carbonic acid ester group; and more preferably includes one or two or more selected from the group consisting of a carboxylic acid ester group and a phosphoric acid ester group.

From the viewpoint of further improving the performance balance between the storage stability and the flowability of the two-pack type liquid resin composition, the number of carbon atoms of the long-chain hydrocarbon group in the ester compound including a long-chain hydrocarbon group in the second embodiment is preferably 4 or more, more preferably 6 or more, still more preferably 8 or more, and even more preferably 10 or more; and is preferably 1000 or less, more preferably 800 or less, still more preferably 600 or less, even more preferably 400 or less, and even still more preferably 200 or less.

In addition, from the viewpoint of further improving the performance balance between the storage stability and the flowability of the two-pack type liquid resin composition, the number of carbon atoms of the long-chain hydrocarbon group is preferably 4 or more and 1000 or less, more preferably 4 or more and 800 or less, still more preferably 6 or more and 600 or less, even more preferably 8 or more and 400 or less, and even still more preferably 10 or more and 200 or less.

From the viewpoint of further improving the performance balance between the storage stability and the flowability of the two-pack type liquid resin composition, a mass-average molecular weight of the ester compound including a long-chain hydrocarbon group in the second embodiment is preferably 300 or more, more preferably 400 or more, still more preferably 500 or more, even more preferably 600 or more, even still more preferably 700 or more, and further more preferably 800 or more; and is preferably 50,000 or less, more preferably 30,000 or less, still more preferably 15,000 or less, and even more preferably 10,000 or less.

In addition, from the viewpoint of further improving the performance balance between the storage stability and the flowability of the two-pack type liquid resin composition, the mass-average molecular weight of the ester compound is preferably 300 or more and 50,000 or less, more preferably 400 or more and 50,000 or less, still more preferably 500 or more and 50,000 or less, even more preferably 600 or more and 30,000 or less, even still more preferably 700 or more and 15,000 or less, and further more preferably 800 or more and 10,000 or less.

From the viewpoint of further improving the performance balance between the storage stability and the flowability of the two-pack type liquid resin composition, the ester compound including a long-chain hydrocarbon group in the second embodiment preferably includes one or two or more selected from the group consisting of a polyhydroxycarboxylic acid ester, an acidic phosphate ester, and a carboxyl group-including polymer-modified product.

From the viewpoint of further improving the performance balance between the storage stability and the flowability of the two-pack type liquid resin composition, the polyhydroxycarboxylic acid ester in the second embodiment preferably includes a compound represented by General Formula (Ib).

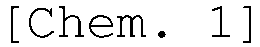

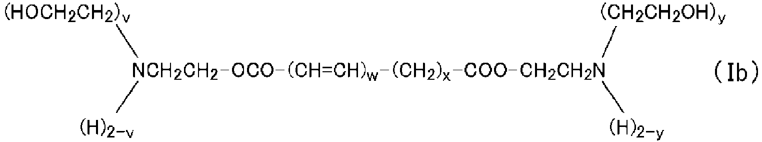

In General Formula (Ib), v and y are each independently 1 or 2, w is an integer of 0 or more and 10 or less, and x is an integer of 14 or more and 40 or less. -(CH=CH)w₋(CH2₎x₋ may be a block structure in which w pieces of (CH=CH) are successively linked, followed by x pieces of (CH₂) consecutively linked, or may be a random structure in which (CH=CH) and (CH₂) are randomly arranged.

In General Formula (Ib), from the viewpoint of further improving the performance balance between the storage stability and the flowability of the two-pack type liquid resin composition, w is preferably an integer of 0 or more and 8 or less. In addition, from the viewpoint of further improving the performance balance between the storage stability and the flowability of the two-pack type liquid resin composition, x is preferably an integer of 18 or more and 36 or less.

Examples of a commercially available product of the polyhydroxycarboxylic acid ester used in the second embodiment include BYK-R606 manufactured by BYK-Chemie Japan.

From the viewpoint of further improving the performance balance between the storage stability and the flowability of the two-pack type liquid resin composition, the acidic phosphate ester in the second embodiment preferably includes a compound represented by General Formula (IIb).

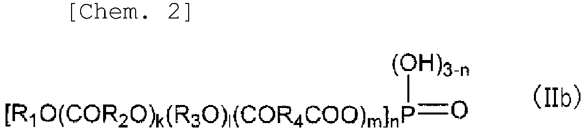

In General Formula (IIb), R₁ is a saturated or unsaturated hydrocarbyl group having 4 or more and 20 or less carbon atoms, R₂ is a saturated hydrocarbylene group having 1 or more and 20 or less carbon atoms, R₃ is a saturated hydrocarbylene group having 2 or 3 carbon atoms, R₄ is a saturated or unsaturated hydrocarbylene group having 1 or more and 8 or less carbon atoms, k, l, and m are each an integer of 0 or more and 20 or less, and n is 1 or 2. When a plurality of R₁'s are present, the plurality of R₁'s may be the same or different; when a plurality of R₂'s are present, the plurality of R₂'s may be the same or different; when a plurality of R₃'s are present, the plurality of R₃'s may be the same or different; and when a plurality of R₄'s are present, the plurality of R₄'s may be the same or different. The sequence of k -COR₂O- groups, l -R₃O- groups, and m -COR₄COO- groups is arbitrary, and in a case of n = 2, two R₁O(COR₂O)ₖ(R₃O)ₗ(COR₄COO)ₘ groups may be the same or different.

In General Formula (IIb), R₁ is not particularly limited as long as it is a saturated or unsaturated hydrocarbyl group having 4 or more and 20 or less carbon atoms. R1 preferably includes one or two or more selected from the group consisting of a saturated hydrocarbon group and an unsaturated hydrocarbon group. The saturated hydrocarbon group preferably includes one or two or more selected from the group consisting of an octyl group, a 2-ethylhexyl group, a nonyl group, a decyl group, an undecyl group, a dodecyl group, a tetradecyl group, a hexadecyl group, and an octadecyl group. The unsaturated hydrocarbon group preferably includes one or two or more selected from the group consisting of a phenyl group and a nonylphenyl group. From the viewpoint of further improving the performance balance between the storage stability and the flowability of the two-pack type liquid resin composition, the number of carbon atoms in R₁ is preferably 6 or more and 18 or less, and when k = l = m = 0, the number of carbon atoms in R₁ is preferably 10 or more and 18 or less.

In General Formula (IIb), R₂ is a saturated hydrocarbylene group having 1 or more and 20 or less carbon atoms. The number of carbon atoms in R₂ is preferably 1 or more and 16 or less. From the viewpoint of further improving the performance balance between the storage stability and the flowability of the two-pack type liquid resin composition, R₂ preferably includes one or two or more selected from the group consisting of a methylene group, an ethylene group, a pentylene group, a tetradecylene group, and a pentadecylene group.

In General Formula (IIb), R₃ is a saturated hydrocarbylene group having 2 or 3 carbon atoms. From the viewpoint of further improving the performance balance between the storage stability and the flowability of the two-pack type liquid resin composition, R₃ is preferably a saturated hydrocarbylene group having 2 carbon atoms, and more preferably an ethylene group.

In General Formula (IIb), R₄ is a saturated or unsaturated hydrocarbylene group having 1 or more and 8 or less carbon atoms. The number of carbon atoms in R₄ is preferably 1 or more and 6 or less. From the viewpoint of further improving the performance balance between the storage stability and the flowability of the two-pack type liquid resin composition, R₄ preferably includes one or two or more selected from the group consisting of a methylene group, an ethylene group, a propylene group, a butylene group, a pentylene group, and a phenyl group.

In General Formula (IIb), from the viewpoint of further improving the performance balance between the storage stability and the flowability of the two-pack type liquid resin composition, k, l, and m are each preferably an integer of 0 to 10.

In General Formula (IIb), the sequence in which the monomer units indicated by k, l, and m, namely k -COR₂O- groups, l -R₃O-groups, and m -COR₄COO- groups, are arranged between the R₁O-group and the phosphorus atom is arbitrary. These groups are not necessarily arranged as in General Formula (IIb). In addition, the -(COR₂O)ₖ(R₃O)ₗ(COR₄COO)ₘ- group may be a block copolymer or a random copolymer.

Examples of a commercially available product of the acidic phosphate ester used in the second embodiment include BYK-W9010 manufactured by BYK-Chemie Japan.

The carboxyl group-including polymer-modified product in the second embodiment includes an ester compound obtained by esterifying an α-olefin/maleic anhydride copolymer with a monohydric alcohol. In such an ester compound, the arrangement of a hydrophobic moiety such as a hydrocarbon group derived from an α-olefin and a hydrophilic moiety such as a carboxyl group formed by ring-opening addition of a maleic anhydride-derived maleic anhydride group is controlled.

From the viewpoint of further improving the performance balance between the storage stability and the flowability of the two-pack type liquid resin composition, the α-olefin constituting the ester compound of the α-olefin/maleic anhydride copolymer and the monohydric alcohol in the second embodiment preferably includes a linear or branched unsaturated hydrocarbon having 6 or more carbon atoms, and preferably includes an unsaturated hydrocarbon having 6 or more and 30 or less carbon atoms. The unsaturated hydrocarbon having 6 or more and 30 or less carbon atoms preferably includes one or two or more selected from the group consisting of 1-dodecene and 1-tetradecene.

From the viewpoint of further improving the performance balance between the storage stability and the flowability of the two-pack type liquid resin composition, the monohydric alcohol used for forming the ester compound of the α-olefin/maleic anhydride copolymer and the monohydric alcohol in the second embodiment preferably includes one or two or more selected from the group consisting of an aliphatic alcohol, an aromatic alcohol, and a polyalkylene glycol monoalkyl ether.

The aliphatic alcohol in the second embodiment preferably includes one or two or more selected from the group consisting of cetyl alcohol and stearyl alcohol.

The aromatic alcohol in the second embodiment preferably includes one or two or more selected from the group consisting of 1-phenyl-1-propanol and α-phenoxy-2-propanol.

The polyalkylene glycol monoalkyl ether in the second embodiment preferably includes a polyethylene glycol monoalkyl ether having a molecular weight of 400 to 700.

An acid value of the carboxyl group-including polymer-modified product in the second embodiment is preferably 10 mgKOH/g or more and 100 mgKOH/g or less, and more preferably 15 mgKOH/g or more and 60 mgKOH/g or less.

Examples of a commercially available product of the carboxyl group-including polymer-modified product used in the second embodiment include FLOREN G-700, FLOREN G-900, FLOREN G-1500, and NC-500 manufactured by Kyoeisha Chemical.

When the total amount of the above-described two-pack type liquid resin composition is taken as 100% by mass, a content of the sedimentation inhibitor (D) in the two-pack type liquid resin composition according to the second embodiment is preferably 0.01% by mass or more, more preferably 0.03% by mass or more, still more preferably 0.05% by mass or more, even more preferably 0.08% by mass or more, even still more preferably 0.10% by mass or more, further more preferably 0.13% by mass or more, and even further more preferably 0.15% by mass or more, from the viewpoint of further suppressing sedimentation of the inorganic filler (C) in the two-pack type liquid resin composition; and is preferably 2.00% by mass or less, more preferably 1.50% by mass or less, still more preferably 1.00% by mass or less, even more preferably 0.80% by mass or less, even still more preferably 0.50% by mass or less, further more preferably 0.30% by mass or less, even further more preferably 0.25% by mass or less, and particularly preferably 0.20% by mass or less, from the viewpoint of further improving the performance balance between the storage stability and the flowability of the two-pack type liquid resin composition.

In addition, from the viewpoints of further suppressing sedimentation of the inorganic filler (C) in the two-pack type liquid resin composition and further improving the performance balance between the storage stability and the flowability of the two-pack type liquid resin composition, the content of the sedimentation inhibitor (D) in the two-pack type liquid resin composition is preferably 0.01% by mass or more and 2.00% by mass or less, more preferably 0.01% by mass or more and 1.50% by mass or less, still more preferably 0.03% by mass or more and 1.00% by mass or less, even more preferably 0.05% by mass or more and 0.80% by mass or less, even still more preferably 0.08% by mass or more and 0.50% by mass or less, further more preferably 0.10% by mass or more and 0.30% by mass or less, even further more preferably 0.13% by mass or more and 0.25% by mass or less, and particularly preferably 0.15% by mass or more and 0.20% by mass or less, when the total amount of the above-described two-pack type liquid resin composition is taken as 100% by mass.

When the total amount of the above-described first liquid is taken as 100% by mass, a content of the sedimentation inhibitor (D) in the first liquid according to the second embodiment is preferably 0.01% by mass or more, more preferably 0.03% by mass or more, still more preferably 0.05% by mass or more, even more preferably 0.08% by mass or more, even still more preferably 0.10% by mass or more, further more preferably 0.13% by mass or more, even further more preferably 0.15% by mass or more, and particularly preferably 0.18% by mass or more, from the viewpoint of suppressing sedimentation of the inorganic filler (C) in the first liquid; and is preferably 2.00% by mass or less, more preferably 1.50% by mass or less, still more preferably 1.00% by mass or less, even more preferably 0.80% by mass or less, even still more preferably 0.50% by mass or less, further more preferably 0.30% by mass or less, and even further more preferably 0.25% by mass or less, from the viewpoint of further improving the performance balance between the storage stability and the flowability of the first liquid.

In addition, from the viewpoints of suppressing sedimentation of the inorganic filler (C) in the first liquid and further improving the performance balance between the storage stability and the flowability of the first liquid, the content of the sedimentation inhibitor (D) in the first liquid is preferably 0.01% by mass or more and 2.00% by mass or less, more preferably 0.03% by mass or more and 2.00% by mass or less, still more preferably 0.05% by mass or more and 1.50% by mass or less, even more preferably 0.08% by mass or more and 1.00% by mass or less, even still more preferably 0.10% by mass or more and 0.80% by mass or less, further more preferably 0.13% by mass or more and 0.50% by mass or less, even further more preferably 0.15% by mass or more and 0.30% by mass or less, and particularly preferably 0.18% by mass or more and 0.25% by mass or less, when the total amount of the above-described first liquid is taken as 100% by mass.

When the total amount of the above-described second liquid is taken as 100% by mass, a content of the sedimentation inhibitor (D) in the second liquid according to the second embodiment is preferably 0.01% by mass or more, more preferably 0.03% by mass or more, still more preferably 0.05% by mass or more, and even more preferably 0.08% by mass or more, from the viewpoint of suppressing sedimentation of the inorganic filler (C) in the second liquid; and is preferably 2.00% by mass or less, more preferably 1.50% by mass or less, still more preferably 1.00% by mass or less, even more preferably 0.80% by mass or less, even still more preferably 0.50% by mass or less, further more preferably 0.30% by mass or less, even further more preferably 0.25% by mass or less, particularly preferably 0.20% by mass or less, and most preferably 0.15% by mass or less, from the viewpoint of further improving the performance balance between the storage stability and the flowability of the second liquid.

In addition, from the viewpoints of suppressing sedimentation of the inorganic filler (C) in the second liquid and further improving the performance balance between storage stability and flowability of the second liquid, the content of the sedimentation inhibitor (D) in the second liquid is preferably 0.01% by mass or more and 2.00% by mass or less, more preferably 0.01% by mass or more and 1.50% by mass or less, still more preferably 0.01% by mass or more and 1.00% by mass or less, even more preferably 0.01% by mass or more and 0.80% by mass or less, even still more preferably 0.01% by mass or more and 0.50% by mass or less, further more preferably 0.01% by mass or more and 0.30% by mass or less, even further more preferably 0.03% by mass or more and 0.25% by mass or less, particularly preferably 0.05% by mass or more and 0.20% by mass or less, and most preferably 0.08% by mass or more and 0.15% by mass or less, when the total amount of the above-described second liquid is taken as 100% by mass.

### (Curing accelerator (E))

The two-pack type liquid resin composition according to the second embodiment preferably further includes a curing accelerator (E) from the viewpoint of promoting the reaction between the epoxy resin (A) and the acid anhydride (B) to improve the curability of the two-pack type liquid resin composition.

It is preferable that the curing accelerator (E) in the second embodiment is included in the second liquid, from the viewpoint of further improving the performance balance between the storage stability and the flowability of the two-pack type liquid resin composition.

From the viewpoint of improving the curability of the two-pack type liquid resin composition, the curing accelerator (E) in the second embodiment preferably includes one or two or more selected from the group consisting of a tertiary amine, a quaternary ammonium salt, imidazoles, an organic phosphine, and a Lewis acid catalyst, and more preferably includes a quaternary ammonium salt.

The tertiary amine preferably includes one or two or more selected from the group consisting of trimethylamine, triethylamine, tripropylamine, tributylamine, and benzyldimethylamine.

The quaternary ammonium salt preferably includes one or two or more selected from the group consisting of organic acid salts of diazabicycloundecene, such as DBU [1,8-diazabicyclo[5.4.0]undec-7-ene] octylate (manufactured by San-Apro Ltd., trade name: SA102), DBN [1,5-diazabicyclo[4.3.0]non-5-ene], quaternary ammonium salts that are salts of tertiary amines and carboxylic acids (manufactured by San-Apro Ltd., trade name: U-CAT2313), octadecyltrimethylammonium chloride (manufactured by NOF CORPORATION, trade name: NISSAN CATION), and tetraalkylammonium salts (each alkyl group having 1 to 18 carbon atoms) (for example, tetraethylammonium bromide, tetrabutylammonium bromide, and tetraalkylammonium carboxylates (carboxylic acids having 1 to 12 carbon atoms)).

The curing accelerator (E) in the second embodiment more preferably includes an organic acid salt of diazabicycloundecene, from the viewpoint of improving the curability of the two-pack type liquid resin composition.

The imidazoles preferably include one or two or more selected from the group consisting of 1-benzyl-2-methylimidazole, 2-ethyl-4-methylimidazole, 2-undecylimidazole, 1,2-dimethylimidazole, and 1-benzyl-2-phenylimidazole.

The organic phosphine preferably includes one or two or more selected from the group consisting of triphenylphosphine, triphenylphosphine-triphenylborate, tris(p-methoxyphenyl)phosphine, and tetraphenylphosphonium tetraphenylborate.

The Lewis acid catalyst preferably includes one or two or more selected from the group consisting of boron trifluoride amine complex, boron trichloride amine complex, and boron trifluoride ethylamine complex.

When the total amount of the above-described two-pack type liquid resin composition is taken as 100% by mass, a content of the curing accelerator (E) in the two-pack type liquid resin composition according to the second embodiment is preferably 0.01% by mass or more, more preferably 0.05% by mass or more, still more preferably 0.10% by mass or more, even more preferably 0.15% by mass or more, and even still more preferably 0.20% by mass or more, from the viewpoint of improving the curability of the two-pack type liquid resin composition; and is preferably 1.00% by mass or less, more preferably 0.80% by mass or less, still more preferably 0.50% by mass or less, and even more preferably 0.30% by mass or less, from the viewpoint of further improving the performance balance between the storage stability and the flowability of the two-pack type liquid resin composition.

In addition, from the viewpoint of improving curability, storage stability, and flowability of the two-pack type liquid resin composition, the content of the curing accelerator (E) in the two-pack type liquid resin composition is preferably 0.01% by mass or more and 1.00% by mass or less, more preferably 0.05% by mass or more and 1.00% by mass or less, still more preferably 0.10% by mass or more and 0.80% by mass or less, even more preferably 0.15% by mass or more and 0.50% by mass or less, and even still more preferably 0.20% by mass or more and 0.30% by mass or less, when the total amount of the above-described two-pack type liquid resin composition is taken as 100% by mass.

### (Other components)

The two-pack type liquid resin composition according to the second embodiment may include a coupling agent, a colorant such as carbon black, an antifoaming agent such as a silicone antifoaming agent, a flame retardant, and the like as necessary.

From the viewpoint of improving an interfacial strength between the epoxy resin (A) and the inorganic filler (C), the coupling agent in the second embodiment preferably includes one or two or more selected from the group consisting of an epoxy silane coupling agent, an amino silane coupling agent, a ureido silane coupling agent, and a mercapto silane coupling agent, and more preferably includes an epoxy silane coupling agent.

The epoxy silane coupling agent preferably includes one or two or more selected from the group consisting of γ-glycidoxypropyltriethoxysilane, γ-glycidoxypropyltrimethoxysilane, γ-glycidoxypropylmethyldimethoxysilane, and β-(3,4-epoxycyclohexyl)ethyltrimethoxysilane, and more preferably includes γ-glycidoxypropyltrimethoxysilane.

The amino silane coupling agent preferably includes one or two or more selected from the group consisting of γ-aminopropyltriethoxysilane, γ-aminopropyltrimethoxysilane, N-β(aminoethyl)γ-aminopropyltrimethoxysilane, N-β(aminoethyl)γ-aminopropylmethyldimethoxysilane, N-phenyl-γ-aminopropyltriethoxysilane, N-phenyl-γ-aminopropyltrimethoxysilane, N-β(aminoethyl)γ-aminopropyltriethoxysilane, N-(6-aminohexyl)3-aminopropyltrimethoxysilane, and N-(3-(trimethoxysilylpropyl)-1,3-benzenedimethanamine.

The ureido silane coupling agent includes, for example, one or two or more selected from the group consisting of γ-ureidopropyltriethoxysilane and hexamethyldisilazane.

When the total amount of the above-described two-pack type liquid resin composition is taken as 100% by mass, a content of the coupling agent in the two-pack type liquid resin composition according to the second embodiment is preferably 0.01% by mass or more, more preferably 0.03% by mass or more, still more preferably 0.05% by mass or more, and even more preferably 0.08% by mass or more, from the viewpoint of improving the interfacial strength between the epoxy resin (A) and the inorganic filler (C); and is preferably 1.00% by mass or less, more preferably 0.80% by mass or less, still more preferably 0.60% by mass or less, even more preferably 0.40% by mass or less, and even still more preferably 0.20% by mass or less.

In addition, from the viewpoint of improving the interfacial strength between the epoxy resin (A) and the inorganic filler (C), the content of the coupling agent in the two-pack type liquid resin composition is preferably 0.01% by mass or more and 1.00% by mass or less, more preferably 0.01% by mass or more and 0.80% by mass or less, still more preferably 0.03% by mass or more and 0.60% by mass or less, even more preferably 0.05% by mass or more and 0.40% by mass or less, and even still more preferably 0.08% by mass or more and 0.20% by mass or less, when the total amount of the above-described two-pack type liquid resin composition is taken as 100% by mass.

The colorant in the second embodiment preferably includes one or two or more selected from the group consisting of carbon black, titanium oxide, barium sulfate, iron black, red iron oxide, aniline black, and alizarin, and more preferably includes carbon black.

When the total amount of the above-described two-pack type liquid resin composition is taken as 100% by mass, a content of the colorant in the two-pack type liquid resin composition according to the second embodiment is preferably 0.01% by mass or more, more preferably 0.02% by mass or more, still more preferably 0.03% by mass or more, even more preferably 0.04% by mass or more, and even still more preferably 0.05% by mass or more; and is preferably 0.50% by mass or less, more preferably 0.40% by mass or less, still more preferably 0.30% by mass or less, even more preferably 0.20% by mass or less, and even still more preferably 0.10% by mass or less.

In addition, the content of the colorant in the two-pack type liquid resin composition is preferably 0.01% by mass or more and 0.50% by mass or less, more preferably 0.02% by mass or more and 0.40% by mass or less, still more preferably 0.03% by mass or more and 0.30% by mass or less, even more preferably 0.04% by mass or more and 0.20% by mass or less, and even still more preferably 0.05% by mass or more and 0.10% by mass or less, when the total amount of the above-described two-pack type liquid resin composition is taken as 100% by mass.

The antifoaming agent in the second embodiment preferably includes one or two or more selected from the group consisting of a silicone-based antifoaming agent, a fluorine-based antifoaming agent, and a polymer-based antifoaming agent, and more preferably includes a silicone-based antifoaming agent.

When the total amount of the above-described two-pack type liquid resin composition is taken as 100% by mass, a content of the antifoaming agent in the two-pack type liquid resin composition according to the second embodiment is preferably 0.01% by mass or more, more preferably 0.03% by mass or more, still more preferably 0.05% by mass or more, and even more preferably 0.08% by mass or more; and is preferably 1.00% by mass or less, more preferably 0.80% by mass or less, still more preferably 0.60% by mass or less, even more preferably 0.40% by mass or less, and even still more preferably 0.20% by mass or less.

In addition, the content of the antifoaming agent in the two-pack type liquid resin composition is preferably 0.01% by mass or more and 1.00% by mass or less, more preferably 0.01% by mass or more and 0.80% by mass or less, still more preferably 0.03% by mass or more and 0.60% by mass or less, even more preferably 0.05% by mass or more and 0.40% by mass or less, and even still more preferably 0.08% by mass or more and 0.20% by mass or less, when the total amount of the two-pack type liquid resin composition is taken as 100% by mass.

The flame retardant in the second embodiment preferably includes one or two or more selected from the group consisting of aluminum hydroxide, magnesium hydroxide, zinc borate, zinc molybdate, antimony trioxide, antimony pentoxide, phosphazene, brominated epoxy resin, and brominated polycarbonate, from the viewpoint of further improving flame retardancy of the cured product of the two-pack type liquid resin composition.

From the viewpoint of further improving the flame retardancy of the cured product of the two-pack type liquid resin composition, a content of the flame retardant in the two-pack type liquid resin composition according to the second embodiment is preferably 1.0% by mass or more and 50% by mass or less, and more preferably 5.0% by mass or more and 30% by mass or less, when the total amount of the above-described two-pack type liquid resin composition is taken as 100% by mass.

### (Method for producing two-pack type liquid resin composition)

A method for producing the two-pack type liquid resin composition according to the second embodiment will be described in detail.

The two-pack type liquid resin composition according to the second embodiment can be produced by sufficiently mixing and stirring, as a first liquid, the epoxy resin (A), the inorganic filler (C), the sedimentation inhibitor (D), and other components, and sufficiently mixing and stirring, as a second liquid, the acid anhydride (B), the inorganic filler (C), the sedimentation inhibitor (D), and other components, among the above-described components, by a known method.

When the two-pack type liquid resin composition according to the second embodiment includes a curing accelerator (E), it is preferable that the second liquid includes the curing accelerator (E).

Examples of a method of mixing and stirring each component to obtain the first liquid or the second liquid in the two-pack type liquid resin composition according to the second embodiment include a method using a mixing machine such as a mixer, and a method using a kneading machine such as a roll and a kneader.

The two-pack type liquid resin composition according to the second embodiment is used in a state of a mixed liquid obtained by mixing the first liquid and the second liquid. Examples of a method of mixing the first liquid and the second liquid include a method using a mixing machine such as a mixer, and a method using a kneading machine such as a roll and a kneader.

In the two-pack type liquid resin composition according to the second embodiment, when the amount of the above-described first liquid is taken as 100 parts by mass, a content of the second liquid when further mixing the first liquid and the second liquid is preferably 50 parts by mass or more, more preferably 70 parts by mass or more, and still more preferably 90 parts by mass or more, from the viewpoint of further improving the performance balance of flowability, heat resistance during curing, and mechanical properties of the two-pack type liquid resin composition; and is preferably 150 parts by mass or less, more preferably 130 parts by mass or less, and still more preferably 110 parts by mass or less.

In addition, from the viewpoint of further improving the performance balance of flowability, heat resistance during curing, and mechanical properties of the two-pack type liquid resin composition, the content of the second liquid when further mixing the first liquid and the second liquid is preferably 50 parts by mass or more and 150 parts by mass or less, more preferably 70 parts by mass or more and 130 parts by mass or less, and still more preferably 90 parts by mass or more and 110 parts by mass or less, when the amount of the above-described first liquid is taken as 100 parts by mass.

### <Third embodiment>

### [Two-pack type liquid resin composition]

The two-pack type liquid resin composition according to the third embodiment is a two-pack type liquid resin composition including a first liquid and a second liquid, in which the first liquid includes an epoxy resin (A), an inorganic filler (C), and a sedimentation inhibitor (D), the second liquid includes an acid anhydride (B), an inorganic filler (C), and a sedimentation inhibitor (D), and a viscosity η_{5A} of the first liquid, measured under conditions of a rotational speed of 5 rpm and a temperature of 60°C using an E-type viscometer and a 3°×R14 cone rotor, is 1.0 Pa·s or more and 15.0 Pa·s or less.

The two-pack type liquid resin composition according to the third embodiment can improve the performance balance between storage stability and flowability by satisfying the above-described configuration.

In the two-pack type liquid resin composition according to the third embodiment, when the viscosity η_{5A} at 60°C of the first liquid in the two-pack type liquid resin composition is within the above-described numerical range, the flowability of the first liquid under quiescent conditions becomes suitable from the viewpoint of storage stability, and thus sedimentation of the inorganic filler (C) in the first liquid is considered to be physically suppressed. As a result, the two-pack type liquid resin composition according to the third embodiment is considered capable of improving the performance balance between storage stability in the first-liquid and second-liquid states and flowability suitable for workability in casting.

In the two-pack type liquid resin composition according to the third embodiment, from the viewpoint of further improving the performance balance between the storage stability and the flowability of the two-pack type liquid resin composition, the above-described viscosity η_{5A} is preferably 1.2 Pa·s or more, more preferably 1.4 Pa·s or more, still more preferably 1.6 Pa·s or more, even more preferably 1.8 Pa·s or more, and even still more preferably 1.9 Pa·s or more; and is preferably 14.0 Pa·s or less, more preferably 12.0 Pa·s or less, still more preferably 10.0 Pa·s or less, even more preferably 8.0 Pa·s or less, even still more preferably 6.0 Pa·s or less, and further more preferably 4.0 Pa·s or less.

In addition, from the viewpoint of further improving the performance balance between the storage stability and the flowability of the two-pack type liquid resin composition, the viscosity η_{5A} of the two-pack type liquid resin composition according to the third embodiment is preferably 1.2 Pa·s or more and 14.0 Pa·s or less, more preferably 1.2 Pa·s or more and 12.0 Pa·s or less, still more preferably 1.4 Pa·s or more and 10.0 Pa·s or less, even more preferably 1.6 Pa·s or more and 8.0 Pa·s or less, even still more preferably 1.8 Pa·s or more and 6.0 Pa·s or less, and further more preferably 1.9 Pa·s or more and 4.0 Pa·s or less.

The above-described viscosity η_{5A} of the two-pack type liquid resin composition according to the third embodiment refers to a viscosity one minute after rotation of the cone rotor set in the E-type viscometer starts.

In the two-pack type liquid resin composition according to the third embodiment, from the viewpoint of further improving the performance balance between the storage stability and the flowability of the two-pack type liquid resin composition, a viscosity η_{10A} of the above-described first liquid, measured under conditions of a rotational speed of 10 rpm and a temperature of 60°C using an E-type viscometer and a 3°×R14 cone rotor, is preferably 1.0 Pa·s or more, more preferably 1.2 Pa·s or more, still more preferably 1.4 Pa·s or more, even more preferably 1.6 Pa·s or more, even still more preferably 1.7 Pa·s or more, and further more preferably 1.8 Pa·s or more; and is preferably 15.0 Pa·s or less, more preferably 14.0 Pa·s or less, and still more preferably 13.0 Pa·s or less.

In addition, from the viewpoint of further improving the performance balance between the storage stability and the flowability of the two-pack type liquid resin composition, the viscosity η_{10A} of the two-pack type liquid resin composition according to the third embodiment is preferably 1.0 Pa·s or more and 15.0 Pa·s or less, more preferably 1.2 Pa·s or more and 15.0 Pa·s or less, still more preferably 1.4 Pa·s or more and 15.0 Pa·s or less, even more preferably 1.6 Pa·s or more and 15.0 Pa·s or less, even still more preferably 1.7 Pa·s or more and 14.0 Pa·s or less, and further more preferably 1.8 Pa·s or more and 13.0 Pa·s or less.

The above-described viscosity η_{10A} of the two-pack type liquid resin composition according to the third embodiment refers to a viscosity one minute after rotation of the cone rotor set in the E-type viscometer starts.

In the two-pack type liquid resin composition according to the third embodiment, from the viewpoint of further improving the performance balance between the storage stability and the flowability of the two-pack type liquid resin composition, a viscosity ratio Ti_{A} (η_{5A}/η_{10A}) of the above-described viscosity η_{5A} to the above-described viscosity η_{10A} is preferably 0.1 or more, more preferably 0.3 or more, still more preferably 0.5 or more, and even more preferably 0.8 or more; and is preferably 1.5 or less, more preferably 1.3 or less, and still more preferably 1.1 or less.

In addition, from the viewpoint of further improving the performance balance between the storage stability and the flowability of the two-pack type liquid resin composition, the viscosity ratio Ti_{A} (η_{5A}/η_{10A}) of the two-pack type liquid resin composition according to the third embodiment is preferably 0.1 or more and 1.5 or less, more preferably 0.3 or more and 1.5 or less, still more preferably 0.5 or more and 1.3 or less, and even more preferably 0.8 or more and 1.1 or less.

In the two-pack type liquid resin composition according to the third embodiment, from the viewpoint of further improving the performance balance between the storage stability and the flowability of the two-pack type liquid resin composition, a viscosity η_{5B} of the above-described second liquid, measured under conditions of a rotational speed of 5 rpm and a temperature of 25°C using an E-type viscometer and a 3°×R14 cone rotor, is preferably 1.0 Pa·s or more, more preferably 5.0 Pa·s or more, still more preferably 10.0 Pa·s or more, even more preferably 15.0 Pa·s or more, and even still more preferably 20.0 Pa·s or more; and is preferably 50.0 Pa·s or less, more preferably 45.0 Pa·s or less, still more preferably 40.0 Pa·s or less, even more preferably 35.0 Pa·s or less, even still more preferably 30.0 Pa·s or less, and further more preferably 25.0 Pa·s or less.

In addition, from the viewpoint of further improving the performance balance between the storage stability and the flowability of the two-pack type liquid resin composition, the viscosity η_{5B} of the two-pack type liquid resin composition according to the third embodiment is preferably 1.0 Pa·s or more and 50.0 Pa·s or less, more preferably 1.0 Pa·s or more and 45.0 Pa·s or less, still more preferably 5.0 Pa·s or more and 40.0 Pa·s or less, even more preferably 10.0 Pa·s or more and 35.0 Pa·s or less, even still more preferably 15.0 Pa·s or more and 30.0 Pa·s or less, and further more preferably 20.0 Pa·s or more and 25.0 Pa·s or less.

The above-described viscosity η_{5B} of the two-pack type liquid resin composition according to the third embodiment refers to a viscosity one minute after rotation of the cone rotor set in the E-type viscometer starts.

In the two-pack type liquid resin composition according to the third embodiment, from the viewpoint of further improving the performance balance between the storage stability and the flowability of the two-pack type liquid resin composition, a viscosity η_{10B} of the above-described second liquid, measured under conditions of a rotational speed of 10 rpm and a temperature of 25°C using an E-type viscometer and a 3°×R14 cone rotor, is preferably 1.0 Pa·s or more, more preferably 3.0 Pa·s or more, still more preferably 5.0 Pa·s or more, even more preferably 10.0 Pa·s or more, and even still more preferably 15.0 Pa·s or more; and is preferably 50.0 Pa·s or less, more preferably 45.0 Pa·s or less, still more preferably 40.0 Pa·s or less, even more preferably 35.0 Pa·s or less, even still more preferably 30.0 Pa·s or less, further more preferably 25.0 Pa·s or less, and even further more preferably 20.0 Pa·s or less.

In addition, from the viewpoint of further improving the performance balance between the storage stability and the flowability of the two-pack type liquid resin composition, the viscosity η_{10B} of the two-pack type liquid resin composition according to the third embodiment is preferably 1.0 Pa·s or more and 50.0 Pa·s or less, more preferably 1.0 Pa·s or more and 45.0 Pa·s or less, still more preferably 1.0 Pa·s or more and 40.0 Pa·s or less, even more preferably 3.0 Pa·s or more and 35.0 Pa·s or less, even still more preferably 5.0 Pa·s or more and 30.0 Pa·s or less, further more preferably 10.0 Pa·s or more and 25.0 Pa·s or less, and even further more preferably 15.0 Pa·s or more and 20.0 Pa·s or less.

The above-described viscosity η_{10B} of the two-pack type liquid resin composition according to the third embodiment refers to a viscosity one minute after rotation of the cone rotor set in the E-type viscometer starts.

In the two-pack type liquid resin composition according to the third embodiment, from the viewpoint of further improving the performance balance between the storage stability and the flowability of the two-pack type liquid resin composition, a viscosity ratio Ti_{B} (η_{5B}/η_{10B}) of the above-described viscosity η_{5B} to the above-described viscosity η_{10B} is preferably 0.5 or more, more preferably 0.8 or more, and still more preferably 1.0 or more; and is preferably 2.5 or less, more preferably 2.2 or less, still more preferably 2.0 or less, even more preferably 1.7 or less, even still more preferably 1.5 or less, and further more preferably 1.3 or less.

In addition, from the viewpoint of further improving the performance balance between the storage stability and the flowability of the two-pack type liquid resin composition, the viscosity ratio Ti_{B} (η_{5B}/η_{10B}) of the two-pack type liquid resin composition according to the third embodiment is preferably 0.5 or more and 2.5 or less, more preferably 0.5 or more and 2.2 or less, still more preferably 0.5 or more and 2.0 or less, even more preferably 0.5 or more and 1.7 or less, even still more preferably 0.8 or more and 1.5 or less, and further more preferably 1.0 or more and 1.3 or less.

In the two-pack type liquid resin composition according to the third embodiment, from the viewpoint of further improving the performance balance between the storage stability and the flowability of the two-pack type liquid resin composition, a viscosity η_{5P} of a mixed liquid of the above-described first liquid and the above-described second liquid, measured under conditions of a rotational speed of 5 rpm and a temperature of 60°C using an E-type viscometer and a 3°×R14 cone rotor, is preferably 1.0 Pa·s or more, more preferably 1.5 Pa·s or more, still more preferably 2.0 Pa·s or more, even more preferably 2.5 Pa·s or more, even still more preferably 3.0 Pa·s or more, and further more preferably 3.5 Pa·s or more; and is preferably 30.0 Pa·s or less, more preferably 25.0 Pa·s or less, still more preferably 20.0 Pa·s or less, even more preferably 15.0 Pa·s or less, and even still more preferably 10.0 Pa·s or less.

In addition, from the viewpoint of further improving the performance balance between the storage stability and the flowability of the two-pack type liquid resin composition, the viscosity η_{5P} of the two-pack type liquid resin composition according to the third embodiment is preferably 1.0 Pa·s or more and 30.0 Pa·s or less, more preferably 1.5 Pa·s or more and 30.0 Pa·s or less, still more preferably 2.0 Pa·s or more and 25.0 Pa·s or less, even more preferably 2.5 Pa·s or more and 20.0 Pa·s or less, even still more preferably 3.0 Pa·s or more and 15.0 Pa·s or less, and further more preferably 3.5 Pa·s or more and 10.0 Pa·s or less.

The above-described viscosity η_{5P} of the two-pack type liquid resin composition according to the third embodiment refers to a viscosity one minute after rotation of the cone rotor set in the E-type viscometer starts.

In the two-pack type liquid resin composition according to the third embodiment, from the viewpoint of further improving the performance balance between the storage stability and the flowability of the two-pack type liquid resin composition, a viscosity η_{10P} of the mixed liquid of the above-described first liquid and the above-described second liquid, measured under conditions of a rotational speed of 10 rpm and a temperature of 60°C using an E-type viscometer and a 3°×R14 cone rotor, is preferably 1.0 Pa·s or more, more preferably 1.5 Pa·s or more, still more preferably 2.0 Pa·s or more, even more preferably 2.5 Pa·s or more, and even still more preferably 3.0 Pa·s or more; and is preferably 30.0 Pa·s or less, more preferably 25.0 Pa·s or less, still more preferably 20.0 Pa·s or less, even more preferably 15.0 Pa·s or less, even still more preferably 10.0 Pa·s or less, and further more preferably 5.0 Pa·s or less.

In addition, from the viewpoint of further improving the performance balance between the storage stability and the flowability of the two-pack type liquid resin composition, the viscosity η_{10P} of the two-pack type liquid resin composition according to the third embodiment is preferably 1.0 Pa·s or more and 30.0 Pa·s or less, more preferably 1.0 Pa·s or more and 25.0 Pa·s or less, still more preferably 1.5 Pa·s or more and 20.0 Pa·s or less, even more preferably 2.0 Pa·s or more and 15.0 Pa·s or less, even still more preferably 2.5 Pa·s or more and 10.0 Pa·s or less, and further more preferably 3.0 Pa·s or more and 5.0 Pa·s or less.

The above-described viscosity η_{10P} of the two-pack type liquid resin composition according to the third embodiment refers to a viscosity one minute after rotation of the cone rotor set in the E-type viscometer starts.

In the two-pack type liquid resin composition according to the third embodiment, from the viewpoint of further improving the performance balance between the storage stability and the flowability of the two-pack type liquid resin composition, a viscosity ratio Ti_{P} (η_{5P}/η_{10P}) of the above-described viscosity η_{5P} to the above-described viscosity η_{10P} is preferably 0.5 or more, more preferably 0.6 or more, still more preferably 0.7 or more, even more preferably 0.8 or more, even still more preferably 0.9 or more, further more preferably 1.0 or more, and even further more preferably 1.1 or more; and is preferably 2.0 or less, more preferably 1.9 or less, still more preferably 1.8 or less, even more preferably 1.7 or less, even still more preferably 1.6 or less, further more preferably 1.5 or less, even further more preferably 1.4 or less, and particularly preferably 1.3 or less.

In addition, from the viewpoint of further improving the performance balance between the storage stability and the flowability of the two-pack type liquid resin composition, the viscosity ratio Ti_{P} (η_{5P}/η_{10P}) of the two-pack type liquid resin composition according to the third embodiment is preferably 0.5 or more and 2.0 or less, more preferably 0.5 or more and 1.9 or less, still more preferably 0.6 or more and 1.8 or less, even more preferably 0.7 or more and 1.7 or less, even still more preferably 0.8 or more and 1.6 or less, further more preferably 0.9 or more and 1.5 or less, even further more preferably 1.0 or more and 1.4 or less, and particularly preferably 1.1 or more and 1.3 or less.

Hereinafter, components used in the resin composition according to the third embodiment will be described in detail.

### (Epoxy resin (A))

The two-pack type liquid resin composition according to the third embodiment includes an epoxy resin (A). As the epoxy resin in the third embodiment, from the viewpoint of further improving the performance balance of strength, hardness, elastic modulus, coefficient of thermal expansion, thermal conductivity, heat dissipation, and electrical properties of a cured product of the two-pack type liquid resin composition, the epoxy resin preferably includes one or two or more selected from the group consisting of alicyclic epoxy resins; bisphenol-type epoxy resins such as bisphenol A-type epoxy resin, bisphenol F-type epoxy resin, bisphenol E-type epoxy resin, bisphenol S-type epoxy resin, bisphenol M-type epoxy resin (4,4'-(1,3-phenylenediisopropylidene)bisphenol-type epoxy resin), bisphenol P-type epoxy resin (4,4'-(1,4-phenylenediisopropylidene)bisphenol-type epoxy resin), and bisphenol Z-type epoxy resin (4,4'-cyclohexylidenebisphenol-type epoxy resin); novolac-type epoxy resins such as phenol novolac-type epoxy resin, cresol novolac-type epoxy resin, trisphenolmethane-type novolac-type epoxy resin, tetraphenolethane-type novolac-type epoxy resin, and novolac-type epoxy resin having a condensed polycyclic aromatic hydrocarbon structure; aromatic glycidylamine-type epoxy resins such as N,N-diglycidylaniline, N,N-diglycidyltoluidine, diaminodiphenylmethane-type glycidylamine, and aminophenol-type glycidylamine; aminophenol-type epoxy resins; biphenyl-type epoxy resins; arylalkylene-type epoxy resins such as xylylenetype epoxy resin and biphenyl aralkyl-type epoxy resin; naphthalene-type epoxy resins such as naphthylene ether-type epoxy resin, naphthol-type epoxy resin, naphthalenediol-type epoxy resin, bifunctional to tetrafunctional epoxy-type naphthalene resin, binaphthyl-type epoxy resin, and naphthalene aralkyl-type epoxy resin; anthracene-type epoxy resins; phenoxytype epoxy resins; dicyclopentadiene-type epoxy resins; norbornene-type epoxy resins; adamantane-type epoxy resins; and fluorene-type epoxy resins; more preferably includes one or two or more selected from the group consisting of alicyclic epoxy resins, bisphenol A-type epoxy resins, bisphenol F-type epoxy resins, and aminophenol-type epoxy resins; and still more preferably includes one or two or more selected from the group consisting of alicyclic epoxy resins, bisphenol A-type epoxy resins, and bisphenol F-type epoxy resins. From the viewpoint of further improving the performance balance of low viscosity and flowability of the two-pack type liquid resin composition, the epoxy resin even more preferably includes an alicyclic epoxy resin.

In the third embodiment, the alicyclic epoxy resin preferably includes an alicyclic epoxy resin that is liquid at 25°C, more preferably includes one or two or more selected from the group consisting of epoxy-[epoxy-oxaspiro-C₈₋₁₅alkyl]-cyclo-C₅₋₁₂alkanes such as vinylcyclopentadiene dioxide, vinylcyclohexene monoxide, vinylcyclohexene dioxide, dicyclopentadiene oxide, and 3,4-epoxy-1-[8,9-epoxy-2,4-dioxaspiro[5.5]undecan-3-yl]-cyclohexane; epoxy-C₅₋₁₂cycloalkyl-C₁₋₃alkyl-epoxy-C₅₋₁₂cycloalkane carboxylates such as 3,4-epoxycyclohexylmethyl-3',4'-epoxycyclohexane carboxylate and 4,5-epoxycyclooctylmethyl-4',5'-epoxycyclooctane carboxylate; and bis(C₁₋₃alkyl epoxy-C₅₋₁₂cycloalkyl-C₁₋₃alkyl) dicarboxylates such as bis(2-methyl-3,4-epoxycyclohexylmethyl) adipate, still more preferably includes an epoxy-C₅₋₁₂cycloalkyl-C₁₋₃alkyl-epoxy-C₅₋₁₂cycloalkane carboxylate, and even more preferably includes 3,4-epoxycyclohexylmethyl-3',4'-epoxycyclohexane carboxylate.

Examples of a commercially available product of the 3,4-epoxycyclohexylmethyl-3',4'-epoxycyclohexane carboxylate include Celloxide #2021P (epoxy equivalent: 128 to 140) manufactured by Daicel Corporation, which is preferably used.

When the epoxy resin (A) in the third embodiment includes an alicyclic epoxy resin, from the viewpoint of further improving the flowability of the two-pack type liquid resin composition, a content of the alicyclic epoxy resin in the epoxy resin (A) is preferably 50 parts by mass or more, more preferably 60 parts by mass or more, still more preferably 70 parts by mass or more, even more preferably 80 parts by mass or more, even still more preferably 90 parts by mass or more, and further more preferably 95 parts by mass or more, when the content of the epoxy resin (A) is taken as 100 parts by mass; and the upper limit value thereof is not particularly limited, but may be, for example, 100 parts by mass or less. In addition, from the viewpoint of further improving the flowability of the two-pack type liquid resin composition, the content of the alicyclic epoxy resin in the epoxy resin (A) is preferably 50 parts by mass or more and 100 parts by mass or less, more preferably 60 parts by mass or more and 100 parts by mass or less, still more preferably 70 parts by mass or more and 100 parts by mass or less, even more preferably 80 parts by mass or more and 100 parts by mass or less, even still more preferably 90 parts by mass or more and 100 parts by mass or less, and further more preferably 95 parts by mass or more and 100 parts by mass or less, when the content of the epoxy resin (A) is taken as 100 parts by mass.

When the total amount of the above-described two-pack type liquid resin composition is taken as 100% by mass, the content of the epoxy resin (A) in the two-pack type liquid resin composition according to the third embodiment is preferably 3% by mass or more, more preferably 4% by mass or more, still more preferably 3% by mass or more, even more preferably 5% by mass or more, and even still more preferably 6% by mass or more, from the viewpoint of further improving the performance balance of strength, hardness, elastic modulus, coefficient of thermal expansion, thermal conductivity, heat dissipation, and electrical properties of a cured product of the two-pack type liquid resin composition; and is preferably 30% by mass or less, more preferably 28% by mass or less, still more preferably 25% by mass or less, even more preferably 23% by mass or less, even still more preferably 20% by mass or less, further more preferably 18% by mass or less, even further more preferably 15% by mass or less, and particularly preferably 13% by mass or less, from the viewpoint of further improving the performance balance between the storage stability and the flowability of the two-pack type liquid resin composition.

In addition, from the viewpoint of further improving the performance balance of storage stability, flowability, strength, hardness, elastic modulus, coefficient of thermal expansion, thermal conductivity, heat dissipation, and electrical properties of the cured product of the two-pack type liquid resin composition, the content of the epoxy resin (A) in the two-pack type liquid resin composition is preferably 3% by mass or more and 30% by mass or less, more preferably 3% by mass or more and 28% by mass or less, still more preferably 3% by mass or more and 25% by mass or less, even more preferably 3% by mass or more and 23% by mass or less, even still more preferably 4% by mass or more and 20% by mass or less, further more preferably 3% by mass or more and 18% by mass or less, even further more preferably 5% by mass or more and 15% by mass or less, and particularly preferably 6% by mass or more and 13% by mass or less, when the total amount of the above-described two-pack type liquid resin composition is taken as 100% by mass.

### (Acid anhydride (B))

The two-pack type liquid resin composition according to the third embodiment includes an acid anhydride (B). The acid anhydride (B) functions as a curing agent for the epoxy resin (A).

As the acid anhydride (B) in the third embodiment, from the viewpoint of improving curability of the two-pack type liquid resin composition, the acid anhydride preferably includes one or two or more selected from the group consisting of dodecenyl succinic acid anhydride, polyadipic acid anhydride, polyazelaic acid anhydride, polysebacic acid anhydride, poly(ethyloctadecanedioic) acid anhydride, poly(phenylhexadecanedioic) acid anhydride, methyltetrahydrophthalic acid anhydride, methylhexahydrophthalic acid anhydride, hexahydrophthalic acid anhydride, methylhymic acid anhydride, tetrahydrophthalic acid anhydride, trialkyltetrahydrophthalic acid anhydride, methylcyclohexenedicarboxylic acid anhydride, phthalic acid anhydride, trimellitic acid anhydride, pyromellitic acid anhydride, benzophenonetetracarboxylic acid anhydride, ethylene glycol bistrimellitate, HET acid anhydride, tetrahydrophthalic acid anhydride, methylnadic acid anhydride (methyl-5-norbornene-2,3-dicarboxylic acid anhydride), methylhymic acid anhydride (methyl-3,6-endomethylene-1,2,3,6-tetrahydrophthalic acid anhydride), methylcyclohexane-1,2-dicarboxylic acid anhydride, and 5-(2,5-dioxotetrahydro-3-furanyl)-3-methyl-3-cyclohexane-1,2-dicarboxylic acid anhydride. From the viewpoint of further improving the performance balance between the storage stability and the flowability of the two-pack type liquid resin composition, the acid anhydride more preferably includes one or two or more selected from the group consisting of methyl-5-norbornene-2,3-dicarboxylic acid anhydride, methylcyclohexane-1,2-dicarboxylic acid anhydride, and methyltetrahydrophthalic acid anhydride, and still more preferably includes methyl-5-norbornene-2,3-dicarboxylic acid anhydride.

When the total amount of the above-described two-pack type liquid resin composition is taken as 100% by mass, a content of the acid anhydride (B) in the two-pack type liquid resin composition according to the third embodiment is preferably 5% by mass or more, more preferably 7% by mass or more, still more preferably 9% by mass or more, and even more preferably 10% by mass or more, from the viewpoint of improving the curability of the two-pack type liquid resin composition; and is preferably 20% by mass or less, more preferably 18% by mass or less, still more preferably 16% by mass or less, and even more preferably 14% by mass or less, from the viewpoint of further improving the performance balance between the storage stability and the flowability of the two-pack type liquid resin composition.

In addition, from the viewpoint of improving the performance balance of storage stability, flowability, and curability of the two-pack type liquid resin composition, the content of the acid anhydride (B) in the two-pack type liquid resin composition is preferably 5% by mass or more and 20% by mass or less, more preferably 7% by mass or more and 18% by mass or less, still more preferably 9% by mass or more and 16% by mass or less, and even more preferably 10% by mass or more and 14% by mass or less, when the total amount of the above-described two-pack type liquid resin composition is taken as 100% by mass.

### (Inorganic filler (C))

The two-pack type liquid resin composition according to the third embodiment includes an inorganic filler (C). The inorganic filler (C) preferably includes one or two or more selected from the group consisting of silica, alumina, zircon, iron oxide, zinc oxide, titanium oxide, silicon nitride, boron nitride, aluminum nitride, silicon carbide, glass fiber, glass flake, alumina fiber, carbon fiber, black lead, carbon black, ferrite, graphite, aluminum hydroxide, magnesium hydroxide, calcium carbonate, manganese carbonate, magnesium carbonate, barium sulfate, potassium titanate, calcium silicate, inorganic balloons, and silver powder, from the viewpoint of further improving the performance balance of strength, hardness, elastic modulus, coefficient of thermal expansion, thermal conductivity, heat dissipation, and electrical properties of the cured product of the two-pack type liquid resin composition. From the viewpoint of further improving the performance balance between storage stability and flowability of the two-pack type liquid resin composition, the inorganic filler (C) more preferably includes one or two or more selected from the group consisting of silica, alumina, aluminum hydroxide, and calcium carbonate. In addition, the inorganic filler may be subjected to surface treatment. Examples of the surface treatment include alkylation treatment, trimethylsilylation treatment, silicone treatment, and treatment with a silane coupling agent, but the surface treatment is not particularly limited thereto.

A shape of the inorganic filler (C) in the third embodiment is preferably fibrous, amorphous, or spherical from the viewpoint of further improving the performance balance of strength, hardness, elastic modulus, coefficient of thermal expansion, thermal conductivity, heat dissipation, and electrical properties of the cured product of the two-pack type liquid resin composition; and is more preferably spherical from the viewpoint of further improving the performance balance between storage stability and flowability of the two-pack type liquid resin composition.

As used herein, "spherical" may be a true sphere, an ellipsoid, or a substantially spherical shape including an egg shape and the like. The inorganic filler (C) in the third embodiment preferably has an aspect ratio (ratio of major axis to minor axis) of 1.3 or less, more preferably 1.2 or less, and still more preferably 1.1 or less.

From the viewpoint of further improving the performance balance between the storage stability and the flowability of the two-pack type liquid resin composition, an average particle diameter D₅₀ of the inorganic filler (C) in the third embodiment, at which a cumulative value reaches 50% in a volume-based particle size distribution measured by a laser diffraction scattering method, is preferably 0.5 µm or more, more preferably 1.0 µm or more, still more preferably 3.0 µm or more, even more preferably 5.0 µm or more, even still more preferably 7.0 µm or more, further more preferably 10.0 µm or more, even further more preferably 12.0 µm or more, particularly preferably 15.0 µm or more, more particularly preferably 17.0 µm or more, and most preferably 20.0 µm or more; and is preferably 100.0 µm or less, more preferably 90.0 µm or less, still more preferably 80.0 µm or less, even more preferably 70.0 µm or less, even still more preferably 60.0 µm or less, further more preferably 50.0 µm or less, even further more preferably 40.0 µm or less, and particularly preferably 30.0 µm or less.

In addition, from the viewpoint of further improving the performance balance between the storage stability and the flowability of the two-pack type liquid resin composition, the average particle diameter D₅₀ is preferably 0.5 µm or more and 100.0 µm or less, more preferably 1.0 µm or more and 100.0 µm or less, still more preferably 3.0 µm or more and 100.0 µm or less, even more preferably 5.0 µm or more and 90.0 µm or less, even still more preferably 7.0 µm or more and 80.0 µm or less, further more preferably 10.0 µm or more and 70.0 µm or less, even further more preferably 12.0 µm or more and 60.0 µm or less, particularly preferably 15.0 µm or more and 50.0 µm or less, more particularly preferably 17.0 µm or more and 40.0 µm or less, and most preferably 20.0 µm or more and 30.0 µm or less.

The inorganic filler (C) in the third embodiment may include inorganic fillers having two or more different average particle diameters D₅₀ within the above-described range of the average particle diameter D₅₀.

The average particle diameter D₅₀ of the inorganic filler (C) in the third embodiment can be measured by, for example, a laser diffraction scattering measurement method using a laser diffraction particle size distribution analyzer (for example, SALD-7000 manufactured by Shimadzu Corporation).

When the total amount of the above-described two-pack type liquid resin composition is taken as 100% by mass, a content of the inorganic filler (C) in the two-pack type liquid resin composition according to the third embodiment is preferably 65% by mass or more, more preferably 67% by mass or more, still more preferably 69% by mass or more, even more preferably 71% by mass or more, even still more preferably 73% by mass or more, and further more preferably 75% by mass or more, from the viewpoint of further improving the performance balance between the storage stability and the flowability of the two-pack type liquid resin composition; and is preferably 85% by mass or less, more preferably 84% by mass or less, still more preferably 83% by mass or less, and even more preferably 82% by mass or less.

In addition, from the viewpoint of further improving the performance balance between the storage stability and the flowability of the two-pack type liquid resin composition, the content of the inorganic filler (C) in the two-pack type liquid resin composition is preferably 65% by mass or more and 85% by mass or less, more preferably 67% by mass or more and 85% by mass or less, still more preferably 69% by mass or more and 85% by mass or less, even more preferably 71% by mass or more and 84% by mass or less, even still more preferably 73% by mass or more and 83% by mass or less, and further more preferably 75% by mass or more and 82% by mass or less, when the total amount of the above-described two-pack type liquid resin composition is taken as 100% by mass.

When the total amount of the above-described first liquid is taken as 100% by mass, a content of the inorganic filler (C) in the first liquid according to the third embodiment is preferably 65% by mass or more, more preferably 67% by mass or more, still more preferably 69% by mass or more, even more preferably 71% by mass or more, even still more preferably 73% by mass or more, further more preferably 75% by mass or more, and even further more preferably 77% by mass or more, from the viewpoint of further improving the performance balance between storage stability and flowability of the first liquid; and is preferably 95% by mass or less, more preferably 93% by mass or less, still more preferably 91% by mass or less, and even more preferably 88% by mass or less.

In addition, from the viewpoint of further improving the performance balance between the storage stability and the flowability of the first liquid, the content of the inorganic filler (C) in the first liquid is preferably 65% by mass or more and 95% by mass or less, more preferably 67% by mass or more and 95% by mass or less, still more preferably 69% by mass or more and 95% by mass or less, even more preferably 71% by mass or more and 95% by mass or less, even still more preferably 73% by mass or more and 93% by mass or less, further more preferably 75% by mass or more and 91% by mass or less, and even further more preferably 77% by mass or more and 88% by mass or less, when the total amount of the above-described first liquid is taken as 100% by mass.

When the total amount of the above-described second liquid is taken as 100% by mass, a content of the inorganic filler (C) in the second liquid according to the third embodiment is preferably 65% by mass or more, more preferably 67% by mass or more, still more preferably 69% by mass or more, even more preferably 71% by mass or more, and even still more preferably 73% by mass or more, from the viewpoint of further improving the performance balance between the storage stability and the flowability of the second liquid; and is preferably 85% by mass or less, more preferably 83% by mass or less, still more preferably 81% by mass or less, even more preferably 79% by mass or less, and even still more preferably 77% by mass or less.

In addition, from the viewpoint of further improving the performance balance between the storage stability and the flowability of the second liquid, the content of the inorganic filler (C) in the second liquid is preferably 65% by mass or more and 85% by mass or less, more preferably 67% by mass or more and 83% by mass or less, still more preferably 69% by mass or more and 81% by mass or less, even more preferably 71% by mass or more and 79% by mass or less, and even still more preferably 73% by mass or more and 77% by mass or less, when the total amount of the above-described second liquid is taken as 100% by mass.

### (Sedimentation inhibitor (D))

The sedimentation inhibitor (D) in the third embodiment preferably includes one or two or more selected from the group consisting of an inorganic thickener (excluding the inorganic filler (C) described above) and a dispersant, and more preferably includes an inorganic thickener.

By including one or two or more selected from the group consisting of an inorganic thickener and a dispersant as the sedimentation inhibitor (D), sedimentation of the inorganic filler (C) in the two-pack type liquid resin composition can be further suppressed.

### · Inorganic thickener

From the viewpoint of further improving the performance balance between the storage stability and the flowability of the two-pack type liquid resin composition, the inorganic thickener in the third embodiment preferably includes a layered inorganic mineral.

From the viewpoint of further improving the performance balance between the storage stability and the flowability of the two-pack type liquid resin composition, the layered inorganic mineral in the third embodiment preferably includes one or two or more selected from the group consisting of clay and talc, and more preferably includes organoclay.

From the viewpoint of further improving the performance balance between the storage stability and the flowability of the two-pack type liquid resin composition, the clay in the third embodiment preferably includes one or two or more selected from the group consisting of kaolin, smectite, illite, bentonite (montmorillonite), hectorite, pyrophyllite, attapulgite, sepiolite, and laponite, and more preferably includes bentonite.

In addition, the organoclay in the third embodiment preferably includes one or two or more selected from the group consisting of organokaolin, organosmectite, organoillite, organobentonite (organomontmorillonite), organohectorite, organopyrophyllite, organoattapulgite, organosepiolite, and organolaponite; more preferably includes organobentonite from the viewpoint of further improving the performance balance between the storage stability and the flowability of the two-pack type liquid resin composition; still more preferably includes bentonite ion-exchanged with a quaternary ammonium salt, still more preferably includes bentonite ion-exchanged with a quaternary alkylammonium salt; even more preferably includes bentonite ion-exchanged with a quaternary alkylammonium salt including at least one alkyl group having 6 to 24 carbon atoms; and even still more preferably includes bentonite ion-exchanged with a quaternary alkylammonium salt including at least one alkyl group having 12 to 22 carbon atoms.

As used herein, "organoclay" refers to a layered silicate (clay) in which an organic compound is intercalated into an interlayer between silicate planes stacked in layers. Between the silicate planes laminated in layers, for example, interlayer cations such as sodium ions and calcium ions are present and maintain a layered crystal structure. By ion-exchanging the interlayer cations with organic cations, the organic compound is chemically bonded to the surface of the silicate planes and is inserted in the interlayer.

In the organoclay, the organic compound that is ion-exchanged with the interlayer cations preferably includes a quaternary ammonium salt; more preferably includes a quaternary alkylammonium salt; still more preferably includes a quaternary alkylammonium salt including at least one alkyl group having 6 or more and 24 or less carbon atoms; even more preferably includes a quaternary alkylammonium salt including at least one alkyl group having 12 or more and 22 or less carbon atoms; and even still more preferably includes one or two or more selected from the group consisting of trimethylstearylammonium salt, dimethylstearylbenzylammonium salt, dimethyloctadecylammonium salt, oleylbis(2-hydroxyethyl)methylammonium salt, dimethylstearylammonium salt, benzyldimethylstearylammonium salt, and dimethyldistearylammonium salt.

Examples of a commercially available product of the organobentonite used in the third embodiment include BENTONE 34, BENTONE SD-1, BENTONE SD-2, BENTONE SD-3, BENTONE 57, and BENTONE 52 manufactured by Elementis PLC.; ESBEN NX, ESBEN N400, ESBEN WX, ESBEN NZ, ESBEN, ESBEN W, ESBEN C, ESBEN E, ESBEN NZ70, ESBEN NTO, ESBEN NX80, ESBEN NO12S, ESBEN NEZ, ESBEN NO12, and ESBEN NE manufactured by HOJUN Co., Ltd.; and KUNIVIS 110, KUNIVIS 120, and KUNIVIS 127 manufactured by Kunimine Industries.

Examples of a commercially available product of the organohectorite used in the third embodiment include BENTONE 27 and BENTONE 38 manufactured by Elementis PLC.

### · Dispersant

From the viewpoint of further improving the performance balance between the storage stability and the flowability of the two-pack type liquid resin composition, the dispersant in the third embodiment preferably includes an ester compound including a long-chain hydrocarbon group; more preferably includes one or two or more selected from the group consisting of a carboxylic acid ester compound including a long-chain hydrocarbon group, a phosphoric acid ester compound including a long-chain hydrocarbon group, a sulfuric acid ester compound including a long-chain hydrocarbon group, a nitric acid ester compound including a long-chain hydrocarbon group, and a carbonic acid ester compound including a long-chain hydrocarbon group; and still more preferably includes one or two or more selected from the group consisting of a carboxylic acid ester compound including a long-chain hydrocarbon group and a phosphoric acid ester compound including a long-chain hydrocarbon group.

Since such an ester compound including a long-chain hydrocarbon group can suppress secondary aggregation of the inorganic filler (C) due to steric hindrance by the long-chain hydrocarbon group, it is considered that the performance balance between the storage stability and the flowability of the two-pack type liquid resin composition can be further improved.

From the viewpoint of further improving the performance balance between the storage stability and the flowability of the two-pack type liquid resin composition, the long-chain hydrocarbon group in the ester compound including a long-chain hydrocarbon group in the third embodiment preferably includes one or two or more selected from the group consisting of an alkylene group, an alkyl group, an alkenyl group, an aralkyl group, an aryl group, and an aryl group in which one, two, or three hydrogen atoms of a hydrocarbon are substituted by substituents; and more preferably includes one or two or more selected from the group consisting of an alkylene group, an alkyl group, and an alkenyl group.

The long-chain hydrocarbon group may be linear or branched. In the long-chain hydrocarbon group, a part of hydrogen atoms of the long-chain hydrocarbon group may be replaced by a substituent such as a hydroxy group, an aldehyde group, a carbonyl group, a carboxy group, an amino group, a nitro group, a sulfo group, and a halogeno group. The long-chain hydrocarbon group may include a bonding group including oxygen, such as an ether bond and an ester bond, in the long chain.

From the viewpoint of further improving the performance balance between the storage stability and the flowability of the two-pack type liquid resin composition, the ester group in the ester compound including a long-chain hydrocarbon group in the third embodiment preferably includes one or two or more selected from the group consisting of a carboxylic acid ester group, a phosphoric acid ester group, a sulfuric acid ester group, a nitric acid ester group, and a carbonic acid ester group; and more preferably includes one or two or more selected from the group consisting of a carboxylic acid ester group and a phosphoric acid ester group.

From the viewpoint of further improving the performance balance between the storage stability and the flowability of the two-pack type liquid resin composition, the number of carbon atoms of the long-chain hydrocarbon group in the ester compound including a long-chain hydrocarbon group in the third embodiment is preferably 4 or more, more preferably 6 or more, still more preferably 8 or more, and even more preferably 10 or more; and is preferably 1000 or less, more preferably 800 or less, still more preferably 600 or less, even more preferably 400 or less, and even still more preferably 200 or less.

In addition, from the viewpoint of further improving the performance balance between the storage stability and the flowability of the two-pack type liquid resin composition, the number of carbon atoms of the long-chain hydrocarbon group is preferably 4 or more and 1000 or less, more preferably 4 or more and 800 or less, still more preferably 6 or more and 600 or less, even more preferably 8 or more and 400 or less, and even still more preferably 10 or more and 200 or less.

From the viewpoint of further improving the performance balance between the storage stability and the flowability of the two-pack type liquid resin composition, a mass-average molecular weight of the ester compound including a long-chain hydrocarbon group in the third embodiment is preferably 300 or more, more preferably 400 or more, still more preferably 500 or more, even more preferably 600 or more, even still more preferably 700 or more, and further more preferably 800 or more; and is preferably 50,000 or less, more preferably 30,000 or less, still more preferably 15,000 or less, and even more preferably 10,000 or less.

In addition, from the viewpoint of further improving the performance balance between the storage stability and the flowability of the two-pack type liquid resin composition, the mass-average molecular weight of the ester compound is preferably 300 or more and 50,000 or less, more preferably 400 or more and 50,000 or less, still more preferably 500 or more and 50,000 or less, even more preferably 600 or more and 30,000 or less, even still more preferably 700 or more and 15,000 or less, and further more preferably 800 or more and 10,000 or less.

From the viewpoint of further improving the performance balance between the storage stability and the flowability of the two-pack type liquid resin composition, the ester compound including a long-chain hydrocarbon group in the third embodiment preferably includes one or two or more selected from the group consisting of a polyhydroxycarboxylic acid ester, an acidic phosphate ester, and a carboxyl group-including polymer-modified product.

From the viewpoint of further improving the performance balance between the storage stability and the flowability of the two-pack type liquid resin composition, the polyhydroxycarboxylic acid ester in the third embodiment preferably includes a compound represented by General Formula (Ic).

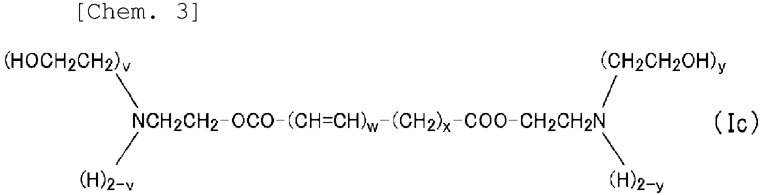

In General Formula (Ic), v and y are each independently 1 or 2, w is an integer of 0 or more and 10 or less, and x is an integer of 14 or more and 40 or less. -(CH=CH)_{w}-(CH2)ₓ- may be a block structure in which w pieces of (CH=CH) are successively linked, followed by x pieces of (CH₂) consecutively linked, or may be a random structure in which (CH=CH) and (CH₂) are randomly arranged.

In General Formula (Ic), from the viewpoint of further improving the performance balance between the storage stability and the flowability of the two-pack type liquid resin composition, w is preferably an integer of 0 or more and 8 or less. In addition, from the viewpoint of further improving the performance balance between the storage stability and the flowability of the two-pack type liquid resin composition, x is preferably an integer of 18 or more and 36 or less.

Examples of a commercially available product of the polyhydroxycarboxylic acid ester used in the third embodiment include BYK-R606 manufactured by BYK-Chemie Japan.

From the viewpoint of further improving the performance balance between the storage stability and the flowability of the two-pack type liquid resin composition, the acidic phosphate ester in the third embodiment preferably includes a compound represented by General Formula (IIc).

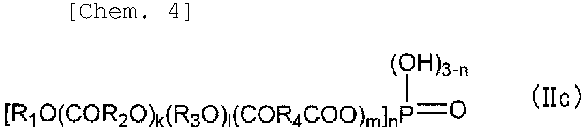

In General Formula (IIc), R₁ is a saturated or unsaturated hydrocarbyl group having 4 or more and 20 or less carbon atoms, R₂ is a saturated hydrocarbylene group having 1 or more and 20 or less carbon atoms, R₃ is a saturated hydrocarbylene group having 2 or 3 carbon atoms, R₄ is a saturated or unsaturated hydrocarbylene group having 1 or more and 8 or less carbon atoms, k, l, and m are each an integer of 0 or more and 20 or less, and n is 1 or 2. When a plurality of R₁'s are present, the plurality of R₁'s may be the same or different; when a plurality of R₂'s are present, the plurality of R₂'s may be the same or different; when a plurality of R₃'s are present, the plurality of R₃'s may be the same or different; and when a plurality of R₄'s are present, the plurality of R₄'s may be the same or different. The sequence of k -COR₂O- groups, l -R₃O- groups, and m -COR₄COO- groups is arbitrary, and in a case of n = 2, two R₁O(COR₂O)ₖ(R₃O)ₗ(COR₄COO)ₘ groups may be the same or different.

In General Formula (IIc), R₁ is not particularly limited as long as it is a saturated or unsaturated hydrocarbyl group having 4 or more and 20 or less carbon atoms. R1 preferably includes one or two or more selected from the group consisting of a saturated hydrocarbon group and an unsaturated hydrocarbon group. The saturated hydrocarbon group preferably includes one or two or more selected from the group consisting of an octyl group, a 2-ethylhexyl group, a nonyl group, a decyl group, an undecyl group, a dodecyl group, a tetradecyl group, a hexadecyl group, and an octadecyl group. The unsaturated hydrocarbon group preferably includes one or two or more selected from the group consisting of a phenyl group and a nonylphenyl group. From the viewpoint of further improving the performance balance between the storage stability and the flowability of the two-pack type liquid resin composition, the number of carbon atoms in R₁ is preferably 6 or more and 18 or less, and when k = l = m = 0, the number of carbon atoms in R₁ is preferably 10 or more and 18 or less.

In General Formula (IIc), R₂ is a saturated hydrocarbylene group having 1 or more and 20 or less carbon atoms. The number of carbon atoms in R₂ is preferably 1 or more and 16 or less. From the viewpoint of further improving the performance balance between the storage stability and the flowability of the two-pack type liquid resin composition, R₂ preferably includes one or two or more selected from the group consisting of a methylene group, an ethylene group, a pentylene group, a tetradecylene group, and a pentadecylene group.

In General Formula (IIc), R₃ is a saturated hydrocarbylene group having 2 or 3 carbon atoms. From the viewpoint of further improving the performance balance between the storage stability and the flowability of the two-pack type liquid resin composition, R₃ is preferably a saturated hydrocarbylene group having 2 carbon atoms, and more preferably an ethylene group.

In General Formula (IIc), R₄ is a saturated or unsaturated hydrocarbylene group having 1 or more and 8 or less carbon atoms. The number of carbon atoms in R₄ is preferably 1 or more and 6 or less. From the viewpoint of further improving the performance balance between the storage stability and the flowability of the two-pack type liquid resin composition, R₄ preferably includes one or two or more selected from the group consisting of a methylene group, an ethylene group, a propylene group, a butylene group, a pentylene group, and a phenyl group.

In General Formula (IIc), from the viewpoint of further improving the performance balance between the storage stability and the flowability of the two-pack type liquid resin composition, k, l, and m are each preferably an integer of 0 to 10.

In General Formula (IIc), the sequence in which the monomer units indicated by k, l, and m, namely k -COR₂O- groups, l -R₃O-groups, and m -COR₄COO- groups, are arranged between the R₁O-group and the phosphorus atom is arbitrary. These groups are not necessarily arranged as in General Formula (IIc). In addition, the -(COR₂O)ₖ(R₃O)ₗ(COR₄COO)ₘ- group may be a block copolymer or a random copolymer.

Examples of a commercially available product of the acidic phosphate ester used in the third embodiment include BYK-W9010 manufactured by BYK-Chemie Japan.

The carboxyl group-including polymer-modified product in the third embodiment includes an ester compound obtained by esterifying an α-olefin/maleic anhydride copolymer with a monohydric alcohol. In such an ester compound, the arrangement of a hydrophobic moiety such as a hydrocarbon group derived from an α-olefin and a hydrophilic moiety such as a carboxyl group formed by ring-opening addition of a maleic anhydride-derived maleic anhydride group is controlled.

From the viewpoint of further improving the performance balance between the storage stability and the flowability of the two-pack type liquid resin composition, the α-olefin constituting the ester compound of the α-olefin/maleic anhydride copolymer and the monohydric alcohol in the third embodiment preferably includes a linear or branched unsaturated hydrocarbon having 6 or more carbon atoms, and preferably includes an unsaturated hydrocarbon having 6 or more and 30 or less carbon atoms. The unsaturated hydrocarbon having 6 or more and 30 or less carbon atoms preferably includes one or two or more selected from the group consisting of 1-dodecene and 1-tetradecene.

From the viewpoint of further improving the performance balance between the storage stability and the flowability of the two-pack type liquid resin composition, the monohydric alcohol used for forming the ester compound of the α-olefin/maleic anhydride copolymer and the monohydric alcohol in the third embodiment preferably includes one or two or more selected from the group consisting of an aliphatic alcohol, an aromatic alcohol, and a polyalkylene glycol monoalkyl ether.

The aliphatic alcohol in the third embodiment preferably includes one or two or more selected from the group consisting of cetyl alcohol and stearyl alcohol.

The aromatic alcohol in the third embodiment preferably includes one or two or more selected from the group consisting of 1-phenyl-1-propanol and α-phenoxy-2-propanol.

The polyalkylene glycol monoalkyl ether in the third embodiment preferably includes a polyethylene glycol monoalkyl ether having a molecular weight of 400 to 700.

An acid value of the carboxyl group-including polymer-modified product in the third embodiment is preferably 10 mgKOH/g or more and 100 mgKOH/g or less, and more preferably 15 mgKOH/g or more and 60 mgKOH/g or less.

Examples of a commercially available product of the carboxyl group-including polymer-modified product used in the third embodiment include FLOREN G-700, FLOREN G-900, FLOREN G-1500, and NC-500 manufactured by Kyoeisha Chemical.

When the total amount of the above-described two-pack type liquid resin composition is taken as 100% by mass, a content of the sedimentation inhibitor (D) in the two-pack type liquid resin composition according to the third embodiment is preferably 0.01% by mass or more, more preferably 0.03% by mass or more, still more preferably 0.05% by mass or more, and even more preferably 0.08% by mass or more, from the viewpoint of further suppressing sedimentation of the inorganic filler (C) in the two-pack type liquid resin composition; and is preferably 2.00% by mass or less, more preferably 1.50% by mass or less, still more preferably 1.00% by mass or less, even more preferably 0.80% by mass or less, even still more preferably 0.50% by mass or less, further more preferably 0.30% by mass or less, even further more preferably 0.20% by mass or less, and particularly preferably 0.15% by mass or less, from the viewpoint of further improving the performance balance between the storage stability and the flowability of the two-pack type liquid resin composition.

In addition, from the viewpoints of further suppressing sedimentation of the inorganic filler (C) in the two-pack type liquid resin composition and further improving the performance balance between the storage stability and the flowability of the two-pack type liquid resin composition, the content of the sedimentation inhibitor (D) in the two-pack type liquid resin composition is preferably 0.01% by mass or more and 2.00% by mass or less, more preferably 0.01% by mass or more and 1.50% by mass or less, still more preferably 0.01% by mass or more and 1.00% by mass or less, even more preferably 0.01% by mass or more and 0.80% by mass or less, even still more preferably 0.01% by mass or more and 0.50% by mass or less, further more preferably 0.03% by mass or more and 0.30% by mass or less, even further more preferably 0.05% by mass or more and 0.20% by mass or less, and particularly preferably 0.08% by mass or more and 0.15% by mass or less, when the total amount of the above-described two-pack type liquid resin composition is taken as 100% by mass.

When the total amount of the above-described first liquid is taken as 100% by mass, a content of the sedimentation inhibitor (D) in the first liquid according to the third embodiment is preferably 0.01% by mass or more, more preferably 0.03% by mass or more, still more preferably 0.05% by mass or more, and even more preferably 0.08% by mass or more, from the viewpoint of suppressing sedimentation of the inorganic filler (C) in the first liquid; and is preferably 2.00% by mass or less, more preferably 1.50% by mass or less, still more preferably 1.00% by mass or less, even more preferably 0.80% by mass or less, even still more preferably 0.50% by mass or less, further more preferably 0.30% by mass or less, even further more preferably 0.20% by mass or less, and particularly preferably 0.15% by mass or less, from the viewpoint of further improving the performance balance between the storage stability and the flowability of the first liquid.

In addition, from the viewpoints of suppressing sedimentation of the inorganic filler (C) in the first liquid and further improving the performance balance between the storage stability and the flowability of the first liquid, the content of the sedimentation inhibitor (D) in the first liquid is preferably 0.01% by mass or more and 2.00% by mass or less, more preferably 0.01% by mass or more and 1.50% by mass or less, still more preferably 0.01% by mass or more and 1.00% by mass or less, even more preferably 0.01% by mass or more and 0.80% by mass or less, even still more preferably 0.01% by mass or more and 0.50% by mass or less, further more preferably 0.03% by mass or more and 0.30% by mass or less, even further more preferably 0.05% by mass or more and 0.20% by mass or less, and particularly preferably 0.08% by mass or more and 0.15% by mass or less, when the total amount of the above-described first liquid is taken as 100% by mass.

When the total amount of the above-described second liquid is taken as 100% by mass, a content of the sedimentation inhibitor (D) in the second liquid according to the third embodiment is preferably 0.01% by mass or more, more preferably 0.03% by mass or more, still more preferably 0.05% by mass or more, and even more preferably 0.08% by mass or more, from the viewpoint of suppressing sedimentation of the inorganic filler (C) in the second liquid; and is preferably 2.00% by mass or less, more preferably 1.50% by mass or less, still more preferably 1.00% by mass or less, even more preferably 0.80% by mass or less, even still more preferably 0.50% by mass or less, further more preferably 0.30% by mass or less, even further more preferably 0.20% by mass or less, and particularly preferably 0.15% by mass or less, from the viewpoint of further improving the performance balance between the storage stability and the flowability of the second liquid.

In addition, from the viewpoints of suppressing sedimentation of the inorganic filler (C) in the second liquid and further improving the performance balance between storage stability and flowability of the second liquid, the content of the sedimentation inhibitor (D) in the second liquid is preferably 0.01% by mass or more and 2.00% by mass or less, more preferably 0.01% by mass or more and 1.50% by mass or less, still more preferably 0.01% by mass or more and 1.00% by mass or less, even more preferably 0.01% by mass or more and 0.80% by mass or less, even still more preferably 0.01% by mass or more and 0.50% by mass or less, further more preferably 0.03% by mass or more and 0.30% by mass or less, even further more preferably 0.05% by mass or more and 0.20% by mass or less, and most preferably 0.08% by mass or more and 0.15% by mass or less, when the total amount of the above-described second liquid is taken as 100% by mass.

### (Curing accelerator (E))

The two-pack type liquid resin composition according to the third embodiment preferably further includes a curing accelerator (E) from the viewpoint of promoting the reaction between the epoxy resin (A) and the acid anhydride (B) to improve the curability of the two-pack type liquid resin composition.

It is preferable that the curing accelerator (E) in the third embodiment is included in the second liquid, from the viewpoint of further improving the performance balance between the storage stability and the flowability of the two-pack type liquid resin composition.

From the viewpoint of improving the curability of the two-pack type liquid resin composition, the curing accelerator (E) in the third embodiment preferably includes one or two or more selected from the group consisting of a tertiary amine, a quaternary ammonium salt, imidazoles, an organic phosphine, and a Lewis acid catalyst, and more preferably includes a quaternary ammonium salt.

The tertiary amine preferably includes one or two or more selected from the group consisting of trimethylamine, triethylamine, tripropylamine, tributylamine, and benzyldimethylamine.

The quaternary ammonium salt preferably includes one or two or more selected from the group consisting of organic acid salts of diazabicycloundecene, such as DBU [1,8-diazabicyclo[5.4.0]undec-7-ene] octylate (manufactured by San-Apro Ltd., trade name: SA102), DBN [1,5-diazabicyclo[4.3.0]non-5-ene], quaternary ammonium salts that are salts of tertiary amines and carboxylic acids (manufactured by San-Apro Ltd., trade name: U-CAT2313), octadecyltrimethylammonium chloride (manufactured by NOF CORPORATION, trade name: NISSAN CATION), and tetraalkylammonium salts (each alkyl group having 1 to 18 carbon atoms) (for example, tetraethylammonium bromide, tetrabutylammonium bromide, and tetraalkylammonium carboxylates (carboxylic acids having 1 to 12 carbon atoms)).

The curing accelerator (E) in the third embodiment more preferably includes an organic acid salt of diazabicycloundecene, from the viewpoint of improving the curability of the two-pack type liquid resin composition.

The imidazoles preferably include one or two or more selected from the group consisting of 1-benzyl-2-methylimidazole, 2-ethyl-4-methylimidazole, 2-undecylimidazole, 1,2-dimethylimidazole, and 1-benzyl-2-phenylimidazole.

The organic phosphine preferably includes one or two or more selected from the group consisting of triphenylphosphine, triphenylphosphine-triphenylborate, tris(p-methoxyphenyl)phosphine, and tetraphenylphosphonium tetraphenylborate.

The Lewis acid catalyst preferably includes one or two or more selected from the group consisting of boron trifluoride amine complex, boron trichloride amine complex, and boron trifluoride ethylamine complex.

When the total amount of the above-described two-pack type liquid resin composition is taken as 100% by mass, a content of the curing accelerator (E) in the two-pack type liquid resin composition according to the third embodiment is preferably 0.01% by mass or more, more preferably 0.05% by mass or more, still more preferably 0.10% by mass or more, even more preferably 0.15% by mass or more, and even still more preferably 0.20% by mass or more, from the viewpoint of improving the curability of the two-pack type liquid resin composition; and is preferably 1.00% by mass or less, more preferably 0.80% by mass or less, still more preferably 0.50% by mass or less, and even more preferably 0.30% by mass or less, from the viewpoint of further improving the performance balance between the storage stability and the flowability of the two-pack type liquid resin composition.

In addition, from the viewpoint of improving curability, storage stability, and flowability of the two-pack type liquid resin composition, the content of the curing accelerator (E) in the two-pack type liquid resin composition is preferably 0.01% by mass or more and 1.00% by mass or less, more preferably 0.05% by mass or more and 1.00% by mass or less, still more preferably 0.10% by mass or more and 0.80% by mass or less, even more preferably 0.15% by mass or more and 0.50% by mass or less, and even still more preferably 0.20% by mass or more and 0.30% by mass or less, when the total amount of the above-described two-pack type liquid resin composition is taken as 100% by mass.

### (Other components)

The two-pack type liquid resin composition according to the third embodiment may include a coupling agent, a colorant such as carbon black, an antifoaming agent such as a silicone antifoaming agent, a flame retardant, and the like as necessary.

From the viewpoint of improving an interfacial strength between the epoxy resin (A) and the inorganic filler (C), the coupling agent in the third embodiment preferably includes one or two or more selected from the group consisting of an epoxy silane coupling agent, an amino silane coupling agent, a ureido silane coupling agent, and a mercapto silane coupling agent, and more preferably includes an epoxy silane coupling agent.

The epoxy silane coupling agent preferably includes one or two or more selected from the group consisting of γ-glycidoxypropyltriethoxysilane, γ-glycidoxypropyltrimethoxysilane, γ-glycidoxypropylmethyldimethoxysilane, and β-(3,4-epoxycyclohexyl)ethyltrimethoxysilane, and more preferably includes γ-glycidoxypropyltrimethoxysilane.

The amino silane coupling agent preferably includes one or two or more selected from the group consisting of γ-aminopropyltriethoxysilane, γ-aminopropyltrimethoxysilane, N-β(aminoethyl)γ-aminopropyltrimethoxysilane, N-β(aminoethyl)γ-aminopropylmethyldimethoxysilane, N-phenyl-γ-aminopropyltriethoxysilane, N-phenyl-γ-aminopropyltrimethoxysilane, N-β(aminoethyl)γ-aminopropyltriethoxysilane, N-(6-aminohexyl)3-aminopropyltrimethoxysilane, and N-(3-(trimethoxysilylpropyl)-1,3-benzenedimethanamine.

The ureido silane coupling agent includes, for example, one or two or more selected from the group consisting of γ-ureidopropyltriethoxysilane and hexamethyldisilazane.

When the total amount of the above-described two-pack type liquid resin composition is taken as 100% by mass, a content of the coupling agent in the two-pack type liquid resin composition according to the third embodiment is preferably 0.01% by mass or more, more preferably 0.03% by mass or more, still more preferably 0.05% by mass or more, and even more preferably 0.08% by mass or more, from the viewpoint of improving the interfacial strength between the epoxy resin (A) and the inorganic filler (C); and is preferably 1.00% by mass or less, more preferably 0.80% by mass or less, still more preferably 0.60% by mass or less, even more preferably 0.40% by mass or less, and even still more preferably 0.20% by mass or less.

In addition, from the viewpoint of improving the interfacial strength between the epoxy resin (A) and the inorganic filler (C), the content of the coupling agent in the two-pack type liquid resin composition is preferably 0.01% by mass or more and 1.00% by mass or less, more preferably 0.01% by mass or more and 0.80% by mass or less, still more preferably 0.03% by mass or more and 0.60% by mass or less, even more preferably 0.05% by mass or more and 0.40% by mass or less, and even still more preferably 0.08% by mass or more and 0.20% by mass or less, when the total amount of the above-described two-pack type liquid resin composition is taken as 100% by mass.

The colorant in the third embodiment preferably includes one or two or more selected from the group consisting of carbon black, titanium oxide, barium sulfate, iron black, red iron oxide, aniline black, and alizarin, and more preferably includes carbon black.

When the total amount of the above-described two-pack type liquid resin composition is taken as 100% by mass, a content of the colorant in the two-pack type liquid resin composition according to the third embodiment is preferably 0.01% by mass or more, more preferably 0.02% by mass or more, still more preferably 0.03% by mass or more, even more preferably 0.04% by mass or more, and even still more preferably 0.05% by mass or more; and is preferably 0.50% by mass or less, more preferably 0.40% by mass or less, still more preferably 0.30% by mass or less, even more preferably 0.20% by mass or less, and even still more preferably 0.10% by mass or less.

In addition, the content of the colorant in the two-pack type liquid resin composition is preferably 0.01% by mass or more and 0.50% by mass or less, more preferably 0.02% by mass or more and 0.40% by mass or less, still more preferably 0.03% by mass or more and 0.30% by mass or less, even more preferably 0.04% by mass or more and 0.20% by mass or less, and even still more preferably 0.05% by mass or more and 0.10% by mass or less, when the total amount of the above-described two-pack type liquid resin composition is taken as 100% by mass.

The antifoaming agent in the third embodiment preferably includes one or two or more selected from the group consisting of a silicone-based antifoaming agent, a fluorine-based antifoaming agent, and a polymer-based antifoaming agent, and more preferably includes a silicone-based antifoaming agent.

When the total amount of the above-described two-pack type liquid resin composition is taken as 100% by mass, a content of the antifoaming agent in the two-pack type liquid resin composition according to the third embodiment is preferably 0.01% by mass or more, more preferably 0.03% by mass or more, still more preferably 0.05% by mass or more, and even more preferably 0.08% by mass or more; and is preferably 1.00% by mass or less, more preferably 0.80% by mass or less, still more preferably 0.60% by mass or less, even more preferably 0.40% by mass or less, and even still more preferably 0.20% by mass or less.

In addition, the content of the antifoaming agent in the two-pack type liquid resin composition is preferably 0.01% by mass or more and 1.00% by mass or less, more preferably 0.01% by mass or more and 0.80% by mass or less, still more preferably 0.03% by mass or more and 0.60% by mass or less, even more preferably 0.05% by mass or more and 0.40% by mass or less, and even still more preferably 0.08% by mass or more and 0.20% by mass or less, when the total amount of the two-pack type liquid resin composition is taken as 100% by mass.

The flame retardant in the third embodiment preferably includes one or two or more selected from the group consisting of aluminum hydroxide, magnesium hydroxide, zinc borate, zinc molybdate, antimony trioxide, antimony pentoxide, phosphazene, brominated epoxy resin, and brominated polycarbonate, from the viewpoint of further improving flame retardancy of the cured product of the two-pack type liquid resin composition.

From the viewpoint of further improving the flame retardancy of the cured product of the two-pack type liquid resin composition, a content of the flame retardant in the two-pack type liquid resin composition according to the third embodiment is preferably 1.0% by mass or more and 50% by mass or less, and more preferably 5.0% by mass or more and 30% by mass or less, when the total amount of the above-described two-pack type liquid resin composition is taken as 100% by mass.

### (Method for producing two-pack type liquid resin composition)

A method for producing the two-pack type liquid resin composition according to the third embodiment will be described in detail.

The two-pack type liquid resin composition according to the third embodiment can be produced by sufficiently mixing and stirring, as a first liquid, the epoxy resin (A), the inorganic filler (C), the sedimentation inhibitor (D), and other components, and sufficiently mixing and stirring, as a second liquid, the acid anhydride (B), the inorganic filler (C), the sedimentation inhibitor (D), and other components, among the above-described components, by a known method.

When the two-pack type liquid resin composition according to the third embodiment includes a curing accelerator (E), it is preferable that the second liquid includes the curing accelerator (E).

Examples of a method of mixing and stirring each component to obtain the first liquid or the second liquid in the two-pack type liquid resin composition according to the third embodiment include a method using a mixing machine such as a mixer, and a method using a kneading machine such as a roll and a kneader.

The two-pack type liquid resin composition according to the third embodiment is used in a state of a mixed liquid obtained by mixing the first liquid and the second liquid. Examples of a method of mixing the first liquid and the second liquid include a method using a mixing machine such as a mixer, and a method using a kneading machine such as a roll and a kneader.

In the two-pack type liquid resin composition according to the third embodiment, when the amount of the above-described first liquid is taken as 100 parts by mass, a content of the second liquid when further mixing the first liquid and the second liquid is preferably 50 parts by mass or more, more preferably 60 parts by mass or more, and still more preferably 70 parts by mass or more, from the viewpoint of further improving the performance balance of flowability, heat resistance during curing, and mechanical properties of the two-pack type liquid resin composition; and is preferably 150 parts by mass or less, more preferably 130 parts by mass or less, and still more preferably 110 parts by mass or less.

In addition, from the viewpoint of further improving the performance balance of flowability, heat resistance during curing, and mechanical properties of the two-pack type liquid resin composition, the content of the second liquid when further mixing the first liquid and the second liquid is preferably 50 parts by mass or more and 150 parts by mass or less, more preferably 60 parts by mass or more and 130 parts by mass or less, and still more preferably 70 parts by mass or more and 110 parts by mass or less, when the amount of the above-described first liquid is taken as 100 parts by mass.

### <Description common to first to third embodiments>

### (Application of two-pack type liquid resin composition)

The two-pack type liquid resin composition according to the present embodiment can be preferably used for encapsulating, by a casting method, a power module that includes a power-module substrate including a circuit layer and a power semiconductor element on the circuit layer of the power-module substrate.

### [Power module]

The power module according to the present embodiment includes a power-module substrate including a circuit layer, a power semiconductor element on the circuit layer of the power-module substrate, and an encapsulant for encapsulating the power-module substrate and the power semiconductor element, in which the encapsulant includes a cured product of the two-pack type liquid resin composition of the present embodiment described above.

The power module according to the present embodiment may be a small- to medium-sized power module for home appliances, computers, and the like, or a large-sized power module for controlling automobiles, railway vehicles, substations, and the like. The power module according to the present embodiment is preferably one or two or more selected from the group consisting of a rectifier, a frequency converter, a regulator, and an inverter.

The power semiconductor element in the power module according to the present embodiment preferably includes one or two or more selected from the group consisting of a rectifier diode, a power transistor, a MOS transistor, an insulated gate bipolar transistor (IGBT), a thyristor, a gate turn-off thyristor (GTO), and a triac, and more preferably includes one or two or more selected from the group consisting of a MOS transistor and an insulated gate bipolar transistor (IGBT).

The power module according to the present embodiment can be obtained by casting the two-pack type liquid resin composition according to the present embodiment described above onto the power semiconductor element mounted on the power-module substrate having the circuit layer formed thereon, so as to cover the substrate and the power semiconductor element, and then heating to cure the two-pack type liquid resin composition. It is preferable to vacuum-degas the two-pack type liquid resin composition during casting and/or before or after casting. By performing the vacuum defoaming, air and the like, included in the two-pack type liquid resin composition, are removed, and a power module having fewer voids in the cured product of the two-pack type liquid resin composition can be obtained.

A method of heating for curing the two-pack type liquid resin composition according to the present embodiment is not particularly limited, and a known method in the related art, such as hot-air circulation heating, infrared heating, and highfrequency heating, can be adopted.

A heating temperature of the power module according to the present embodiment is preferably 100°C or higher, more preferably 110°C or higher, still more preferably 120°C or higher, and even more preferably 130°C or higher, from the viewpoint of production efficiency of the power module; and is preferably 220°C or lower, more preferably 210°C or lower, and still more preferably 200°C or lower, from the viewpoint of improving the performance balance of reliability and mechanical strength of the power module.

A heating time of the power module according to the present embodiment is preferably 30 seconds or more, more preferably 60 seconds or more, and still more preferably 300 seconds or more, from the viewpoint of improving the performance balance of reliability and mechanical strength of the power module; and is preferably 10 hours or less, more preferably 5 hours or less, and still more preferably 3 hours or less, from the viewpoint of production efficiency of the power module.

The embodiments of the present invention have been described above, but these are examples of the present invention and various configurations other than the above can be adopted. In addition, the present invention is not limited to the above-described embodiments, and modifications, improvements, and the like within the range in which the object of the present invention can be achieved are included in the present invention.

### EXAMPLES

Hereinafter, the present invention will be described in more detail with reference to Examples, but the present invention is not limited thereto in any way. Here, Examples and Comparative Examples relating to the first embodiment of the present invention are Examples 1a to 5a and Comparative Examples 1a to 4a; Examples and Comparative Examples relating to the second embodiment of the present invention are Examples 1b to 3b and Comparative Examples 1b to 4b; and Examples and Comparative Examples relating to the third embodiment of the present invention are Examples 1c to 3c and Comparative Examples 1c to 2c.

### <Examples and Comparative Examples relating to the first embodiment>

Components shown in "First liquid" of Table 1 were mixed in amounts (parts by mass) shown in Table 1 to obtain a first liquid (main agent). Separately, components shown in "Second liquid" of Table 1 were mixed in amounts (parts by mass) shown in Table 1 to obtain a second liquid (curing agent). Thereafter, the first liquid and the second liquid were mixed at a ratio shown in "Compounding ratio (first liquid/second liquid)" of Table 1 to produce a mixed liquid (liquid resin composition).

Details of each component in Table 1 are as follows.

### <Epoxy resin (A)>

· Epoxy resin 1a: 3,4-epoxycyclohexylmethyl-3',4'-epoxycyclohexane carboxylate (alicyclic epoxy resin, manufactured by Daicel Corporation, Celloxide 2021P)
· Epoxy resin 2a: bisphenol A-type epoxy resin (manufactured by Mitsubishi Chemical Corporation, jER828EL)
· Epoxy resin 3a: bisphenol F-type epoxy resin (manufactured by Mitsubishi Chemical Corporation, jER807)
· Epoxy resin 4a: aminophenol-type epoxy resin (manufactured by Mitsubishi Chemical Corporation, JER630)

### <Acid anhydride (B)>

· Acid anhydride 1a: methylnadic acid anhydride (manufactured by Showa Denko Materials Co., Ltd., MHAC-P)

### <Curing accelerator (E)>

· Curing accelerator 1a: DBU-octylate (manufactured by San-Apro Ltd., U-CAT SA102)

### <Inorganic filler (C)>

· Inorganic filler 1a: spherical fused silica (manufactured by Denka Co., Ltd., FB-950, average particle diameter D₅₀: 23 µm)

### <Sedimentation inhibitor (D)>

· Sedimentation inhibitor 1a: organobentonite (manufactured by HOJUN Co., Ltd., ESBEN NTO)
· Sedimentation inhibitor 2a: organobentonite (manufactured by Elementis PLC., BENTONE SD-2)
· Sedimentation inhibitor 3a: organobentonite (manufactured by HOJUN Co., Ltd., ESBEN N400)
· Sedimentation inhibitor 4a: organobentonite (manufactured by HOJUN Co., Ltd., ESBEN NZ)
· Sedimentation inhibitor 5a: nanosilica (manufactured by Tokuyama Corporation, REOLOSIL QS20, average particle diameter D₅₀: 12 nm)

### <Other components>

· Colorant: carbon black (manufactured by Mitsubishi Chemical Corporation, Carbon #5)
· Coupling agent: epoxy silane coupling agent (manufactured by Momentive Performance Materials Inc., A-187)
· Antifoaming agent: silicone-based antifoaming agent (manufactured by Nissho Sangyo Co., Ltd., TSA750)

As the average particle diameter D₅₀ of the inorganic filler and the sedimentation inhibitor described above, a measured value when a cumulative value of a volume-based particle size distribution by a laser diffraction scattering measurement method using a laser diffraction particle size distribution analyzer (manufactured by Shimadzu Corporation, SALD-7000) was 50% was used.

### <Evaluation of physical properties>

The following physical properties were measured for the first liquid, the second liquid, and the mixed liquid obtained in each of Examples and each of Comparative Examples.

### (Viscosity and thixotropy at 25°C)

For the first liquid obtained in each of Examples and each of Comparative Examples, a viscosity η_{5A} at a rotational speed of 5 rpm and a temperature of 25°C was measured using an E-type viscometer and a 3°×R14 cone rotor (rotor No. 4). At this time, for the measurement result of the viscosity η_{5A}, the viscosity one minute after starting the rotation of the cone rotor set in the E-type viscometer was used.

Next, a viscosity η_{10A} of the first liquid was measured by the same method as described above, except that the rotational speed was changed to 10 rpm.

Furthermore, thixotropy of the first liquid was calculated from the following expression using the above-described measurement results.

### (Thixotropy of first liquid) = (Viscosity η_{5A})/(Viscosity η_{10A})

Similarly, for the second liquid and the mixed liquid, viscosities η_{5B} and η_{5P} at a rotational speed of 5 rpm and a temperature of 25°C, viscosities η_{10B} and η_{10P} at a rotational speed of 10 rpm and a temperature of 25°C, and thixotropy were measured by the same method as described above. The measurement results are shown in Table 1.

The description "Unmeasurable" in Table 1 means that each viscosity of the first liquid, the second liquid, and the mixed liquid obtained in each of Examples and each of Comparative Examples was so high that the measurement torque exceeded 100%, and a correct measured value thereof could not be obtained.

### (Flowability)

On a glass plate, 0.05 ml of the mixed liquid was applied such that a diameter of the mixed liquid was 1 cm or less. Next, the glass plate was held at an inclination angle of 45° and a temperature of 60°C for 3 minutes. A distance the mixed liquid flowed during that time was measured as a flow distance (mm), and evaluated based on the following criteria. The evaluation results are shown in Table 1.
A: flow distance was 30 mm or more.
B: flow distance was 15 mm or more and less than 30 mm.
C: flow distance was less than 15 mm.

### (Storage stability)

Storage stability of the first liquid and the second liquid was evaluated by the following method.

First, the first liquid was charged into a 120 mL plastic container with a lid to a height of 50 to 55 mm, the lid was closed, and a height of filler sedimentation (hard cake) deposited on a bottom after 240 hours at 60°C was measured, and evaluated based on the following criteria.
A: height of the hard cake was 0 mm.
B: height of the hard cake was more than 0 mm and less than 3 mm.
C: height of the hard cake was 3 mm or more.

For the second liquid, the storage stability was evaluated in the same manner as for the first liquid. The evaluation results are shown in Table 1.

### (Workability in casting)

Workability in casting of the mixed liquid was evaluated based on the following criteria.
A: all of (Requirement 1) to (Requirement 3) shown below were satisfied.
B: any two of (Requirement 1) to (Requirement 3) shown below were satisfied.
C: any one of (Requirement 1) to (Requirement 3) shown below was satisfied, or none of them were satisfied.

Requirement 1: both the viscosity η_{5P} and the viscosity η_{10P} of the mixed liquid at 25°C were 50 Pa·s or less.
Requirement 2: the evaluation result of the flowability of the mixed liquid was "A".
Requirement 3: the evaluation results of the storage stability for both the first liquid and the second liquid were "A".

**[Table 1]**

| | | Example 1a | Example 2a | Example 3a | Example 4a | Example 5a | Comparative Example 1a | Comparative Example 2a | Comparative Example 3a | Comparative Example 4a |
|---|---|---|---|---|---|---|---|---|---|---|
| | Epoxy resin 1a | 21.00 | 21.00 | 21.00 | 21.00 | 21.00 | 21.00 | | | |
| | Epoxy resin 2a | | | | | | | 21.00 | | |
| | Epoxy resin 3a | | | | | | | | 21.00 | |
| | Epoxy resin 4a | | | | | | | | | 21.00 |
| | Inorganic filler 1a | 78.00 | 78.00 | 78.00 | 78.00 | 78.00 | 78.00 | 78.00 | 78.00 | 78.00 |
| | Sedimentation inhibitor 1a | 0.20 | | | | | | 0.20 | 0.20 | 0.20 |
| | Sedimentation inhibitor 2a | | 0.20 | | | | | | | |
| First liquid | Sedimentation inhibitor 3a | | | 0.20 | | | | | | |
| | Sedimentation inhibitor 4a | | | | 0.20 | | | | | |
| | Sedimentation inhibitor 5a | | | | | 0.10 | | | | |
| | Colorant | 0.10 | 0.10 | 0.10 | 0.10 | 0.10 | 0.10 | 0.10 | 0.10 | 0.10 |
| | Coupling agent | 0.20 | 0.20 | 0.20 | 0.20 | 0.20 | 0.20 | 0.20 | 0.20 | 0.20 |
| | Antifoaming agent | 0.10 | 0.10 | 0.10 | 0.10 | 0.10 | 0.10 | 0.10 | 0.10 | 0.10 |
| | Acid anhydride 1a | 24.00 | 24.00 | 24.00 | 24.00 | 24.00 | 24.00 | 24.00 | 24.00 | 24.00 |
| | Curing accelerator 1a | 0.50 | 0.50 | 0.50 | 0.50 | 0.50 | 0.50 | 0.50 | 0.50 | 0.50 |
| | Inorganic filler 1a | 75.00 | 75.00 | 75.00 | 75.00 | 75.00 | 75.00 | 75.00 | 75.00 | 75.00 |
| Second liquid | Sedimentation inhibitor 1a | 0.10 | | | | | | 0.10 | 0.10 | 0.10 |
| | Sedimentation inhibitor 2a | | 0.10 | | | | | | | |
| | Sedimentation inhibitor 3a | | | 0.10 | | | | | | |
| | Sedimentation inhibitor 4a | | | | 0.10 | | | | | |
| | Sedimentation inhibitor 5a | | | | | 0.10 | | | | |
| | Antifoaming agent | 0.10 | 0.10 | 0.10 | 0.10 | 0.10 | 0.10 | 0.10 | 0.10 | 0.10 |
| Compounding ratio (first liquid/second liquid) | | 100/100 | 100/100 | 100/100 | 100/100 | 100/100 | 100/100 | 100/73 | 100/80 | 100/142 |
| Viscosity η_{5A} [Pa·s] | | 12.5 | 14.4 | 13.2 | 9.5 | 23.0 | 17.9 | Unmeasurable | Unmeasurable | 53.3 |
| Viscosity η_{10A} [Pa·s] | | 12.2 | 17.1 | 14.7 | 8.9 | 27.1 | 21.6 | Unmeasurable | Unmeasurable | Unmeasurable |
| Thixotropy of first liquid | | 1.02 | 0.84 | 0.90 | 1.07 | 0.85 | 0.83 | Unmeasurable | Unmeasurable | Unmeasurable |
| Storage stability of first liquid | | A | A | A | A | A | C | A | A | A |
| viscosity η_{5B} [Pa·s] | | 25.1 | 25.9 | 24.7 | 24.9 | 23.6 | 22.2 | 22.5 | 22.5 | 22.5 |
| Viscosity η_{10B} [Pa·s] | | 20.7 | 21.2 | 20.5 | 20.0 | 20.0 | 18.8 | 19.4 | 19.4 | 19.4 |
| Thixotropy of second liquid | | 1.21 | 1.22 | 1.21 | 1.22 | 1.18 | 1.23 | 1.16 | 1.16 | 1.16 |
| Storage stability of second liquid | | A | A | A | A | A | C | A | A | A |
| Viscosity η_{5P} [Pa·s] | | 30.7 | 26.1 | 25.7 | 23.9 | 29.2 | 22.2 | Unmeasurable | 56.4 | 28.3 |
| Viscosity q_{10P} [Pa·s] | | 27.8 | 23.7 | 23.7 | 21.6 | 26.2 | 20.4 | Unmeasurable | Unmeasurable | 24.2 |
| Thixotropy of mixed liquid | | 1.10 | 1.10 | 1.08 | 1.11 | 1.12 | 1.09 | Unmeasurable | Unmeasurable | 1.17 |
| Flowability | | A | A | A | A | A | A | B | B | C |
| Workability in casting | | A | A | A | A | A | B | C | C | B |

In the two-pack type liquid resin compositions of Examples relating to the first embodiment, the first liquid included the epoxy resin (A), the inorganic filler (C), and the sedimentation inhibitor (D), the second liquid included the acid anhydride (B), the inorganic filler (C), and the sedimentation inhibitor (D), the sedimentation inhibitor (D) included an inorganic thickener, and the viscosity η_{5A} of the first liquid was 1.0 Pa·s or more and 50.0 Pa·s or less, whereby the performance balance between the storage stability and the flowability was improved.

### <Examples and Comparative Examples relating to the second embodiment>

Components shown in "First liquid" of Table 2 were mixed in amounts (parts by mass) shown in Table 2 to obtain a first liquid (main agent). Separately, components shown in "Second liquid" of Table 2 were mixed in amounts (parts by mass) shown in Table 2 to obtain a second liquid (curing agent). Thereafter, the first liquid and the second liquid were mixed at a ratio shown in "Compounding ratio (first liquid/second liquid)" of Table 2 to produce a mixed liquid (liquid resin composition).

Details of each component in Table 2 are as follows.

### <Epoxy resin (A)>

· Epoxy resin 1b: 3,4-epoxycyclohexylmethyl-3',4'-epoxycyclohexane carboxylate (alicyclic epoxy resin, manufactured by Daicel Corporation, Celloxide 2021P)
· Epoxy resin 2b: bisphenol A-type epoxy resin (manufactured by Mitsubishi Chemical Corporation, jER828EL)
· Epoxy resin 3b: bisphenol F-type epoxy resin (manufactured by Mitsubishi Chemical Corporation, jER807)
· Epoxy resin 4b: aminophenol-type epoxy resin (manufactured by Mitsubishi Chemical Corporation, JER630)

### <Acid anhydride (B)>

· Acid anhydride 1b: methylnadic acid anhydride (manufactured by Showa Denko Materials Co., Ltd., MHAC-P)

### <Curing accelerator (E)>

· Curing accelerator 1b: DBU-octylate (manufactured by San-Apro Ltd., U-CAT SA102)

### <Inorganic filler (C)>

· Inorganic filler 1b: spherical fused silica (manufactured by Denka Co., Ltd., FB-950, average particle diameter D₅₀: 23 µm)

### <Sedimentation inhibitor (D)>

· Sedimentation inhibitor 1b: polyhydroxycarboxylic acid ester (manufactured by BYK-Chemie Japan, BYK-R606)
· Sedimentation inhibitor 2b: acidic phosphate ester (manufactured by BYK-Chemie Japan, BYK-W9010)
· Sedimentation inhibitor 3b: carboxyl group-including polymer-modified product (manufactured by Kyoeisha Chemical Co., Ltd., FLOREN G-700)
· Sedimentation inhibitor 4b: organobentonite (manufactured by HOJUN Co., Ltd., ESBEN NTO)

### <Other components>

· Colorant: carbon black (manufactured by Mitsubishi Chemical Corporation, Carbon #5)
· Coupling agent: epoxy silane coupling agent (manufactured by Momentive Performance Materials Inc., A-187)
· Antifoaming agent: silicone-based antifoaming agent (manufactured by Nissho Sangyo Co., Ltd., TSA750)

As the average particle diameter D₅₀ of the inorganic filler described above, a measured value when a cumulative value of a volume-based particle size distribution by a laser diffraction scattering measurement method using a laser diffraction particle size distribution analyzer (manufactured by Shimadzu Corporation, SALD-7000) was 50% was used.

### <Evaluation of physical properties>

The following physical properties were measured for the first liquid, the second liquid, and the mixed liquid obtained in each of Examples and each of Comparative Examples.

### (Viscosity and thixotropy at 25°C)

For the first liquid obtained in each of Examples and each of Comparative Examples, a viscosity η_{5A} at a rotational speed of 5 rpm and a temperature of 25°C was measured using an E-type viscometer and a 3°×R14 cone rotor (rotor No. 4). At this time, for the measurement result of the viscosity η_{5A}, the viscosity one minute after starting the rotation of the cone rotor set in the E-type viscometer was used.

Next, a viscosity η_{10A} of the first liquid was measured by the same method as described above, except that the rotational speed was changed to 10 rpm.

Furthermore, thixotropy of the first liquid was calculated from the following expression using the above-described measurement results. 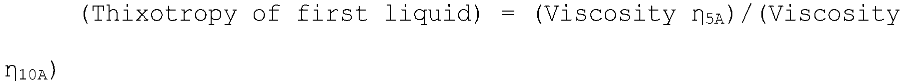 (Thixotropy of first liquid) = (Viscosity η5A)/(Viscosity η10A)

Similarly, for the second liquid and the mixed liquid, viscosities η_{5B} and η_{5P} at a rotational speed of 5 rpm and a temperature of 25°C, viscosities η_{10B} and η_{10P} at a rotational speed of 10 rpm and a temperature of 25°C, and thixotropy were measured by the same method as described above. The measurement results are shown in Table 2.

The description "Unmeasurable" in Table 2 means that each viscosity of the first liquid, the second liquid, and the mixed liquid obtained in each of Examples and each of Comparative Examples was so high that the measurement torque exceeded 100%, and a correct measured value thereof could not be obtained.

### (Flowability)

On a glass plate, 0.05 ml of the mixed liquid was applied such that a diameter of the mixed liquid was 1 cm or less. Next, the glass plate was held at an inclination angle of 45° and a temperature of 60°C for 3 minutes. A distance the mixed liquid flowed during that time was measured as a flow distance (mm), and evaluated based on the following criteria. The evaluation results are shown in Table 2.
A: flow distance was 30 mm or more.
B: flow distance was 15 mm or more and less than 30 mm.
C: flow distance was less than 15 mm.

### (Storage stability)

Storage stability of the first liquid and the second liquid was evaluated by the following method.

First, the first liquid was charged into a 120 mL plastic container with a lid to a height of 50 to 55 mm, the lid was closed, and a height of filler sedimentation (hard cake) deposited on a bottom after 240 hours at 60°C was measured, and evaluated based on the following criteria.
A: height of the hard cake was 0 mm.
B: height of the hard cake was more than 0 mm and less than 3 mm.
C: height of the hard cake was 3 mm or more.

For the second liquid, the storage stability was evaluated in the same manner as for the first liquid. The evaluation results are shown in Table 2.

### (Workability in casting)

Workability in casting of the mixed liquid was evaluated based on the following criteria.
A: all of (Requirement 1) to (Requirement 3) shown below were satisfied.
B: any two of (Requirement 1) to (Requirement 3) shown below were satisfied.
C: any one of (Requirement 1) to (Requirement 3) shown below was satisfied, or none of them were satisfied.

Requirement 1: both the viscosity η_{5P} and the viscosity η_{10P} of the mixed liquid at 25°C were 50 Pa·s or less.
Requirement 2: the evaluation result of the flowability of the mixed liquid was "A".
Requirement 3: the evaluation results of the storage stability for both the first liquid and the second liquid were "A".

**[Table 2]**

| | | Example 1b | Example 2b | Example 3b | Comparative Example 1b | Comparative Example 2b | Comparative Example 3b | Comparative Example 4b |
|---|---|---|---|---|---|---|---|---|
| | Epoxy resin 1b | 21.00 | 21.00 | 21.00 | 21.00 | | | |
| | Epoxy resin 2b | | | | | 21.00 | | |
| | Epoxy resin 3b | | | | | | 21.00 | |
| | Epoxy resin 4b | | | | | | | 21.00 |
| | Inorganic filler 1b | 78.00 | 78.00 | 78.00 | 78.00 | 78.00 | 78.00 | 78.00 |
| First liquid | Sedimentation inhibitor 1b | 0.20 | | | | | | |
| | Sedimentation inhibitor 2b | | 0.20 | | | | | |
| | Sedimentation inhibitor 3b | | | 0.20 | | | | |
| | Sedimentation inhibitor 4b | | | | | 0.20 | 0.20 | 0.20 |
| | Colorant | 0.10 | 0.10 | 0.10 | 0.10 | 0.10 | 0.10 | 0.10 |
| | Coupling agent | 0.20 | 0.20 | 0.20 | 0.20 | 0.20 | 0.20 | 0.20 |
| | Antifoaming agent | 0.10 | 0.10 | 0.10 | 0.10 | 0.10 | 0.10 | 0.10 |
| Second liquid | Acid anhydride 1b | 24.00 | 24.00 | 24.00 | 24.00 | 24.00 | 24.00 | 24.00 |
| | Curing accelerator 1b | 0.50 | 0.50 | 0.50 | 0.50 | 0.50 | 0.50 | 0.50 |
| | Inorganic filler 1b | 75.00 | 75.00 | 75.00 | 75.00 | 75.00 | 75.00 | 75.00 |
| | Sedimentation inhibitor 1b | 0.10 | | | | | | |
| | Sedimentation inhibitor 2b | | 0.10 | | | | | |
| | Sedimentation inhibitor 3b | | | 0.10 | | | | |
| | Sedimentation inhibitor 4b | | | | | 0.10 | 0.10 | 0.10 |
| | Antifoaming agent | 0.10 | 0.10 | 0.10 | 0.10 | 0.10 | 0.10 | 0.10 |
| Compounding ratio | | 100/100 | 100/100 | 100/100 | 100/100 | 100/73 | 100/80 | 100/142 |
| viscosity η_{5A} [Pa·s] | | 20.8 | 21.0 | 23.9 | 17.9 | Unmeasurable | Unmeasurable | 53.3 |
| Viscosity n_{10A} [Pa·s] | | 25.0 | 25.5 | 27.7 | 21.6 | Unmeasurable | Unmeasurable | Unmeasurable |
| Thixotropy of first liquid | | 0.83 | 0.82 | 0.86 | 0.83 | Unmeasurable | Unmeasurable | Unmeasurable |
| Storage stability of first liquid | | A | A | A | C | A | A | A |
| viscosity η_{5B} [Pa·s] | | 32.9 | 22.4 | 27.6 | 22.2 | 22.5 | 22.5 | 22.5 |
| Viscosity q_{10B} [Pa·s] | | 25.0 | 19.6 | 22.5 | 18.8 | 19.4 | 19.4 | 19.4 |
| Thixotropy of second liquid | | 1.32 | 1.15 | 1.22 | 1.23 | 1.16 | 1.16 | 1.16 |
| Storage stability of second liquid | | A | A | A | C | A | A | A |
| viscosity η_{5P} [Pa·s] | | 26.9 | 23.3 | 25.7 | 22.2 | Unmeasurable | 56.4 | 28.3 |
| viscosity η_{10P} [Pa·s] | | 25.0 | 21.8 | 23.6 | 20.4 | Unmeasurable | Unmeasurable | 24.2 |
| Thixotropy of mixed liquid | | 1.07 | 1.07 | 1.09 | 1.09 | Unmeasurable | Unmeasurable | 1.17 |
| Flowability | | A | A | A | A | B | B | C |
| Workability in casting | | A | A | A | B | C | C | B |

In the two-pack type liquid resin compositions of Examples relating to the second embodiment, the first liquid included the epoxy resin (A), the inorganic filler (C), and the sedimentation inhibitor (D), the second liquid included the acid anhydride (B), the inorganic filler (C), and the sedimentation inhibitor (D), the sedimentation inhibitor (D) included a dispersant, and the viscosity η_{5A} of the first liquid was 1.0 Pa·s or more and 50.0 Pa·s or less, whereby the performance balance between the storage stability and the flowability was improved.

### <Examples and Comparative Examples relating to the third embodiment>

Components shown in "First liquid" of Table 3 were mixed in amounts (parts by mass) shown in Table 3 to obtain a first liquid (main agent). Separately, components shown in "Second liquid" of Table 3 were mixed in amounts (parts by mass) shown in Table 3 to obtain a second liquid (curing agent). Thereafter, the first liquid and the second liquid were mixed at a ratio shown in "Compounding ratio (first liquid/second liquid)" of Table 3 to produce a mixed liquid (liquid resin composition).

Details of each component in Table 3 are as follows.

### <Epoxy resin (A)>

· Epoxy resin 1c: alicyclic epoxy resin (manufactured by Daicel Corporation, Celloxide 2021P)
· Epoxy resin 2c: bisphenol A-type epoxy resin (manufactured by Mitsubishi Chemical Corporation, jER828EL)
· Epoxy resin 3c: bisphenol F-type epoxy resin (manufactured by Mitsubishi Chemical Corporation, jER807)

### <Acid anhydride (B)>

· Acid anhydride 1c: methylnadic acid anhydride (manufactured by Showa Denko Materials Co., Ltd., MHAC-P)

### <Curing accelerator (E)>

· Curing accelerator 1c: DBU-octylate (manufactured by San-Apro Ltd., U-CAT SA102)

### <Inorganic filler (C)>

· Inorganic filler 1c: spherical fused silica (manufactured by Denka Co., Ltd., FB-950, average particle diameter D₅₀: 23 µm)

### <Sedimentation inhibitor (D)>

· Sedimentation inhibitor 1c: organobentonite (manufactured by HOJUN Co., Ltd., ESBEN NTO)

### <Other components>

· Colorant: carbon black (manufactured by Mitsubishi Chemical Corporation, Carbon #5)
· Coupling agent: epoxy silane coupling agent (manufactured by Momentive Performance Materials Inc., A-187)
· Antifoaming agent: silicone-based antifoaming agent (manufactured by Nissho Sangyo Co., Ltd., TSA750)

As the average particle diameter D₅₀ of the inorganic filler described above, a measured value when a cumulative value of a volume-based particle size distribution by a laser diffraction scattering measurement method using a laser diffraction particle size distribution analyzer (manufactured by Shimadzu Corporation, SALD-7000) was 50% was used.

### <Evaluation of physical properties>

The following physical properties were measured for the first liquid, the second liquid, and the mixed liquid obtained in each of Examples and each of Comparative Examples.

### (Viscosity and thixotropy)

For the first liquid obtained in each of Examples and each of Comparative Examples, a viscosity η_{5A} at a rotational speed of 5 rpm and a temperature of 60°C was measured using an E-type viscometer and a 3°×R14 cone rotor (rotor No. 4). At this time, for the measurement result of the viscosity η_{5A}, the viscosity one minute after starting the rotation of the cone rotor set in the E-type viscometer was used.

Next, a viscosity η_{10A} of the first liquid was measured by the same method as described above, except that the rotational speed was changed to 10 rpm.

Furthermore, thixotropy of the first liquid was calculated from the following expression using the above-described measurement results. 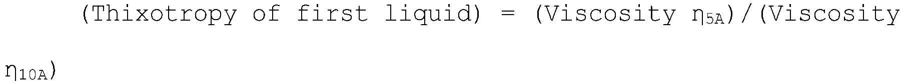 (Thixotropy of first liquid) = (Viscosity η5A)/(Viscosity η10A)

Next, for the second liquid obtained in each of Examples and each of Comparative Examples, a viscosity η_{5B} at a rotational speed of 5 rpm and a temperature of 25°C was measured using an E-type viscometer and a 3°×R14 cone rotor (rotor No. 4). At this time, for the measurement result of the viscosity η_{5B}, the viscosity one minute after starting the rotation of the cone rotor set in the E-type viscometer was used.

Next, a viscosity η_{10B} of the second liquid was measured by the same method as described above, except that the rotational speed was changed to 10 rpm.

Furthermore, thixotropy of the second liquid was calculated from the following expression using the above-described measurement results. 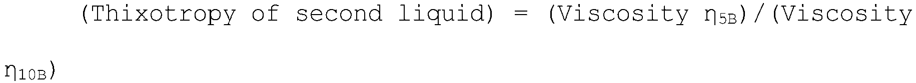 (Thixotropy of second liquid) = (Viscosity η5B)/(Viscosity η10B)

Furthermore, for the mixed liquid of the first liquid and the second liquid, a viscosity η_{5P} at a rotational speed of 5 rpm, a viscosity η_{10P} at a rotational speed of 10 rpm, and thixotropy were measured and calculated under the same conditions as the measurement method performed on the first liquid. The measurement results are shown in Table 3.

The description "Unmeasurable" in Table 3 means that each viscosity of the obtained first liquid and second liquid was so high that the measurement torque exceeded 100%, and a correct measured value thereof could not be obtained.

### (Flowability)

On a glass plate, 0.05 ml of the mixed liquid was applied such that a diameter of the mixed liquid was 1 cm or less. Next, the glass plate was held at an inclination angle of 45° and a temperature of 60°C for 3 minutes. A distance the mixed liquid flowed during that time was measured as a flow distance (mm), and evaluated based on the following criteria. The evaluation results are shown in Table 3.
A: flow distance was 30 mm or more.
B: flow distance was 15 mm or more and less than 30 mm.
C: flow distance was less than 15 mm.

### (Storage stability)

Storage stability of the first liquid and the second liquid was evaluated by the following method.

First, the first liquid was charged into a 120 mL plastic container with a lid to a height of 50 to 55 mm, the lid was closed, and a height of filler sedimentation (hard cake) deposited on a bottom after 240 hours at 60°C was measured, and evaluated based on the following criteria.
A: height of the hard cake was 0 mm.
B: height of the hard cake was more than 0 mm and less than 3 mm.
C: height of the hard cake was 3 mm or more.

For the second liquid, the storage stability was evaluated in the same manner as for the first liquid. The evaluation results are shown in Table 3.

### (Workability in casting)

Workability in casting of the mixed liquid was evaluated based on the following criteria.
A: all of (Requirement 1) to (Requirement 3) shown below were satisfied.
B: any two of (Requirement 1) to (Requirement 3) shown below were satisfied.
C: any one of (Requirement 1) to (Requirement 3) shown below was satisfied, or none of them were satisfied.

Requirement 1: both the viscosity q_{5P} and the viscosity η_{10P} of the mixed liquid at 60°C were 30 Pa·s or less.
Requirement 2: the evaluation result of the flowability of the mixed liquid was "A" or "B".
Requirement 3: the evaluation results of the storage stability for both the first liquid and the second liquid were "A".

**[Table 3]**

| | | Example 1c | Example 2c | Example 3c | Comparative Example 1c | Comparative Example 2c |
|---|---|---|---|---|---|---|
| First liquid | Epoxy resin 1c | 21.00 | | | 21.00 | 12.00 |
| | Epoxy resin 2c | | 12.00 | | | |
| | Epoxy resin 3c | | | 12.00 | | |
| | Inorganic filler 1c | 78.00 | 78.00 | 78.00 | 78.00 | 87.00 |
| | Sedimentation inhibitor 1c | 0.10 | 0.10 | 0.10 | | |
| | Colorant | 0.10 | 0.10 | 0.10 | 0.10 | 0.10 |
| | Coupling agent | 0.20 | 0.20 | 0.20 | 0.20 | 0.20 |
| | Antifoaming agent | 0.10 | 0.10 | 0.10 | 0.10 | 0.10 |
| Second liquid | Acid anhydride 1c | 24.00 | 24.00 | 24.00 | 24.00 | 14.00 |
| | Curing accelerator 1c | 0.50 | 0.50 | 0.50 | 0.50 | 0.30 |
| | Inorganic filler 1c | 75.00 | 75.00 | 75.00 | 75.00 | 85.00 |
| | Sedimentation inhibitor 1c | 0.10 | 0.10 | 0.10 | | |
| | Antifoaming agent | 0.10 | 0.10 | 0.10 | 0.10 | 0.10 |
| Compounding ratio | | 100/100 | 100/73 | 100/80 | 100/100 | 100/100 |
| Viscosity η_{5A} [Pa·s] | | 2.0 | 11.0 | 4.8 | 1.8 | Unmeasurable |
| Viscosity η_{10A} [Pa·s] | | 1.9 | 12.1 | 5.0 | 1.6 | Unmeasurable |
| Thixotropy of first liquid | | 1.08 | 0.91 | 0.97 | 1.13 | Unmeasurable |
| Storage stability of first liquid | | A | A | A | C | A |
| Viscosity η_{5B} [Pa·s] | | 22.5 | 22.5 | 22.5 | 22.2 | Unmeasurable |
| Viscosity η_{10B} [Pa·s] | | 19.4 | 19.4 | 19.4 | 18.8 | Unmeasurable |
| Thixotropy of second liquid | | 1.16 | 1.16 | 1.16 | 1.23 | Unmeasurable |
| Storage stability of second liquid | | A | A | A | C | A |
| Viscosity η_{5P} [Pa·s] | | 4.0 | 5.0 | 3.9 | 3.0 | 46.9 |
| Viscosity η_{10P} [Pa·s] | | 3.1 | 4.5 | 3.3 | 2.4 | 32.6 |
| Thixotropy of mixed liquid | | 1.29 | 1.11 | 1.18 | 1.25 | 1.43 |
| Flowability | | A | B | B | A | C |
| Workability in casting | | A | A | A | B | C |

In the two-pack type liquid resin compositions of Examples, the first liquid included the epoxy resin (A), the inorganic filler (C), and the sedimentation inhibitor (D), the second liquid included the acid anhydride (B), the inorganic filler (C), and the sedimentation inhibitor (D), and the viscosity η_{5A} of the first liquid was 1.0 Pa·s or more and 15.0 Pa·s or less, whereby the performance balance between the storage stability and the flowability was improved.

This application claims priority based on Japanese Patent Application No. 2023-202588, Japanese Patent Application No. 2023-202589, and Japanese Patent Application No. 2023-202591, filed on November 30, 2023, the disclosure of which is incorporated herein in its entirety.

## Claims

1. A two-pack type liquid resin composition comprising:
a first liquid; and
a second liquid,
wherein the first liquid includes an epoxy resin (A), an inorganic filler (C), and a sedimentation inhibitor (D),
the second liquid includes an acid anhydride (B), an inorganic filler (C), and a sedimentation inhibitor (D),
the sedimentation inhibitor (D) includes an inorganic thickener (excluding the inorganic filler (C)), and
a viscosity η_{5A} of the first liquid, as measured under conditions of a rotational speed of 5 rpm and a temperature of 25°C using an E-type viscometer and a 3°×R14 cone rotor, is 1.0 Pa·s or more and 50.0 Pa·s or less.

2. The two-pack type liquid resin composition according to Claim 1,
wherein a viscosity η_{10A} of the first liquid, as measured under conditions of a rotational speed of 10 rpm and a temperature of 25°C using an E-type viscometer and a 3°×R14 cone rotor, is 1.0 Pa·s or more and 50.0 Pa·s or less.

3. The two-pack type liquid resin composition according to Claim 2,
wherein a viscosity ratio Ti_{A} (η_{5A}/η_{10A}) of the viscosity η_{5A} to the viscosity η_{10A} is 0.1 or more and 1.5 or less.

4. The two-pack type liquid resin composition according to any one of Claims 1 to 3,
wherein a viscosity η_{5B} of the second liquid, as measured under conditions of a rotational speed of 5 rpm and a temperature of 25°C using an E-type viscometer and a 3°×R14 cone rotor, is 1.0 Pa·s or more and 50.0 Pa·s or less.

5. The two-pack type liquid resin composition according to Claim 4,
wherein a viscosity η_{10B} of the second liquid, as measured under conditions of a rotational speed of 10 rpm and a temperature of 25°C using an E-type viscometer and a 3°×R14 cone rotor, is 1.0 Pa·s or more and 50.0 Pa·s or less.

6. The two-pack type liquid resin composition according to Claim 5,
wherein a viscosity ratio Ti_{B} (η_{5B}/η_{10B}) of the viscosity η_{5B} to the viscosity η_{10B} is 0.5 or more and 2.5 or less.

7. The two-pack type liquid resin composition according to any one of Claims 1 to 6,
wherein a viscosity η_{5P} of a mixed liquid of the first liquid and the second liquid, as measured under conditions of a rotational speed of 5 rpm and a temperature of 25°C using an E-type viscometer and a 3°×R14 cone rotor, is 1.0 Pa·s or more and 50.0 Pa·s or less.

8. The two-pack type liquid resin composition according to Claim 7,
wherein a viscosity η_{10P} of the mixed liquid of the first liquid and the second liquid, as measured under conditions of a rotational speed of 10 rpm and a temperature of 25°C using an E-type viscometer and a 3°×R14 cone rotor, is 10.0 Pa·s or more and 50.0 Pa·s or less.

9. The two-pack type liquid resin composition according to Claim 8,
wherein a viscosity ratio Ti_{P} (η_{5P}/η_{10P}) of the viscosity η_{5P} to the viscosity η_{10P} is 0.5 or more and 2.0 or less.

10. The two-pack type liquid resin composition according to any one of Claims 1 to 9,
wherein the inorganic thickener includes one or two or more selected from the group consisting of a layered inorganic mineral and nanosilica.

11. The two-pack type liquid resin composition according to Claim 10,
wherein the layered inorganic mineral includes one or two or more selected from the group consisting of clay and talc.

12. The two-pack type liquid resin composition according to any one of Claims 1 to 11,
wherein a content of the sedimentation inhibitor (D) is 0.01% by mass or more and 2.00% by mass or less, when a total amount of the two-pack type liquid resin composition is taken as 100% by mass.

13. The two-pack type liquid resin composition according to any one of Claims 1 to 12,
wherein the epoxy resin (A) includes an alicyclic epoxy resin.

14. The two-pack type liquid resin composition according to Claim 13,
wherein a content of the alicyclic epoxy resin is 50 parts by mass or more and 100 parts by mass or less, when a content of the epoxy resin (A) is taken as 100 parts by mass.

15. The two-pack type liquid resin composition according to any one of Claims 1 to 14,
wherein a content of the epoxy resin (A) is 5% by mass or more and 30% by mass or less, when a total amount of the two-pack type liquid resin composition is taken as 100% by mass.

16. The two-pack type liquid resin composition according to any one of Claims 1 to 15,
wherein the acid anhydride (B) includes one or two or more selected from the group consisting of methyl-5-norbornene-2,3-dicarboxylic acid anhydride, methylcyclohexane-1,2-dicarboxylic acid anhydride, and methyltetrahydrophthalic acid anhydride.

17. The two-pack type liquid resin composition according to any one of Claims 1 to 16,
wherein a content of the acid anhydride (B) is 5% by mass or more and 20% by mass or less, when a total amount of the two-pack type liquid resin composition is taken as 100% by mass.

18. The two-pack type liquid resin composition according to any one of Claims 1 to 17,
wherein the inorganic filler (C) includes one or two or more selected from the group consisting of silica, alumina, aluminum hydroxide, and calcium carbonate.

19. The two-pack type liquid resin composition according to any one of Claims 1 to 18,
wherein the inorganic filler (C) has an average particle diameter D₅₀ of 0.5 µm or more and 100.0 µm or less, the D₅₀ being a particle diameter at which a cumulative value reaches 50% in a volume-based particle size distribution measured by a laser diffraction scattering method.

20. The two-pack type liquid resin composition according to any one of Claims 1 to 19,
wherein a content of the inorganic filler (C) is 65% by mass or more and 85% by mass or less, when a total amount of the two-pack type liquid resin composition is taken as 100% by mass.

21. The two-pack type liquid resin composition according to any one of Claims 1 to 20, further comprising:
a curing accelerator (E).

22. The two-pack type liquid resin composition according to Claim 21,
wherein the curing accelerator (E) includes one or two or more selected from the group consisting of a tertiary amine, a quaternary ammonium salt, imidazoles, an organic phosphine, and a Lewis acid catalyst.

23. The two-pack type liquid resin composition according to Claim 21 or Claim 22,
wherein a content of the curing accelerator (E) is 0.01% by mass or more and 1.00% by mass or less, when a total amount of the two-pack type liquid resin composition is taken as 100% by mass.

24. A two-pack type liquid resin composition comprising:
a first liquid; and
a second liquid,
wherein the first liquid includes an epoxy resin (A), an inorganic filler (C), and a sedimentation inhibitor (D),
the second liquid includes an acid anhydride (B), an inorganic filler (C), and a sedimentation inhibitor (D),
the sedimentation inhibitor (D) includes a dispersant, and
a viscosity η_{5A} of the first liquid, as measured under conditions of a rotational speed of 5 rpm and a temperature of 25°C using an E-type viscometer and a 3°×R14 cone rotor, is 1.0 Pa·s or more and 50.0 Pa·s or less.

25. The two-pack type liquid resin composition according to Claim 24,
wherein a viscosity η_{10A} of the first liquid, as measured under conditions of a rotational speed of 10 rpm and a temperature of 25°C using an E-type viscometer and a 3°×R14 cone rotor, is 1.0 Pa·s or more and 50.0 Pa·s or less.

26. The two-pack type liquid resin composition according to Claim 25,
wherein a viscosity ratio Ti_{A} (η_{5A}/η_{10A}) of the viscosity η_{5A} to the viscosity η_{10A} is 0.4 or more and 1.5 or less.

27. The two-pack type liquid resin composition according to any one of Claims 24 to 26,
wherein a viscosity η_{5B} of the second liquid, as measured under conditions of a rotational speed of 5 rpm and a temperature of 25°C using an E-type viscometer and a 3°×R14 cone rotor, is 1.0 Pa·s or more and 70.0 Pa·s or less.

28. The two-pack type liquid resin composition according to Claim 27,
wherein a viscosity η_{10B} of the second liquid, as measured under conditions of a rotational speed of 10 rpm and a temperature of 25°C using an E-type viscometer and a 3°×R14 cone rotor, is 1.0 Pa·s or more and 50.0 Pa·s or less.

29. The two-pack type liquid resin composition according to Claim 28,
wherein a viscosity ratio Ti_{B} (η_{5B}/η_{10B}) of the viscosity η_{5B} to the viscosity η_{10B} is 0.5 or more and 4.0 or less.

30. The two-pack type liquid resin composition according to any one of Claims 24 to 29,
wherein a viscosity η_{5P} of a mixed liquid of the first liquid and the second liquid, as measured under conditions of a rotational speed of 5 rpm and a temperature of 25°C using an E-type viscometer and a 3°×R14 cone rotor, is 1.0 Pa·s or more and 50.0 Pa·s or less.

31. The two-pack type liquid resin composition according to Claim 30,
wherein a viscosity η_{10P} of the mixed liquid of the first liquid and the second liquid, as measured under conditions of a rotational speed of 10 rpm and a temperature of 25°C using an E-type viscometer and a 3°×R14 cone rotor, is 10.0 Pa·s or more and 50.0 Pa·s or less.

32. The two-pack type liquid resin composition according to Claim 31,
wherein a viscosity ratio Ti_{P} (η_{5P}/η_{10P}) of the viscosity η_{5P} to the viscosity η_{10P} is 0.5 or more and 2.0 or less.

33. The two-pack type liquid resin composition according to any one of Claims 24 to 32,
wherein the dispersant includes an ester compound including a long-chain hydrocarbon group.

34. The two-pack type liquid resin composition according to Claim 33,
wherein the ester compound including a long-chain hydrocarbon group includes one or two or more selected from the group consisting of a polyhydroxycarboxylic acid ester, an acidic phosphate ester, and a carboxyl group-including polymer-modified product.

35. The two-pack type liquid resin composition according to any one of Claims 24 to 34,
wherein a content of the sedimentation inhibitor (D) is 0.01% by mass or more and 2.0% by mass or less, when a total amount of the two-pack type liquid resin composition is taken as 100% by mass.

36. The two-pack type liquid resin composition according to any one of Claims 24 to 35,
wherein the epoxy resin (A) includes an alicyclic epoxy resin.

37. The two-pack type liquid resin composition according to Claim 36,
wherein a content of the alicyclic epoxy resin is 50 parts by mass or more and 100 parts by mass or less, when a content of the epoxy resin (A) is taken as 100 parts by mass.

38. The two-pack type liquid resin composition according to any one of Claims 24 to 37,
wherein a content of the epoxy resin (A) is 5% by mass or more and 30% by mass or less, when a total amount of the two-pack type liquid resin composition is taken as 100% by mass.

39. The two-pack type liquid resin composition according to any one of Claims 24 to 38,
wherein the acid anhydride (B) includes one or two or more selected from the group consisting of methyl-5-norbornene-2,3-dicarboxylic acid anhydride, methylcyclohexane-1,2-dicarboxylic acid anhydride, and methyltetrahydrophthalic acid anhydride.

40. The two-pack type liquid resin composition according to any one of Claims 24 to 39,
wherein a content of the acid anhydride (B) is 5% by mass or more and 20% by mass or less, when a total amount of the two-pack type liquid resin composition is taken as 100% by mass.

41. The two-pack type liquid resin composition according to any one of Claims 24 to 40,
wherein the inorganic filler (C) includes one or two or more selected from the group consisting of silica, alumina, aluminum hydroxide, and calcium carbonate.

42. The two-pack type liquid resin composition according to any one of Claims 24 to 41,
wherein the inorganic filler (C) has an average particle diameter D₅₀ of 0.5 µm or more and 100 µm or less, the D₅₀ being a particle diameter at which a cumulative value reaches 50% in a volume-based particle size distribution measured by a laser diffraction scattering method.

43. The two-pack type liquid resin composition according to any one of Claims 24 to 42,
wherein a content of the inorganic filler (C) is 65% by mass or more and 85% by mass or less, when a total amount of the two-pack type liquid resin composition is taken as 100% by mass.

44. The two-pack type liquid resin composition according to any one of Claims 24 to 43, further comprising:
a curing accelerator (E).

45. The two-pack type liquid resin composition according to Claim 44,
wherein the curing accelerator (E) includes one or two or more selected from the group consisting of a tertiary amine, a quaternary ammonium salt, imidazoles, an organic phosphine, and a Lewis acid catalyst.

46. The two-pack type liquid resin composition according to Claim 44 or Claim 45,
wherein a content of the curing accelerator (E) is 0.01% by mass or more and 1.00% by mass or less, when a total amount of the two-pack type liquid resin composition is taken as 100% by mass.

47. A two-pack type liquid resin composition comprising:
a first liquid; and
a second liquid,
wherein the first liquid includes an epoxy resin (A), an inorganic filler (C), and a sedimentation inhibitor (D),
the second liquid includes an acid anhydride (B), an inorganic filler (C), and a sedimentation inhibitor (D), and
a viscosity η_{5A} of the first liquid, as measured under conditions of a rotational speed of 5 rpm and a temperature of 60°C using an E-type viscometer and a 3°×R14 cone rotor, is 1.0 Pa·s or more and 15.0 Pa·s or less.

48. The two-pack type liquid resin composition according to Claim 47,
wherein a viscosity η_{10A} of the first liquid, as measured under conditions of a rotational speed of 10 rpm and a temperature of 60°C using an E-type viscometer and a 3°×R14 cone rotor, is 1.0 Pa·s or more and 15.0 Pa·s or less.

49. The two-pack type liquid resin composition according to Claim 48,
wherein a viscosity ratio Ti_{A} (η_{5A}/η_{10A}) of the viscosity η_{5A} to the viscosity η_{10A} is 0.1 or more and 1.5 or less.

50. The two-pack type liquid resin composition according to any one of Claims 47 to 49,
wherein a viscosity η_{5B} of the second liquid, as measured under conditions of a rotational speed of 5 rpm and a temperature of 25°C using an E-type viscometer and a 3°×R14 cone rotor, is 1.0 Pa·s or more and 50.0 Pa·s or less.

51. The two-pack type liquid resin composition according to Claim 50,
wherein a viscosity η_{10B} of the second liquid, as measured under conditions of a rotational speed of 10 rpm and a temperature of 25°C using an E-type viscometer and a 3°×R14 cone rotor, is 1.0 Pa·s or more and 50.0 Pa·s or less.

52. The two-pack type liquid resin composition according to Claim 51,
wherein a viscosity ratio Ti_{B} (η_{5B}/η_{10B}) of the viscosity η_{5B} to the viscosity η_{10B} is 0.5 or more and 2.5 or less.

53. The two-pack type liquid resin composition according to any one of Claims 47 to 52,
wherein a viscosity η_{5P} of a mixed liquid of the first liquid and the second liquid, as measured under conditions of a rotational speed of 5 rpm and a temperature of 60°C using an E-type viscometer and a 3°×R14 cone rotor, is 1.0 Pa·s or more and 30.0 Pa·s or less.

54. The two-pack type liquid resin composition according to Claim 53,
wherein a viscosity η_{10P} of the mixed liquid of the first liquid and the second liquid, as measured under conditions of a rotational speed of 10 rpm and a temperature of 60°C using an E-type viscometer and a 3°×R14 cone rotor, is 1.0 Pa·s or more and 30.0 Pa·s or less.

55. The two-pack type liquid resin composition according to Claim 54,
wherein a viscosity ratio Ti_{P} (η_{5P}/η_{10P}) of the viscosity η_{5P} to the viscosity η_{10P} is 0.5 or more and 2.0 or less.

56. The two-pack type liquid resin composition according to any one of Claims 47 to 55,
wherein the sedimentation inhibitor (D) includes an inorganic thickener (excluding the inorganic filler (C)).

57. The two-pack type liquid resin composition according to Claim 56,
wherein the inorganic thickener includes a layered inorganic mineral.

58. The two-pack type liquid resin composition according to Claim 57,
wherein the layered inorganic mineral includes one or two or more selected from the group consisting of clay and talc.

59. The two-pack type liquid resin composition according to any one of Claims 47 to 58,
wherein a content of the sedimentation inhibitor (D) is 0.01% by mass or more and 2.00% by mass or less, when a total amount of the two-pack type liquid resin composition is taken as 100% by mass.

60. The two-pack type liquid resin composition according to any one of Claims 47 to 59,
wherein a content of the epoxy resin (A) is 3% by mass or more and 30% by mass or less, when a total amount of the two-pack type liquid resin composition is taken as 100% by mass.

61. The two-pack type liquid resin composition according to any one of Claims 47 to 60,
wherein the acid anhydride (B) includes one or two or more selected from the group consisting of methyl-5-norbornene-2,3-dicarboxylic acid anhydride, methylcyclohexane-1,2-dicarboxylic acid anhydride, and methyltetrahydrophthalic acid anhydride.

62. The two-pack type liquid resin composition according to any one of Claims 47 to 61,
wherein a content of the acid anhydride (B) is 5% by mass or more and 20% by mass or less, when a total amount of the two-pack type liquid resin composition is taken as 100% by mass.

63. The two-pack type liquid resin composition according to any one of Claims 47 to 62,
wherein the inorganic filler (C) includes one or two or more selected from the group consisting of silica, alumina, aluminum hydroxide, and calcium carbonate.

64. The two-pack type liquid resin composition according to any one of Claims 47 to 63,
wherein the inorganic filler (C) has an average particle diameter D₅₀ of 0.5 µm or more and 100 µm or less, the D₅₀ being a particle diameter at which a cumulative value reaches 50% in a volume-based particle size distribution measured by a laser diffraction scattering method.

65. The two-pack type liquid resin composition according to any one of Claims 47 to 64,
wherein a content of the inorganic filler (C) is 65% by mass or more and 85% by mass or less, when a total amount of the two-pack type liquid resin composition is taken as 100% by mass.

66. The two-pack type liquid resin composition according to any one of Claims 47 to 65, further comprising:
a curing accelerator (E).

67. The two-pack type liquid resin composition according to Claim 66,
wherein the curing accelerator (E) includes one or two or more selected from the group consisting of a tertiary amine, a quaternary ammonium salt, imidazoles, an organic phosphine, and a Lewis acid catalyst.

68. The two-pack type liquid resin composition according to Claim 66 or Claim 67,
wherein a content of the curing accelerator (E) is 0.01% by mass or more and 1.00% by mass or less, when a total amount of the two-pack type liquid resin composition is taken as 100% by mass.

69. The two-pack type liquid resin composition according to any one of Claims 1 to 68,
wherein the two-pack type liquid resin composition is usable for encapsulating, by a casting method, a power module that includes a power-module substrate including a circuit layer and a power semiconductor element on the circuit layer of the power-module substrate.

70. A power module comprising:
a power-module substrate including a circuit layer;
a power semiconductor element on the circuit layer of the power-module substrate; and
an encapsulant for encapsulating the power-module substrate and the power semiconductor element,
wherein the encapsulant includes a cured product of the two-pack type liquid resin composition according to any one of Claims 1 to 68.

71. The power module according to Claim 70,
wherein the power semiconductor element includes one or two or more selected from the group consisting of a MOS transistor and an insulated gate bipolar transistor (IGBT).
